# EUROPEAN PATENT SPECIFICATION

(11) **EP 0 541 112 B1**
(45) Date of publication and mention of the grant of the patent: **05.09.2001**
(21) Application number: 92119043.5
(22) Date of filing: 06.11.1992
(51) Int. Cl.: G03F 7/004

(54) **Positive type light-senstitive composition**
Positiv-arbeitende lichtempfindliche Zusammensetzung
Composition photosensible à réserve positive

(30) Priority: 08.11.1991 JP 31960091; 05.02.1992 JP 4770592; 05.02.1992 JP 4778292; 03.06.1992 JP 16668592; 13.10.1992 JP 29909392
(43) Date of publication of application: 12.05.1993
(73) Proprietor: FUJI PHOTO FILM CO., LTD., Kanagawa-ken (JP)
(72) Inventor: Yamanaka, Tsukasa, c/o Fuji Photo Film Co., Ltd., Haibara-gun, Shizuoka (JP); Aoai, Toshiaki, c/o Fuji Photo Film Co., Ltd., Haibara-gun, Shizuoka (JP); Uenichi, Kazuya, c/o Fuji Photo Film Co., Ltd., Haibara-gun, Shizuoka (JP); Kondo, Shunichi, c/o Fuji Photo Film Co., Ltd., Haibara-gun, Shizuoka (JP); Kokubo, Tadayoshi, c/o Fuji Photo Film Co., Ltd., Haibara-gun, Shizuoka (JP)
(74) Representative: Barz, Peter, Dr.

(56) References cited:
- EP-A- 0 249 139
- EP-A- 0 358 194
- EP-A- 0 424 124
- EP-A- 0 445 819
- US-A- 4 816 375

## Description

The present invention relates to a positive type light-sensitive composition which can be used in the manufacturing of a lithographic printing plate or a semiconductor such as an integrated circuit (IC), or in the manufacturing of a circuit board for a liquid crystal, a thermal head and other devices made by photofabrication.

A composition containing an alkali soluble resin and a naphthoquinonediazide compound as a light-sensitive substance are generally used as a positive type photoresist composition. For example, a novolak type phenol resin/naphthoquinonediazide-substituted compound is disclosed in US-A-3,666,473, 4,115,128 and 4,173,470. An example of a (novolak resin consisting of cresol-formaldehyde)/trihydroxybenzophenone-1,2-naphthoquinonediazide sulfonic acid ester is disclosed in Introduction to Microlithography written by L.F. Thompson (ACS Publication, No. 219, pp. 112 to 121).

In such a novolak type photoresist consisting of a novolak resin and a quinoneazide compound, the novolak resin provides high durability to a plasma etching, and the naphthoquinonediazide compound acts as an dissolution inhibitor agent. Naphthoquinonediazide has the characteristic that it loses dissolution inhibiting capability and increases alkali solubility of a novolak resin when it is subjected to light irradiation to generate carboxylic acid.

Many positive type photoresists containing the novolak resin and naphthoquinonediazide type light-sensitive material have been developed and put into practical use, and sufficient results have been obtained in line width processing of about 0.8 to 2 µm.

In an integrated circuit, however, integration is being increased more and more, and in the manufacturing of a semiconductor substrate such as ultra LSI(large scale integration), there is a need to process an ultra fine pattern consisting of a line width not more than 0,5 µm. In order to achieve this needed resolution, the wavelength used in exposing equipment for photolithography is shifted more and more to a shorter wavelength, and recently, far ultraviolet rays and eximer laser rays (XeCl, KrF and ArF) have been investigated.

The use of a resist consisting of a conventional novolak resin and a naphthoquinonediazide compound for forming a lithographic pattern using far ultraviolet rays or eximer laser rays makes it difficult for the rays to reach the bottom of the resist because of strong absorption by the novolak resin and naphthoquinonediazide in the far ultraviolet region and only a low sensitive and tapered pattern can be obtained.

One of the means for solving such a problem is a chemical sensitization series resist composition described in US-A-4,491,628 and EP-A-249,139. A chemical sensitization series positive type resist composition is a pattern forming material in which acid is generated in an exposed portion by irradiation with, for example, far ultraviolet rays, and the solubilities of the irradiated portion and the nonirradiated portion with an active radial rays in a developing solution are changed by the reaction in which the acid is used as a catalyst to form a pattern on a substrate.

For example, the combination of a compound generating acid by photodecomposition with acetal or an O⁻ or N-acetal compound is described in JP-A-48-89003(US-A-3,779,778; the term"JP-A" as used herewith means an unexamined Japanese patent application), the combination with an orthoester or an amidacetal compound is described in JP-A-51-120714 (US-A-4,101,323), the combination with a polymer having an acetal or ketal group on a principal chain is described in JP-A-53-133429 (US-A-4,247,611), the combination with an enol ether compound is described in JP-A-55-12995 (US-A-4,248,957), the combination with an N-acylimino-carbonate compound is described in JP-A-55-126236 (US-A-4,250,247), the combination with a polymer having an orthoester group on a principal chain is described in JP-A-56-17345 (US-A-4,311,782), the combination with a tertiary alkyl ester compound is described in JP-A-60-3625, the combination with a silyl ester compound is described in JP-A-60-10247, and the combination with a silyl ether compound is described in JP-A-60-37549 and JP-A-60-121446 (these publications correspond to US-A-4,752,552). These combinations have quantum yields theoretically exceeding 1 and therefore, they show high light-sensitivity.

Similarly, there are systems which are decomposed by heating in the presence of acid to become alkali soluble while stable over time at room temperature. Examples thereof include combined systems of compounds generating acids by exposing and esters having tertiary or secondary carbons (for example, t-butyl and 2-cyclohexenyl) or carbonic acid esters, described in, for example, JP-A-59-45439 (US-A-4,491,628), JP-A-60-3625, JP-A-62-229242 (US-A-4,837,124 and 4,968,581), JP-A-63-27829 (EP-A-249139), JP-A-63-36240 (US-A-4,939,070), and JP-A-63-250642 (EP-A-284868), Polym. Eng. Sci., vol. 23, pp. 1012 (1983), ACS. Sym. vol. 242, pp. ll (1984), Semiconductor World, November 1987, pp. 91, Micromolecules, vol. 21, pp. 1475 (1988), and SPIE, vol. 920, pp. 42 (1988). These systems also have high sensitivities and have small absorptions in the deep-UV region compared with a naphthoquinonediazide/novolak resin system. Accordingly, they can become an effective system for shifting the wavelength of a light source to a shorter wavelength as described above.

The above positive type chemical sensitization resist can be classified roughly as (i) a three component system consisting of an alkali soluble resin, a compound generating acid upon exposure with radial rays (a photo acid generating agent) and a dissolution inhibitor used for an alkali soluble resin and having a group decomposable with acid and (ii) a two component system consisting of a resin having a group which is decomposed by the reaction with acid to become alkali soluble and a photo acid generating agent.

In case of the two component system, there has been a problem that the resist layer shrinks by baking after exposure because of the increase in the content of an acid decomposition group in the resin. Also, in the three component system, there has been a problem that the decrease in a layer during development becomes large because of an insufficient dissolution inhibiting performance with respect to an alkali soluble resin, which markedly deteriorates the resist profile.

The three component system, however, is a favorable system since there is a large selection of raw materials therefor, and therefore, the development of an acid decomposable compound having an excellent dissolution inhibitor performance, which can be used in this system, is needed.

EP-A-424124 discloses a positive-acting photoresist composition comprising:
(i) an alkali-soluble binder comprising a plurality of phenol groups,
(ii) an iodonium salt of the general formula: 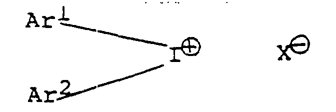 in which:
   Ar¹ and Ar² independently represent aromatic or heteroaromatic groups comprising of up to 10 ring atoms, which groups may optionally be linked together to include the iodine atom within a ring structure and, X⁻ is an anion such that HX is an acid of pKa not greater than 3, and
(iii) an acid cleavable compound having a nucleus of general formula (I): 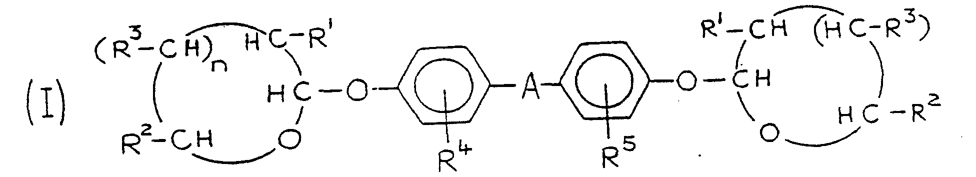 in which:
   n is 0, 1, 2 or 3,
   each R¹, R² and R³ independently represents hydrogen or an alkyl group comprising up to 4 carbon atoms,
   R⁴ and R⁵ independently represent hydrogen or one or more ring substituents selected from Cl, Br, F, alkyl groups comprising up to 4 carbon atoms, alkoxy groups comprising up to 4 carbon atoms and combinations thereof, and
   A represents a bond or a divalent linking group containing up to 10 atoms other than hydrogen.
Said compositions are intended primarily for use in the preparation of lithographic printing plates.

Moreover EP-A-445819 discloses a positive type photoresist composition which comprises a quinonediazide compound, an alkali-soluble resin and certain polynuclear polyphenol compounds and which exhibits excellent sensitivity, percent film retention, resolution, heat resistance, resist shape and developability.

US-A-4,816,375 discloses a photosolubilizable composition containing an acid generator such as a sulfonium salt and an acid decomposable dissolution inhibitor, which can be used for photoresist compositions comprising alkali-soluble resins. The dissolution inhibitor may contain two or more silyl ether or silyl ester groups and these silyl ether or silyl ester groups may be separated by 10 or more bonded atoms.

An object of the present invention is to provide a positive type light-sensitive composition having less layer shrinkage by baking (if it is conducted) after exposing, less layer decrease in developing, a good profile and high resolution.

Taking note of the above various characteristics, the intensive investigations made by the present inventors have resulted in finding that the object of the present invention can be achieved by a positive type chemical sensitization system comprising an alkali soluble resin, a specific photo acid generating agent and a dissolution inhibitor having an acid decomposable group, wherein a low molecular weight compound satisfying the following conditions is used as the dissolution inhibitor to reach the present invention.

That is, the present invention provides a positive type light-sensitive composition comprising:
(a) a resin which is insoluble in water and soluble in an alkaline aqueous solution,
(b) a compound which generates acid by irradiation with active rays or radial rays as further specified below, and
(c) an acid decomposable dissolution inhibitor, having a molecular weight of not more than 3,000 and having groups decomposable by the action of the generated acid to increase the solubility of said inhibitor in an alkaline developing solution, wherein said inhibitor (c) is at least one compound selected from
   (i) compounds having two of said acid decomposable groups which are separated by 10 or more bonded atoms excluding the atoms constituting the acid decomposable groups, or
   (ii) compounds having at least three of said acid decomposable groups, and two of said groups which are at the farthest positions are separated by 9 or more bonded atoms excluding the atoms constituting the acid decomposable groups, wherein said acid decomposable group contains -COOA⁰ or -OB⁰ as further specified below.

The three component series positive type light-sensitive composition of the present invention consists fundamentally of an acid decomposable dissolution inhibitor agent, an alkali soluble resin and a certain photo acid generating agent. The acid decomposable dissolution inhibitor controls dissolving of the alkali soluble resin in an alkaline aqueous solution, and the acid decomposable group is deprotected by acid generated by exposing to accelerate solubility of the resin in an alkaline aqueous solution. Dissolution inhibitors in which the skeletons thereof consist of naphthalene, biphenyl and diphenyl cycloalkane are disclosed in JP-A-63-27829 and JP-A-3-198059. However, they have a small dissolution inhibitor performance to an alkali soluble resin and therefore are insufficient in profile and a resolution.

The compounds used in the present invention will be explained below in detail.

### Acid decomposable dissolution inhibitor [the component (c) of the composition of present invention]

The acid decomposable dissolution inhibitor used as the component (c) in the present invention is a compound having two groups which can be decomposed by acid in the structure thereof, in which the two acid decomposable groups are separated by at least 10, preferably at least 11 and further preferably at least 12 bonded atoms excluding the atoms constituting the acid decomposable groups, or the compound having at least three acid decomposable groups, in which two of the acid decomposable groups at the farthest positions are separated by at least 9, preferably at least 10 and further preferably at least 11 bonded atoms excluding the atoms constituting the acid decomposable groups. The acid decomposable groups are preferably separated by not more than 50 bonded atoms and more preferably by not more than 30 bonded atoms.

The number of the bonded atoms is counted in the direction so that the number of the bonded atoms becomes smallest.

In the present invention, it has been found that if in the acid decomposable dissolution inhibitor which has three or more, preferably four or more acid decomposable groups, or also in the compound having two acid decomposable groups, the acid decomposable groups are separated from each other by some fixed distance, the dissolution inhibitor performance to the alkali soluble resin is markedly improved. The distance between the acid decomposable groups in the present invention is shown by the number of the bonded atoms present therebetween excluding the atoms constituting the acid decomposable groups. For example, in case of the following compounds (1) and (2), the distance between the acid decomposable groups each corresponds to four bonded atoms, in case of the compound (3), it corresponds to twelve bonded atoms, and in the case of the compound (4), it corresponds to eleven bonded atoms. 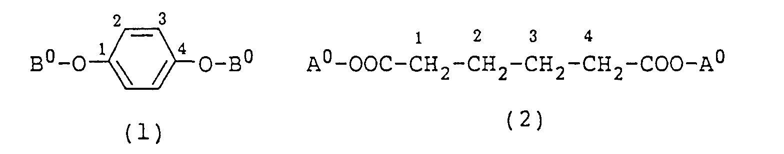 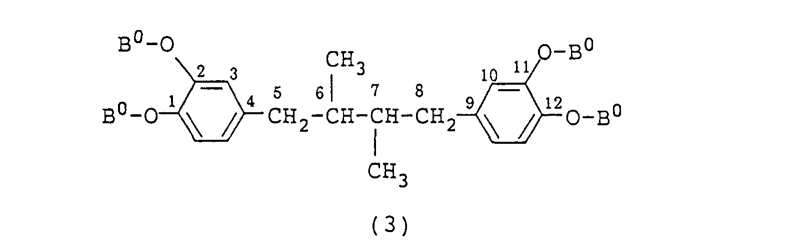 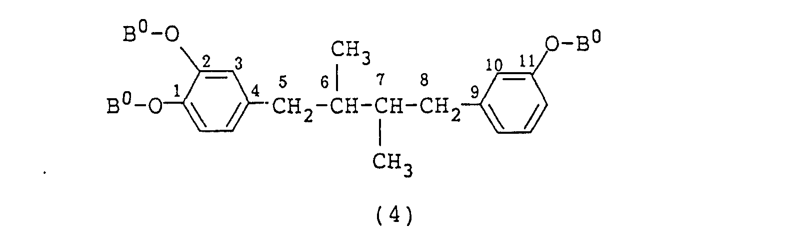 The acid decomposable group contains -COOA⁰ or -OB⁰. The groups -O-B⁰ and -COO-A⁰ are acid decomposable groups which become -OH and -COOH, respectively, by an action of the acid generated from the photo acid generating agent. A⁰ and B° are defined below.

The acid decomposable dissolution inhibitor may have plural acid decomposable groups on one benzene ring, but it is preferable that the compound is composed of a skeleton having one acid decomposable group on one benzene ring. Further, the molecular weight of the acid decomposable dissolution inhibitor of the composition of the present invention is 3000 or less, preferably 500 to 3000, and further preferably 1000 to 2500.

In the preferred embodiment of the present invention, -R⁰(̵COO-A⁰)_{n'}(n'≥1) or -Ar-O-B⁰ can represent the acid decomposable group containing a -COO-A⁰ or -O-B⁰ group, wherein A⁰ represents a -C(R⁰¹)(R⁰²)(R⁰³), or -C(R⁰⁴) (R⁰⁵)-OR⁰⁶ group; B⁰ represents a A⁰ or -COO-A⁰ group; R⁰¹, R⁰², R⁰³, R⁰⁴ and R⁰⁵ each may be the same or different and each represents a hydrogen atom, an alkyl group, a cycloalkyl group, an alkenyl group, or an aryl group, or substituted groups thereof, and R⁰⁶ represents an alkyl group, an aryl group, or substituted groups thererof, provided that at least two of R⁰¹ to R⁰³ each are groups other than a hydrogen atom and provided that two of R⁰¹ to R⁰³ and R⁰⁴ to R⁰⁶ may be combined with each other to form a ring; R⁰ represents a di- or more valent (e.g., trivalent) aliphatic or aromatic hydrocarbon group (e.g., alkylene, arylene) which may have a substituent; and Ar represents a monocyclic or polycyclic, di- or more valent aromatic group which may have a substituent.

The preferred alkyl group has 1 to 4 carbon atoms (e.g., methyl, ethyl, propyl, n-butyl, sec-butyl and t-butyl), the preferred cycloalkyl group has 3 to 10 carbon atoms (e.g., cyclopropyl, cyclobutyl, cyclohexyl, and adamantyl), the preferred alkenyl group has 2 to 4 carbon atoms (e.g., vinyl, propenyl, alkyl and butenyl), and the preferred aryl group has 6 to 14 carbon atoms (e.g., phenyl, xylyl, toluyl, cumenyl, naphthyl and anthracenyl). In the present invention the number of carbon atoms includes that of the substituent on the group.

Examples of the substituents for R⁰, R⁰¹, to R⁰⁶ and Ar include a hydroxy group, a halogen atom (e.g., fluorine, chlorine, bromine and iodine atoms), a nitro group, a cyano group, an alkyl group described above, an alkoxy group (e.g., methoxy, ethoxy, hydroxyethoxy, propoxy, hydroxypropoxy, n-butoxy, isobutoxy, sec-butoxy, and t-butoxy), an alkoxycarbonyl group (e.g., methoxycarbonyl and ethoxy carbonyl), and aralkyl group (e.g., benzyl, phenethyl, and cumyl), an aralkyloxy group (e.g., benzyloxy), an acyl group (e.g., formyl, acetyl, butyryl, benzoyl, and valeryl), an acyloxy group (e.g., butyryloxy and benzoyloxy) an alkenyl group as described hereinabove, an alkenyloxy group (e.g., vinyloxy, propenyloxy, allyloxy and butenyloxy), an aryl group as described hereinabove, an aryloxy group (e.g., phenoxy), and an aryloxycarbonyl group (e.g., phenyloxycarbonyl).

The group represented by -COOA⁰ or -OB⁰ is preferably a cumyl ester group, an acetal group, a tetrahydropyranyl ether group, an enol ether group, an enol ester group, a tertiary alkyl ether group, a tertiary alkyl ester group, or a tertiary alkyl carbonate group. It is more preferably a tertiary alkyl ester group, a tertiary alkyl carbonate group, a cumyl ester group, or a tetrahydropyranyl ether group.

Preferably the compounds are prepared by bonding the group shown above, i.e., a -R⁰(̵COO-A⁰)_{n'} group or a B⁰ group for protecting, to a part or all of the phenolic OH groups of the polyhydroxy compounds described in JP-A-1-289946, JP-A-1-289947, JP-A-2-2560, JP-A-3-128959, JP-A-3-158855, JP-A-3-179353 (EP-A-416544), JP-A-3-191351 (EP-A-458988), JP-A-3-200251, JP-A-3-200252 (US-A-5,112,719), JP-A-3-200253, JP-A-3-200254, JP-A-3-200255, JP-A-3-259149, JP-A-3-279958 JP-A-3-279959 JP-A-4-1650, JP-A-4-1651, JP-A-4-11260, JP-A-4-12356, JP-A-4-12357, JP-A-4-271349, Japanese Patent Application 3-230790, Japanese Patent Application 3-320438, Japanese Patent Application 4-25157, Japanese Patent Application 4-52732, Japanese Patent Application 4-103215, Japanese Patent Application 4-104542, Japanese Patent Application 4-107885, Japanese Patent Application 4-107889 and Japanese Patent Application No. 4-152195.

The polyhydroxy compounds described in JP-A-1-289946, JP-A-3-128959, JP-A-3-158855, JP-A-3-179353 (EP-A-416,544), JP-A-3-200251, JP-A-3-200252 (US-A-5,112,719), JP-A-3-200255, JP-A-3-259149, JP-A-3-279958/ JP-A-4-1650, 4-11260, JP-A-4-12356, JP-A-4-12357, Japanese Patent Application 4-25157, Japanese Patent Application 4-103215, Japanese Patent Application 4-104542, Japanese Patent Application 4-107885, Japanese Patent Application 4-107889, and Japanese Patent Application No. 4-152195 are more preferred.

The compounds represented by Formulas (I) to (XVI) are preferably used as the compound (c).

In the following formulas the groups containing the acid decomposable group (-COOA⁰ or -OB⁰) should be positioned so that the number of the bonded atoms satisfies the definitions disclosed hereinabove.

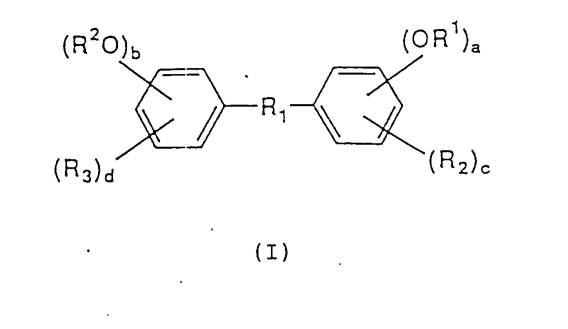

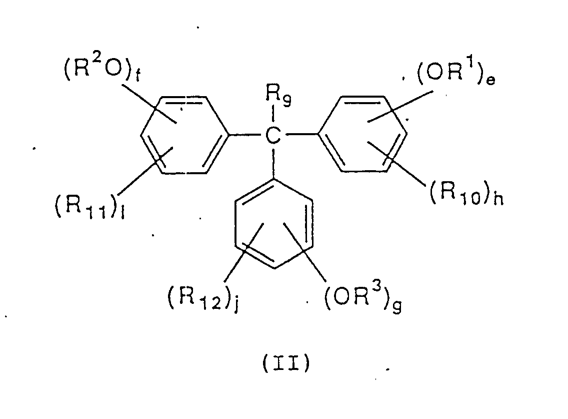

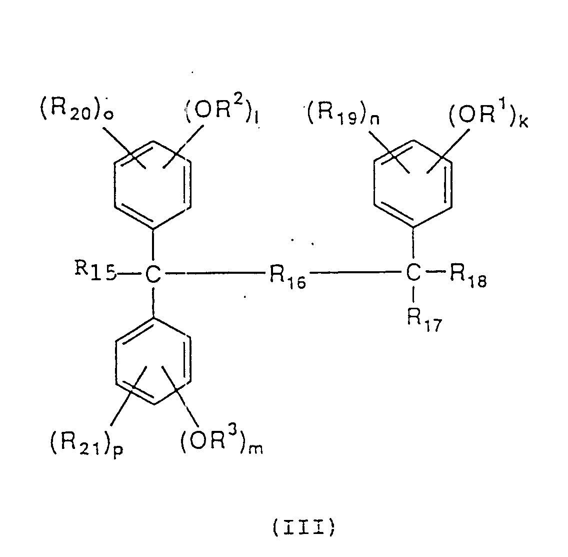

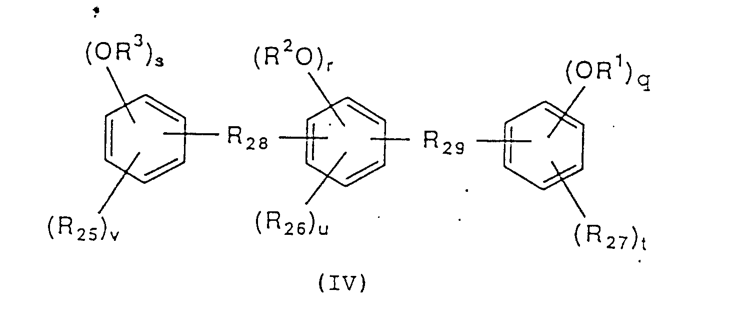

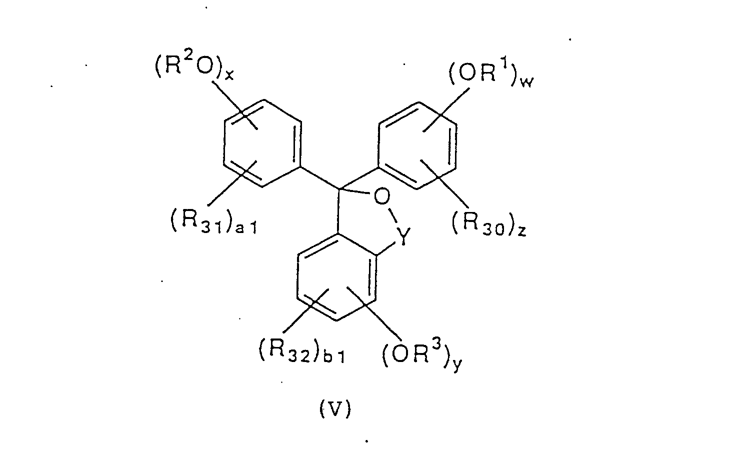

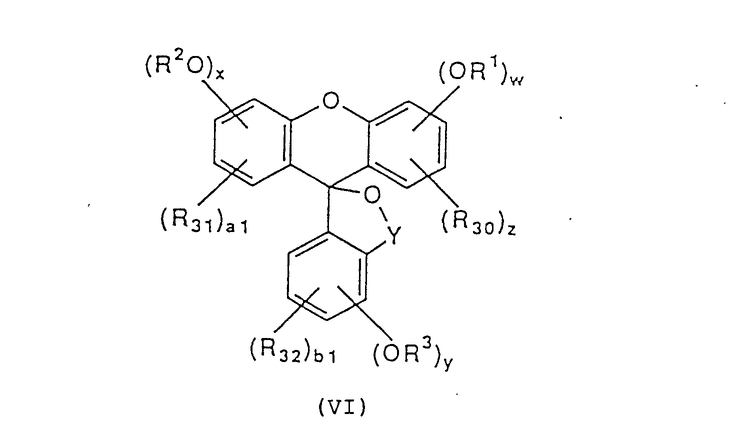

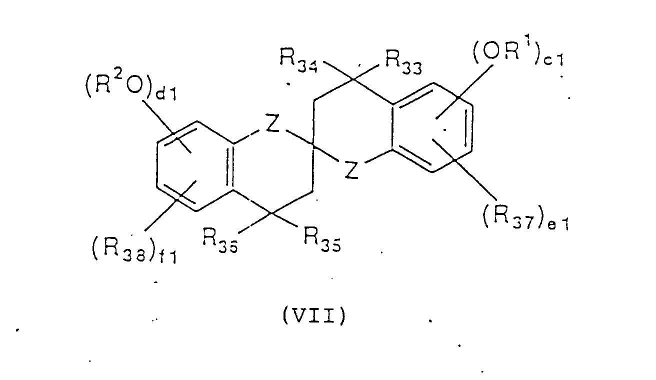

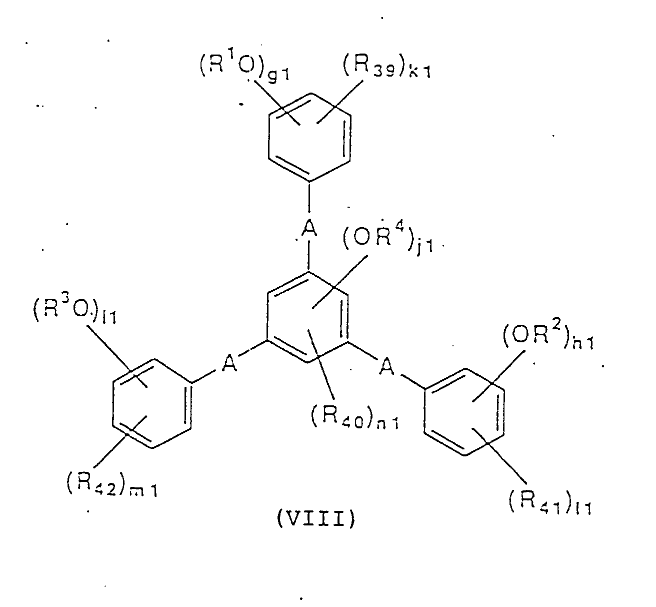

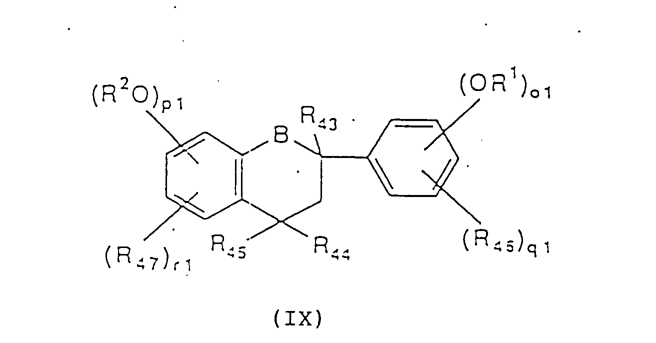

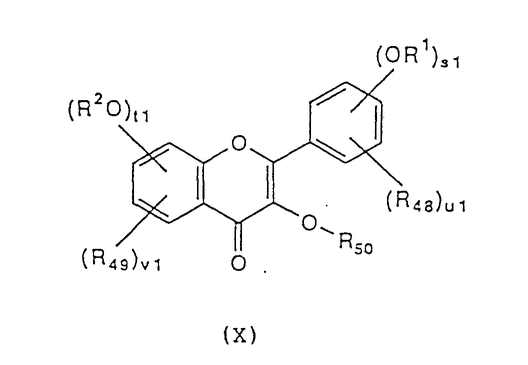

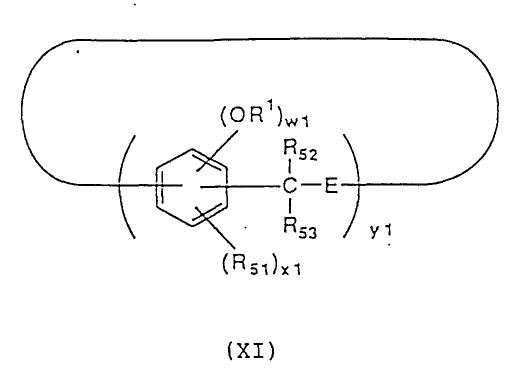

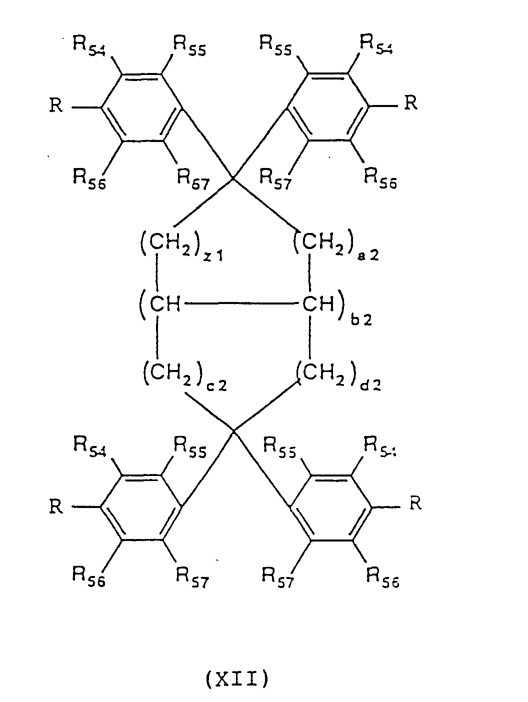

In the above formulas,
R¹, R², R³ R⁴ are the same or different, and each represents a hydrogen atom, a -R⁰(̵COO-A⁰)_{n'} (n'≥1) group or a B⁰ group (R⁰ ,A⁰ and B⁰ and n' have the same definitions as hereinbefore: the same also hereinafter) provided that at least two of groups represented by R¹, R², R³ or R⁴ each represents -R⁰(̵COO-A⁰)_{n'} (n'≥1) or B⁰;
R₁ represents -CO-, -COO-, -NHCONH-, -NHCOO-, -O-, -S-, -SO- , -SO₂-, -SO₃-, or 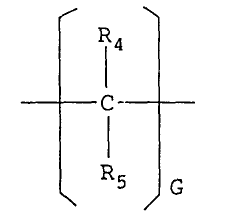 wherein G is 2 to 6, provided that when G is 2, at least one of R₄ and R₅ is an alkyl group;
R₄ and R₅ are t:he same or different, and each represents a hydrogen atom, an alkyl group, an alkoxy group, -OH, -COOH, -CN, a halogen atom, -R₆-COOR₇, or -R₈-OH;
R₆ and R₈ each represents an alkylene group;
R₇ represents a hydrogen atom, an alkyl group, an aryl group, or an aralkyl group;
R₂, R₃, R₉ to R₁₂, R₁₅, R₁₇ to R₂₁, R₂₅ to R₂₇, R₃₀ to R₃₂, R₃₇ to R₄₂, R₄₆ to R₄₉, and R₅₁ are the same or different, and each represents a hydrogen atom, a hydroxy group, an alkyl group, an alkoxy group, an acyl group, an acyloxy group, an aryl group, an aryloxy group, an aralkyl group, an aralkyloxy group, a halogen atom, a nitro group, a carboxyl group, a cyano group, or -N(R₁₃)(R₁₄) where R₁₃ and R₁₄ each represents an alkyl group and an aryl group;
R₁₆ represents a single bond, an alkylene group or 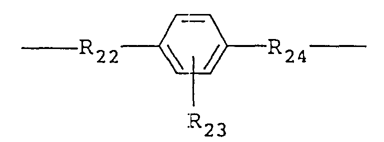 wherein R₂₂ and R₂₄ are the same or different, and each represents a single bond, an alkylene group, -O-, -S-, -CO-, or a carboxyl group; and
R₂₃ represents a hydrogen atom, an alkyl group, an alkoxy group, an acyl group, an acyloxy group, an aryl group, a nitro group, a hydroxy group, a cyano group, a carboxyl group, -O-R⁰(̵COO-A⁰)_{n'} or -O-B⁰;
R₂₈ and R₂₉ are the same or different, and each represents a methylene group, a lower alkyl-substituted methylene group, a halomethylene group, or an alkoxymethylene group (in the present invention a lower alkyl group is an alkyl group having 1 to 4 carbon atoms);
R₃₃ to R₃₆ are the same or different, and each represents a hydrogen atom or an alkyl group;
R₄₃ to R₄₅ are the same or different, and each represents a hydrogen atom, an alkyl group, an alkoxy group, an acyl group, or an acyloxy group;
R₅₀ represents a hydrogen atom, -R⁰(̵COO-A⁰)_{n'}, -B⁰, or 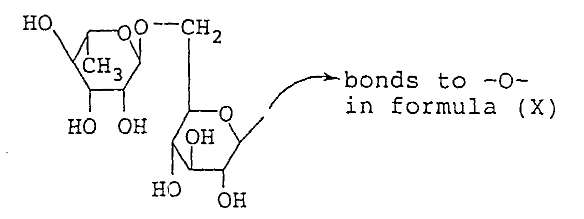
R₅₂ to R₅₃ are the same or different, and each represents a hydrogen atom, a lower alkyl group, a lower haloalkyl group, or an aryl group;
R₅₄ to R₅₇ are the same or different, and each represents a hydrogen atom, a hydroxy group, a halogen atom, a nitro group, a cyano group, a carbonyl group, an alkyl group, an alkoxy group, an alkoxycarbonyl group, an aralkyl group, an aralkyloxy group, an acyl group, an acyloxy group, an alkenyl group, an alkenyloxy group, an aryl group, an aryloxy group, or an aryloxycarbonyl group;
R represents -O-R⁰(̵COO-A⁰)_{n'}, -O-B⁰ or a hydroxy group provided that at least two of the R groups each represents
   -O-R⁰(̵COO-A⁰)_{n'} or -O-B⁰ and that groups represented by the same symbol may be not necessarily the same group;
Y represents -CO- or -SO₂-;
Z and B each represents a single bond or -O-;
A represents a methylene group, a lower alkyl-substituted methylene group, a halomethylene group, or an alkoxymethylene group;
E represents a single bond or an oxymethylene group;

When subscripts a to z and a1 to y1 are plural, the groups in parenthesis may be the same or different;
a to q, s, t, v, g1 to i1, k1 to m1, o1, q1, s1, and u1 each represents 0 or an integer of 1 to 5;
r, u, w, x, y, z, a1 to f1, p1, r1, t1, and v1 to x1 each represents 0 or an integer of 1 to 4;
j1, n1, z1, a2, b2, c2, and d2 each represents 0 or an integer of 1 to 3, provided that at least one of z1, a2, b2, c2, and d2 is 1 or more;
yl represents an integer of 3 to 8
Wherein (a+b), (e+f+g), (k+ℓ+m), (q+r+s), (w+x+y), (cl+dl), (gl+hl+il+jl), (ol+pl), and (sl+tl)≧2;
(j1+n1)≦3;
(r+u), (w+z), (x+al), (y+bl), (cl+el), (dl+fl), (pl+rl), (tl+vl), (xl+wl)≦4, but in formula (V), (w+z) and(x+al)≦5; and
(a+c), (b+d), (e+h), (f+i), (g+j), (k+n), (1+o), (m+p), (q+t), (s+v), (gl+kl), (hl+ll), (il+ml), (ol+ql), and (sl+ul)≦5. 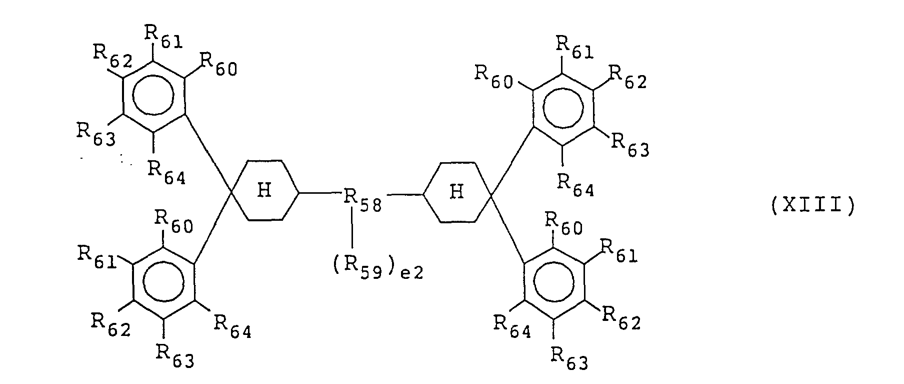
wherein R₅₈ represents an organic group such as an alkylene group, an alkenylene group, an arylene group, a single bond, -S-, -SO-, or -(O=)S(=O)-; and
R₅₉ represents a hydrogen atom, a monovalent organic group such as those recited hereinbefore as examples of substituents for R⁰, or 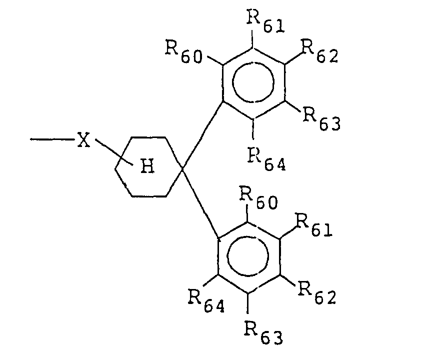
R₆₀ to R₆₄ are the same or different and each represents a hydrogen atom, a hydroxy group, a halogen atom, an alkyl group, an alkoxy group, an alkenyl group, -O-R⁰(̵COO-A⁰)_{n'} or -O-B⁰, provided that at least two of R₆₀ to R₆₄ (each of the at least two groups may be positioned at any of the benzene rings in formula (XIII)) each represents -O-R⁰(̵COO-A⁰)_{n'} or-O-B⁰; groups represented by the same symbols may be the same or different;
X represents a divalent organic group, preferably a substituted or unsubstituted alkylene or arylene group; and
e2 represents 0 or 1. 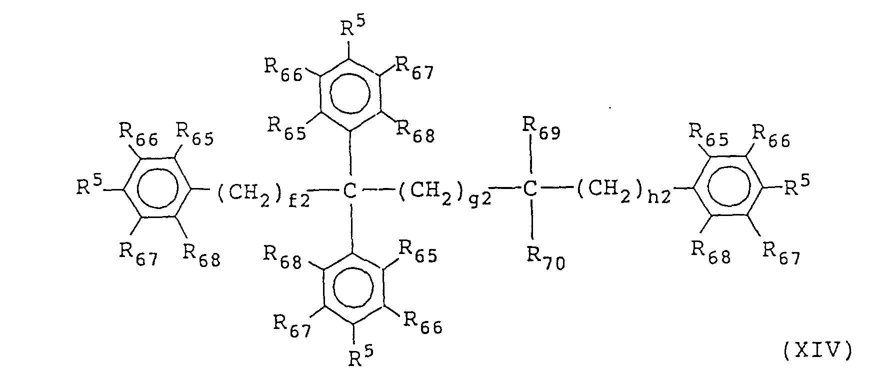
R₆₅ to R₆₈ are the same or different, and each represents a hydrogen group, a hydroxy atom, a halogen atom, an alkyl group, an alkoxy group, or an alkenyl group;
R₆₉ to R₇₀ represents a hydrogen atom, an alkyl group, or 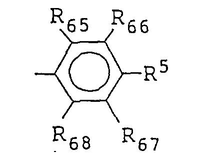
wherein R⁵ represents a hydroxy group, a -O-R⁰(̵COO-A⁰)ₙ, group or a -O-B⁰ group; and at least two of the R⁵ groups each represents -O-R⁰(̵COC-A⁰)ₙ, or -O-B⁰;
f2 and h2 each represents 0 or 1;
g2 represents 0 or an integer of 1 to 4; and
the groups having the same symbols may be the same or different. 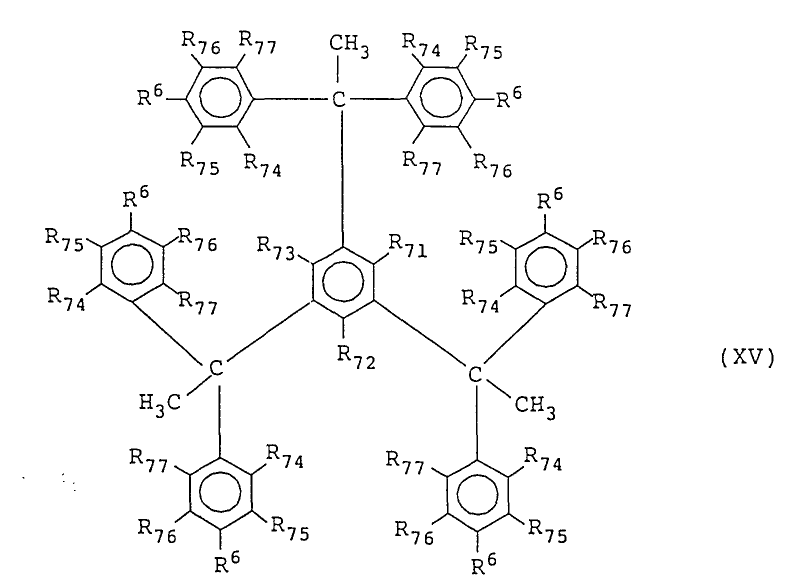
wherein R₇₁ to R₇₇ are the same or different, and each represents a hydrogen atom, a hydroxy group, a halogen atom, an alkyl group, an alkoxy group, a nitro group, an alkenyl group, an aryl group, an aralkyl group, an alkoxycarbonyl group, an aryloxycarbonyl group, an acyloxy group, an acyl group, an aralkyloxy group, or an aryloxy group; and
R⁶ represents a hydroxyl group, a -O-R⁰(̵COO-A⁰)_{n'} group or a -O-B⁰ group, and at least two of the R⁶ groups each represents a -O-R⁰(̵COO-A⁰)_{n'} group or -O-B⁰ group. 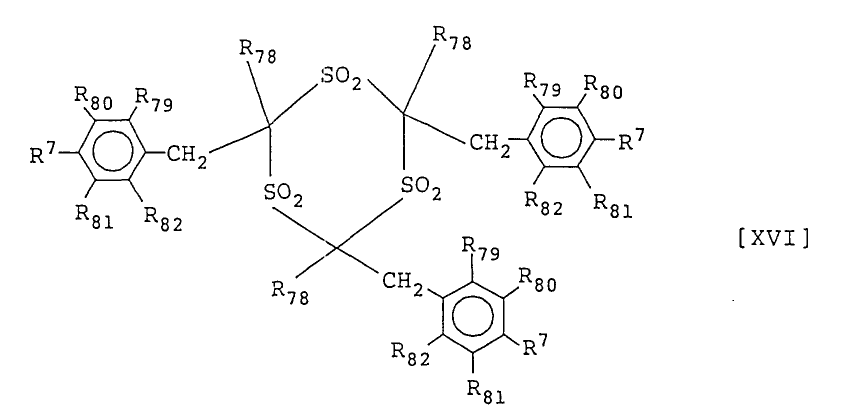
wherein R₇₈ represents a hydrogen atom or an alkyl group;
R₇₉ to R₈₂ represents a hydroxy group, a hydrogen atom, a halogen atom, an alkyl group, or an alkoxy group;
R⁷ represents a hydroxy group, a -O-R⁰(̵COO-A⁰)_{n'} group, or a -OB⁰ group, at least two of the R⁷ groups each representing a -O-R⁰(̵COO-A⁰)_{n'} group or a -O- B⁰ group; and
the groups having the same symbols may be the same on different.

In the definitions for groups in formulae (I) to (XVI), the preferred carbon numbers and examples for an alkyl group, an alkenyl group, a cycloalkyl group, an aryl group, and substituents where specifically not explained are the same as those explained in the definitions for A⁰ and B⁰ hereinabove.

Furthermore, in formulae (I) to (XVI), preferably, an aralkyl group has 7 to 11 carbon atoms (e.g., benzyl, phenethyl, and cumyl), an acyl group has 1 to 6 carbon atoms (e.g., formyl, acetyl, butyryl, benzoyl, and valeryl), an alkoxy group has 1 to 4 carbon atoms (e.g., methoxy, ethoxy, hydroxyethoxy, propoxy, hydroxypropoxy, n-butoxy, isobutoxy, sec-butoxy, and t-butoxy), an alkenyloxy group has 2 to 4 carbon atoms (e.g., vinyloxy, propenyloxy, allyloxy, and butenyloxy), an aryloxy group has 6 to 10 carbon atoms (e.g., phenoxy), an aralkyloxy group has 7 to 11 carbon atoms (e.g., benzyloxy), an acyloxy group has 1 to 6 carbon atoms (e.g., butyryloxy), an alkoxycarbonyl group has 2 to 5 carbon atoms (e.g., methoxycarbonyl and ethoxycarbonyl), an aryloxycarbonyl group has 7 to 11 carbon atoms (e.g., phenyloxycarbonyl), an alkylene group has 1 to 4 carbon atoms (e.g., methylene and ethylene), an alkenylene group has 3 to 5 carbon atoms, and an arylene group has 6 to 14 carbon atoms.

Methods for preparing polyhydroxy compounds used for preparing compounds represented by formulae (I) to (XVI) are disclosed in the following literatures.
Formula (I): JP-A-3-279958
Formula (II): JP-A-4-11260 (Compounds are obtained according on the method disclosed in DE-A-1,930,333 or Journal of Chemical Society, (1954), Page 985)
Formula (III): JP-A-179353, JP-A-4-1650, JP-A-4-12356, and JP-A-1-2357
Formula (IV): JP-A-3-200253, and JP-A-3-259149
Formulae (V) and (VI): Japanese Patent Application 3-62150 (Compounds are obtained according on the method of H.L. Rohatgi disclosed in Indian J. Appl. Chem. Vol. 21, No. 3, (1958) 177. The compounds are commercially available.)
Formula (VII): JP-A-64-76047
Formula (VIII): JP-A-1-289946, JP-A-3-158855, JP-A-200252, and JP-A-3-259149
Formula (IX): JP-A-1-289947 and JP-A-279959
Formula (X): JP-A-60-163043
Formula (XI): JP--A-3-279958
Formula (XII): Japanese Patent Application 3-320438 (Compounds are obtained according on the method disclosed in JP-A-56-55328.)
Formula (XIII): Japanese Patent Application 4-104542 (Compounds are obtained according on the method disclosed in JP-A-49-250.)
Formula (XIV): Japanese Patent Application 4-107889 (Compounds are obtained according on the method disclosed in JP-A-55-162728 using p-hydroxyphenylketone compounds which can be obtained according on the method disclosed in Chemische Berichte Vol. 74, pp. 1772 (1941). The compounds can also be obtained according to the method disclosed in US-A-2,965,611.)
Formula (XV): Japanese Patent Application 4-107889 (Compounds are obtained according on the method disclosed in JP-A-55-162728.)
Formula (XVI): Japanese Patent Application 4-103215 (Compounds are obtained according on the method disclosed in US-A-3,891,673.)

Illustrated examples of the skeletons of preferred compounds (c) are shown below: 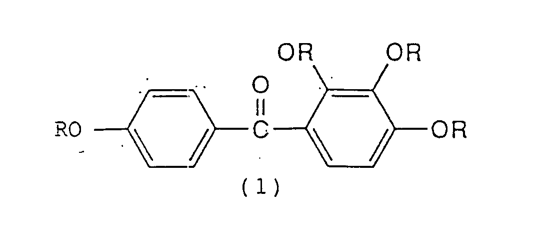 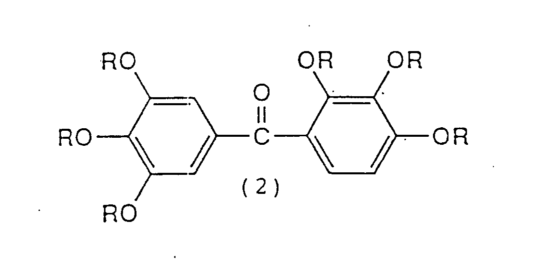 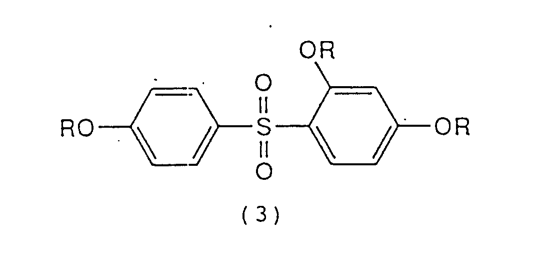 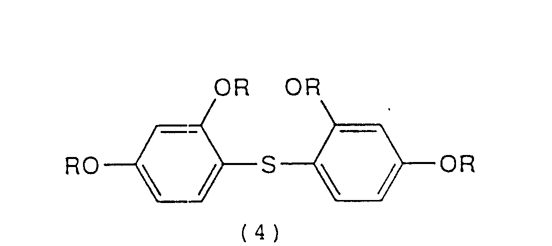 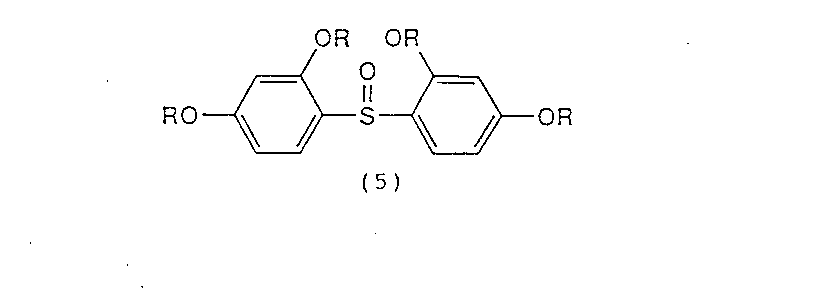 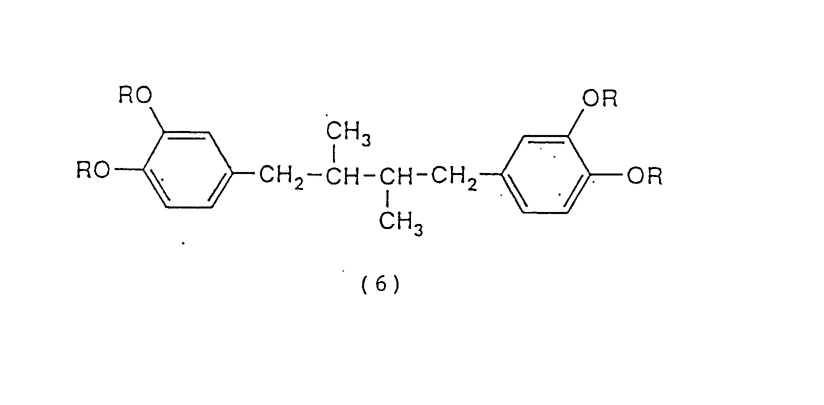 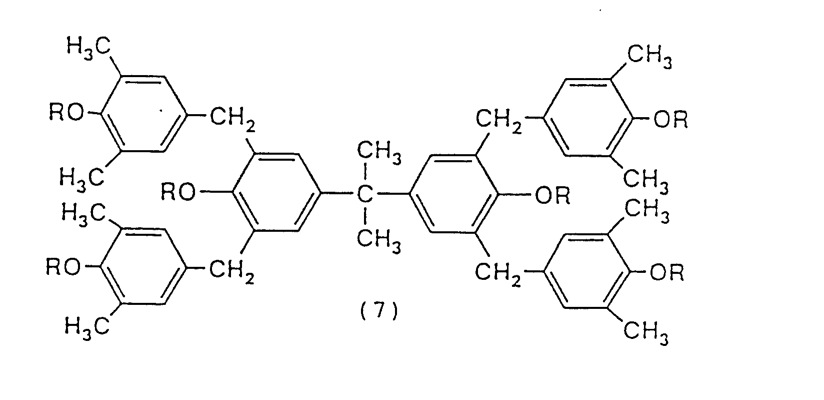 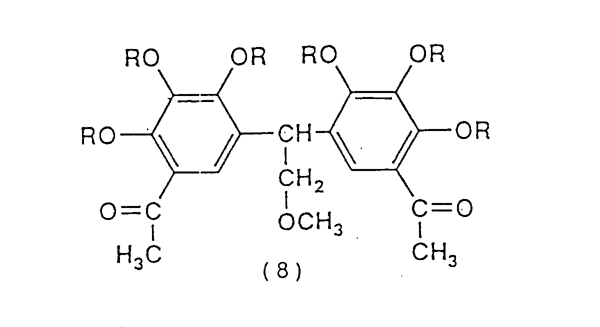 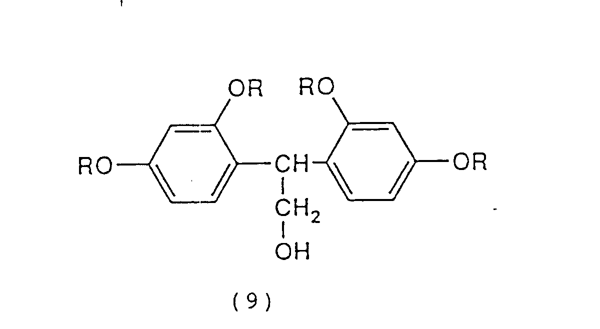 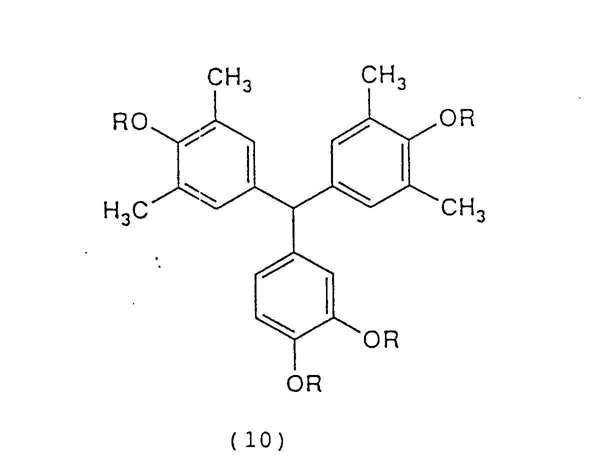 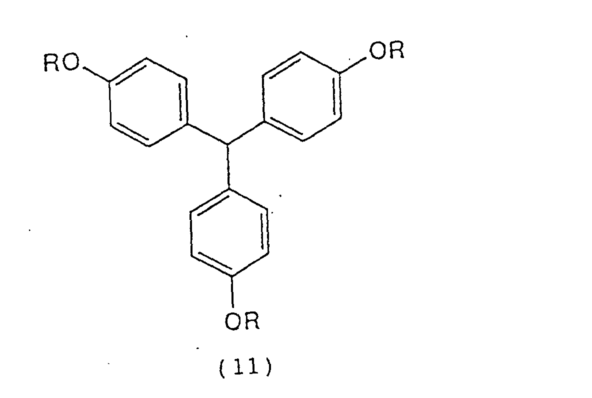 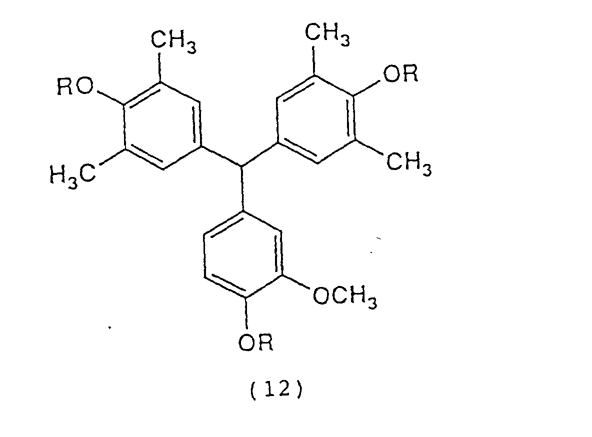 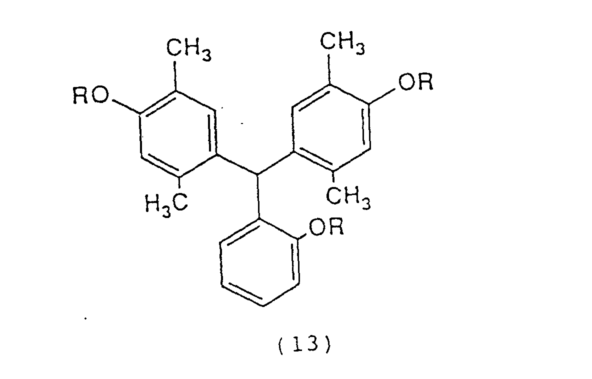 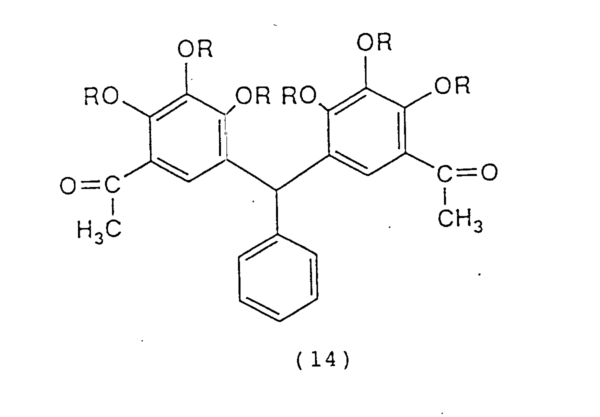 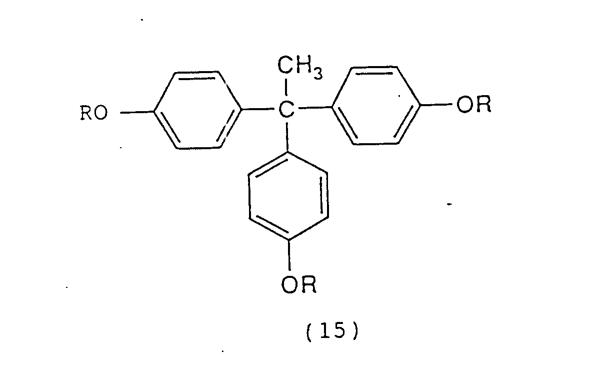 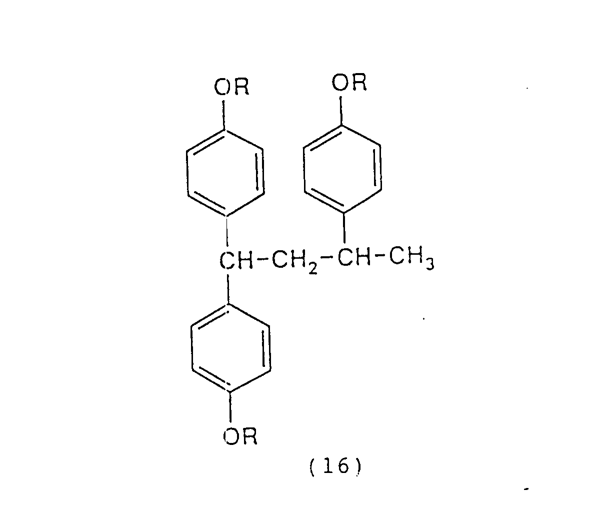 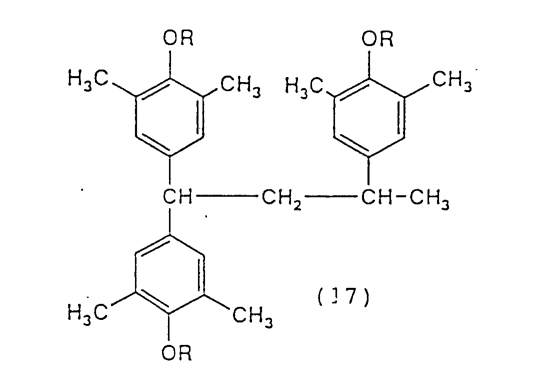 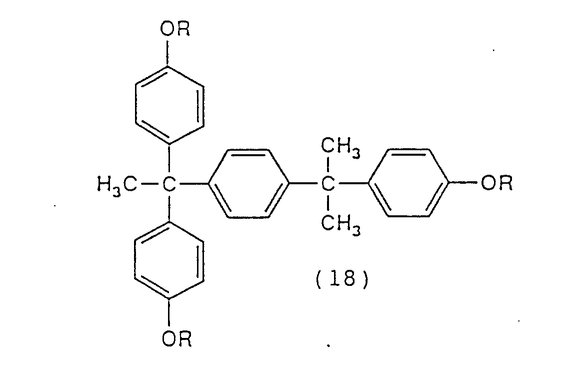 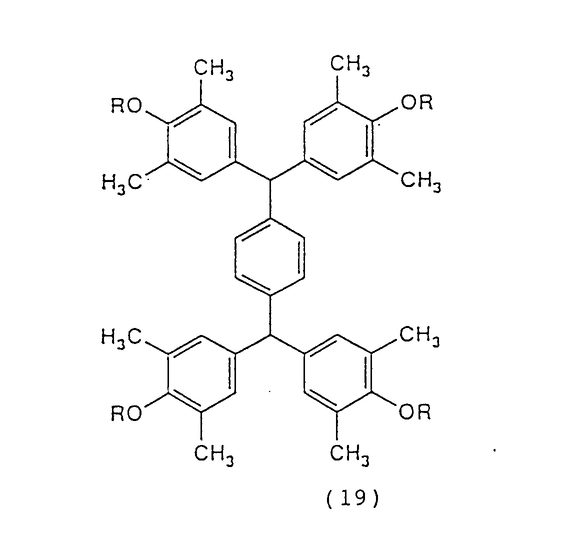 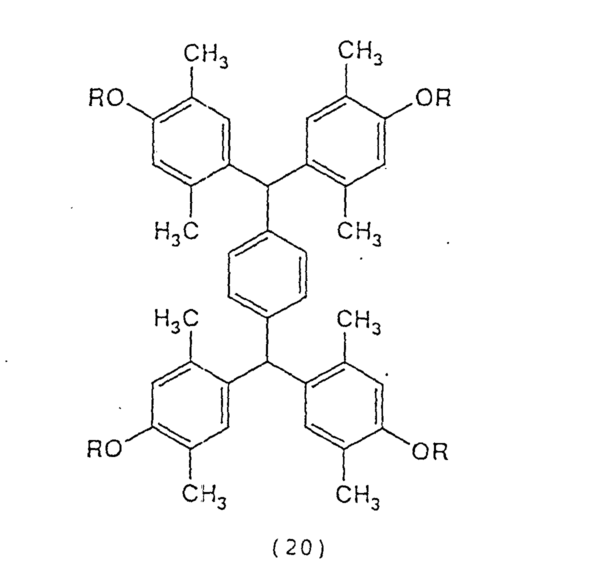 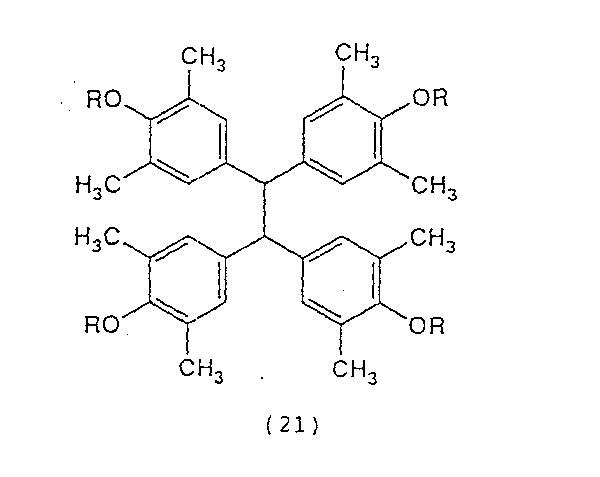 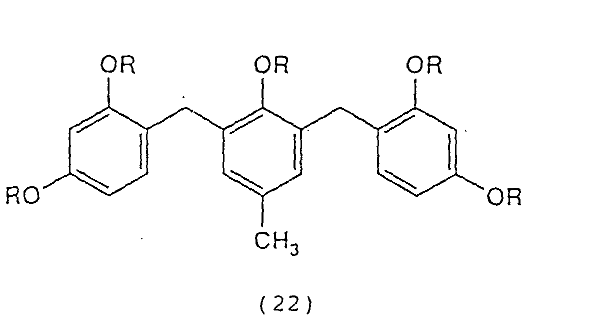 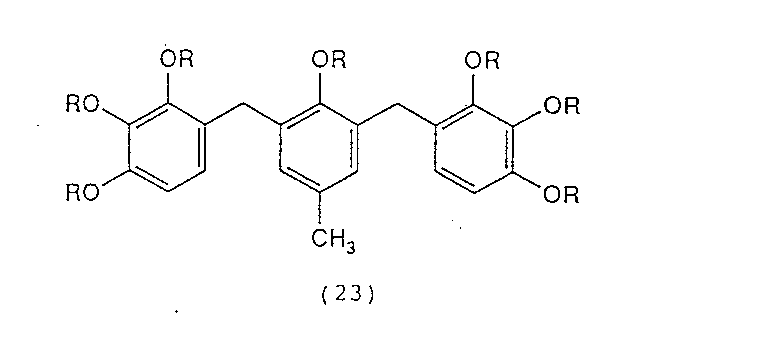 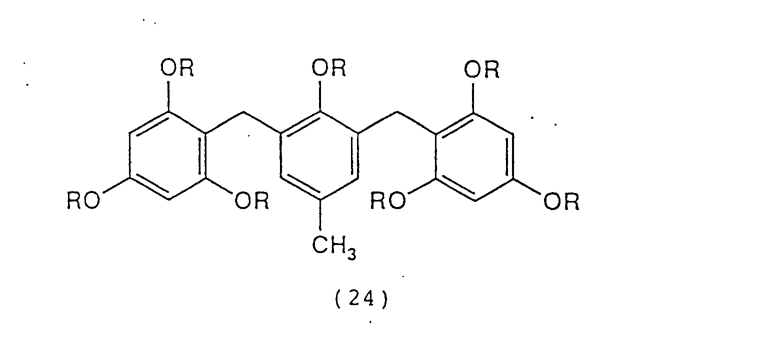 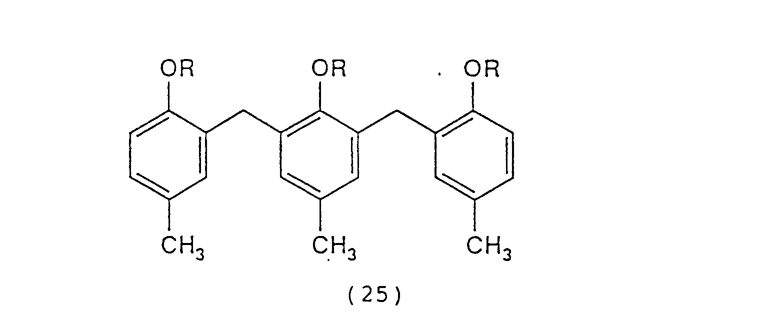 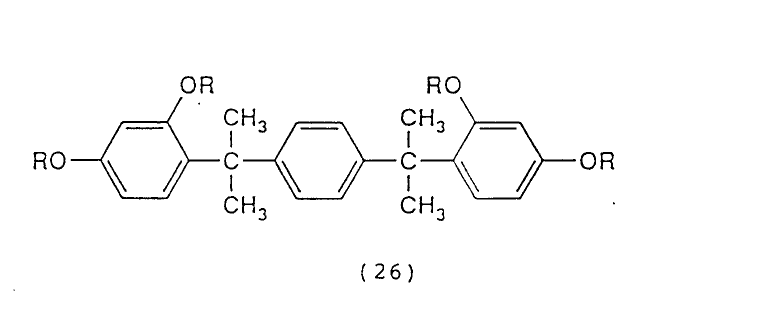 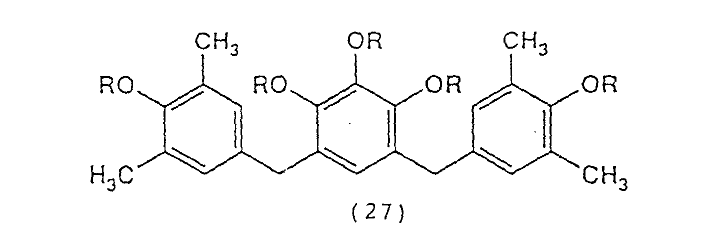 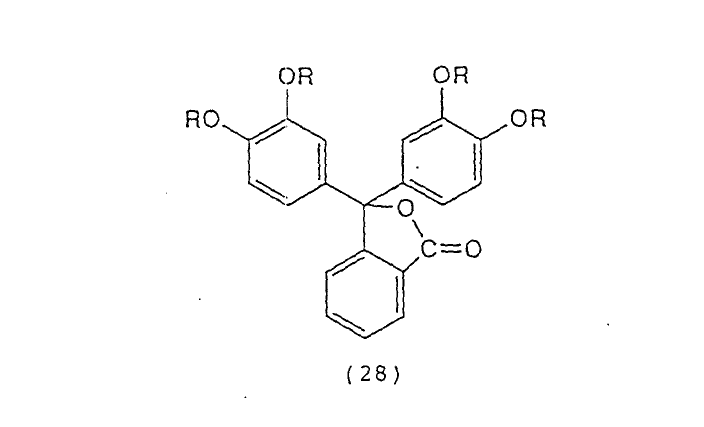 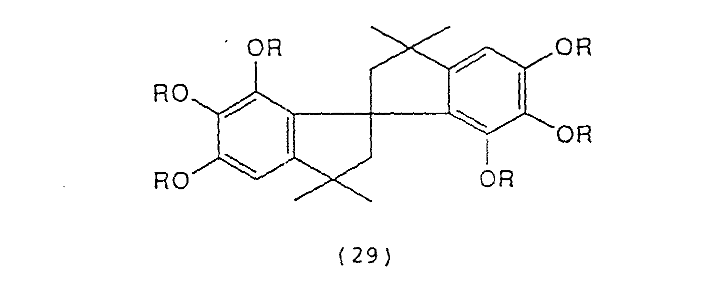 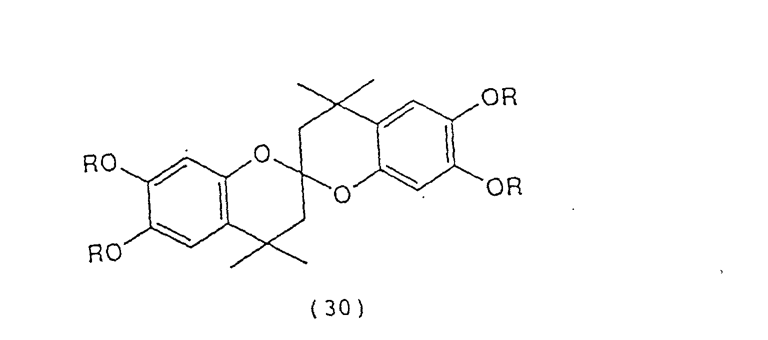 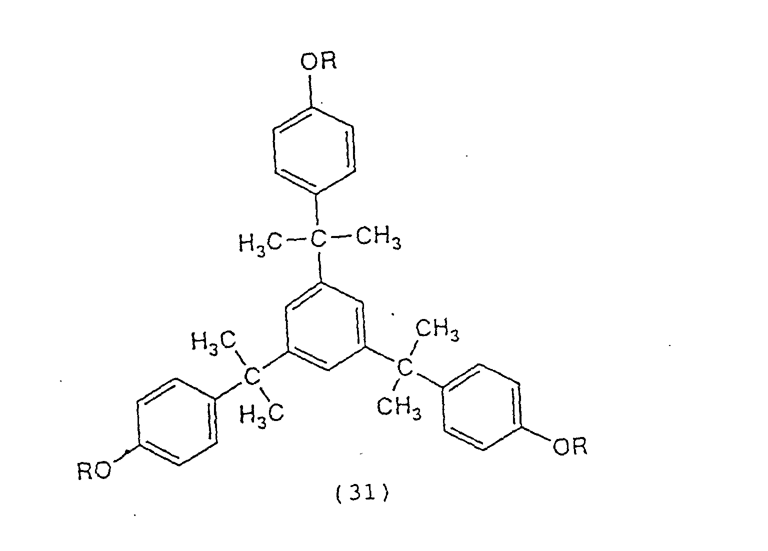 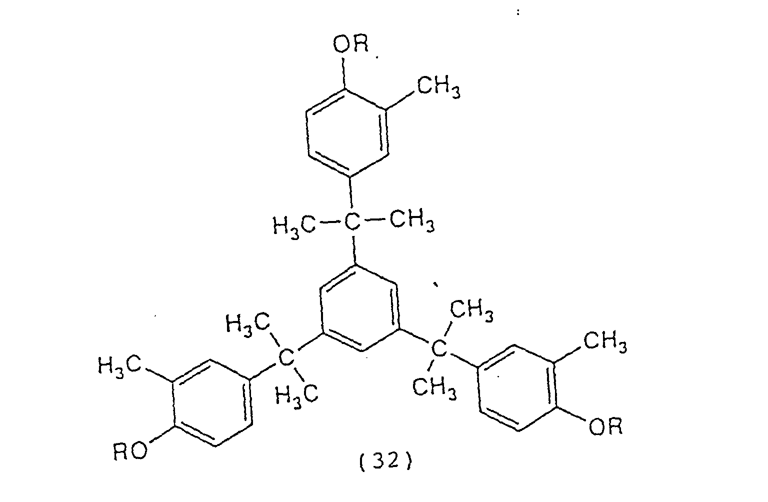 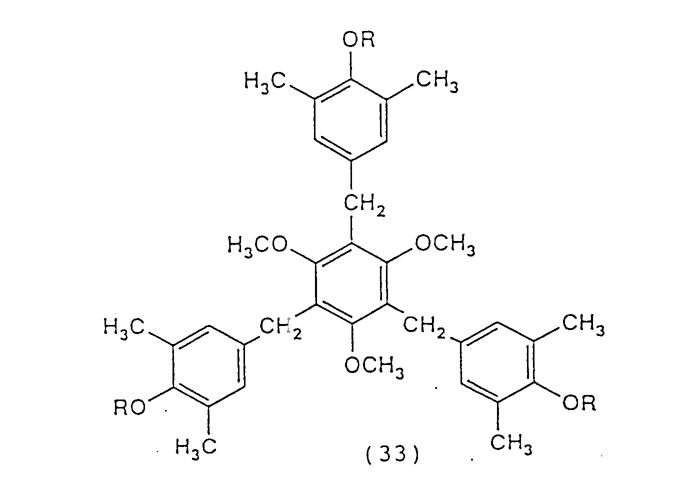 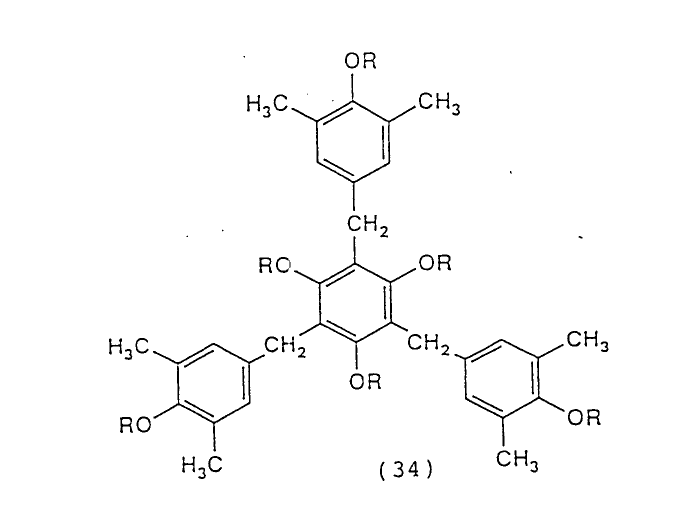 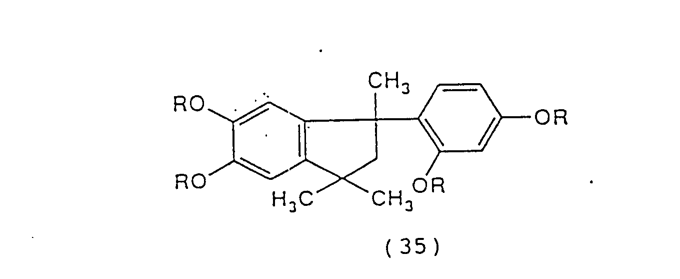 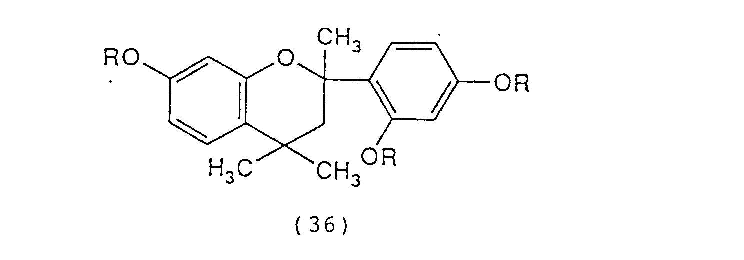 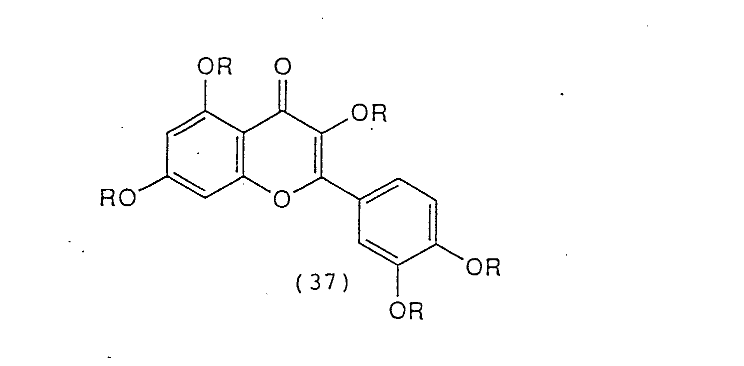 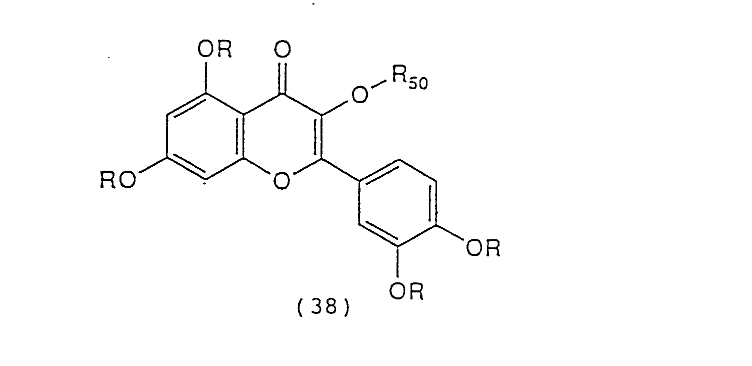 wherein R₅₀ is 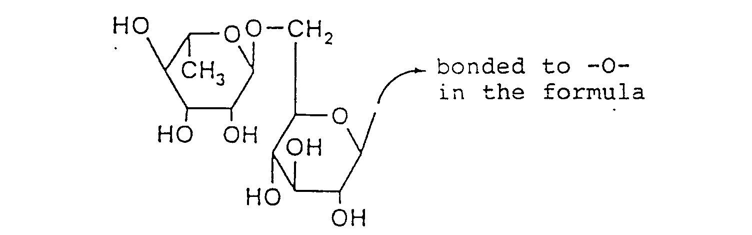 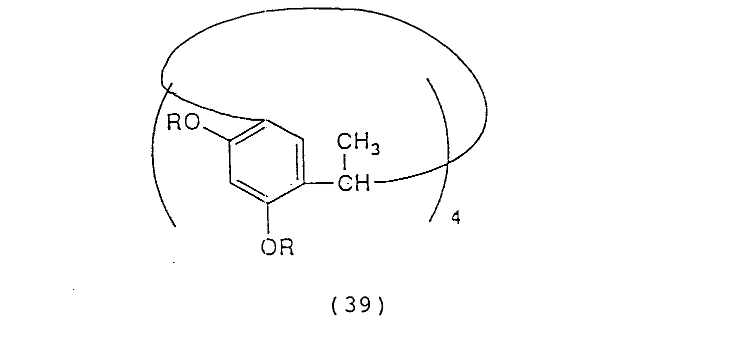 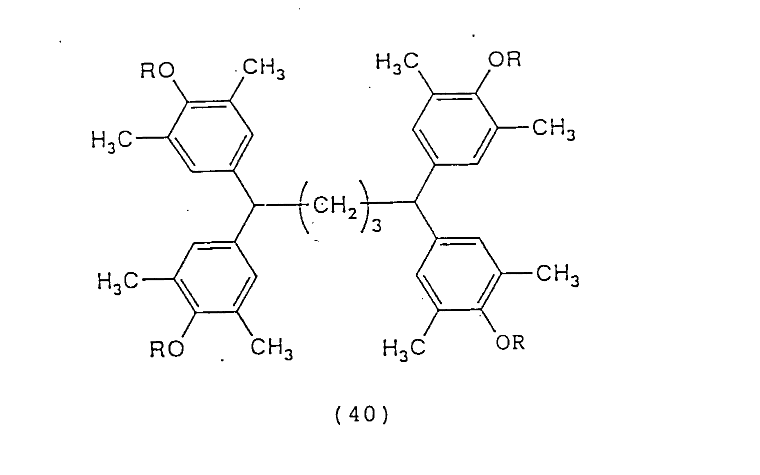 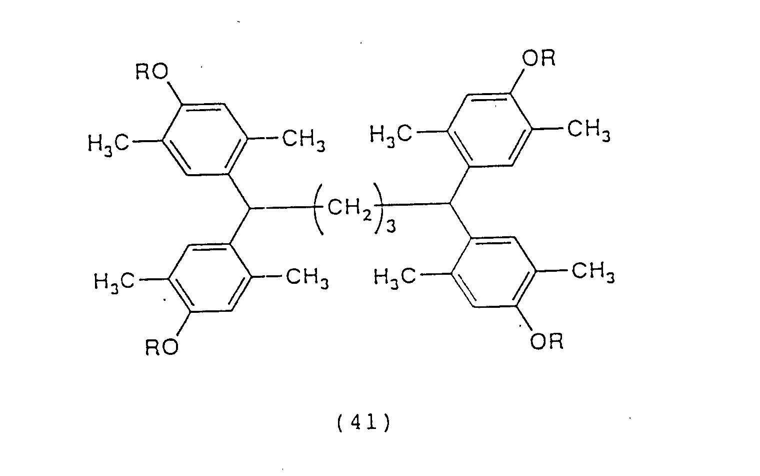 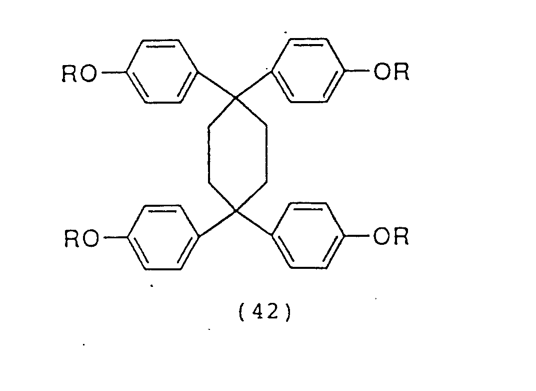 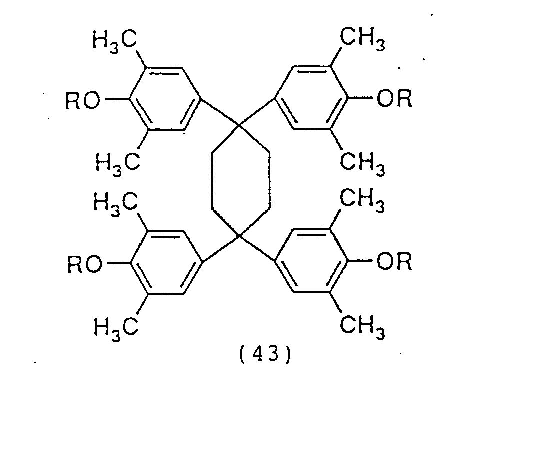 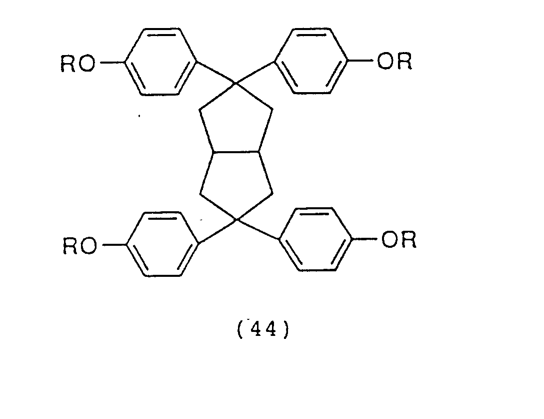 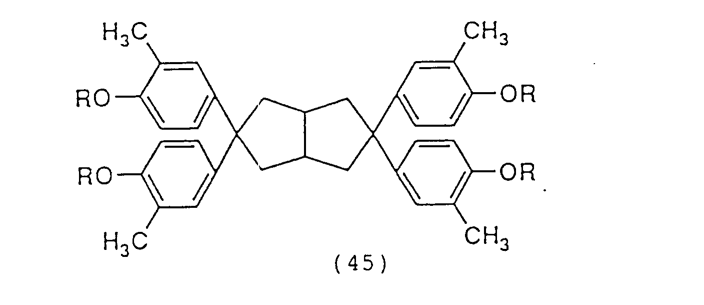 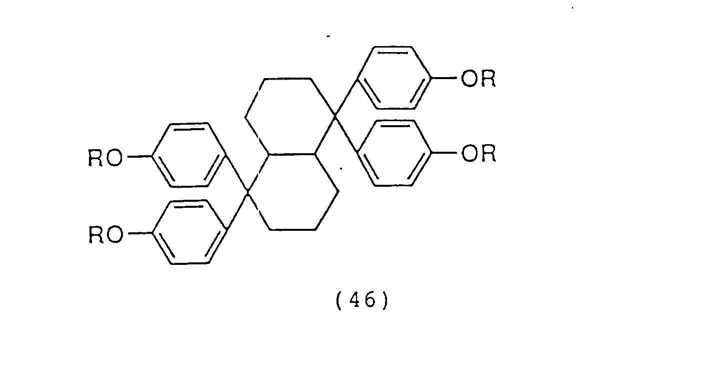 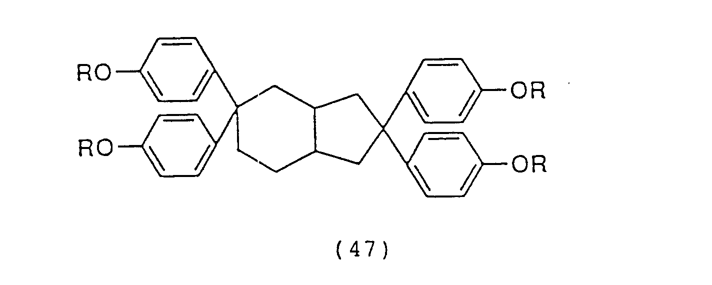 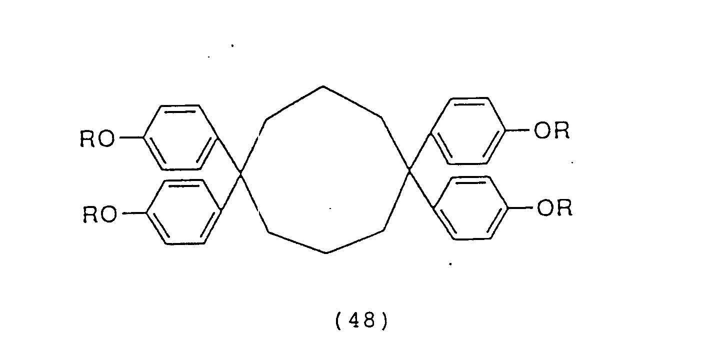 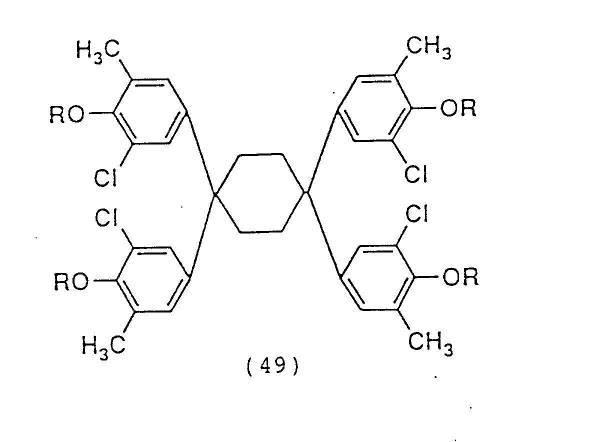 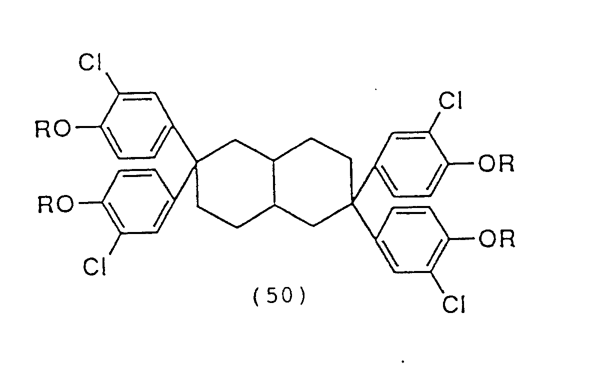 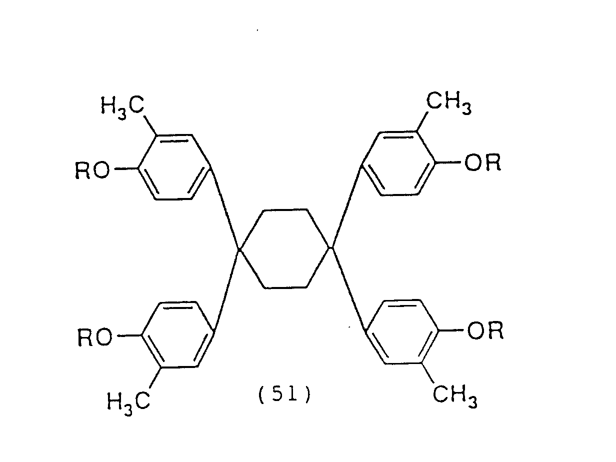 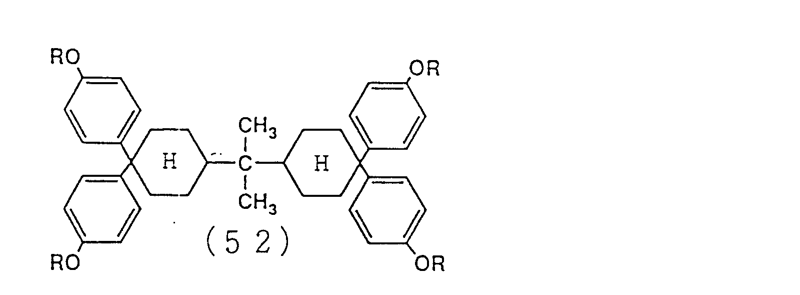 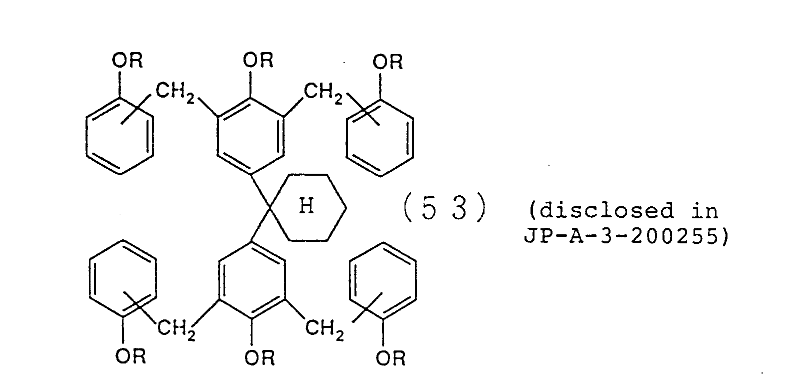 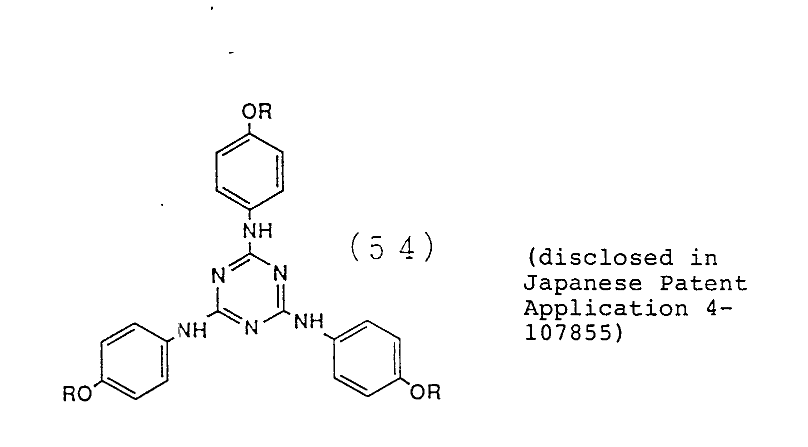 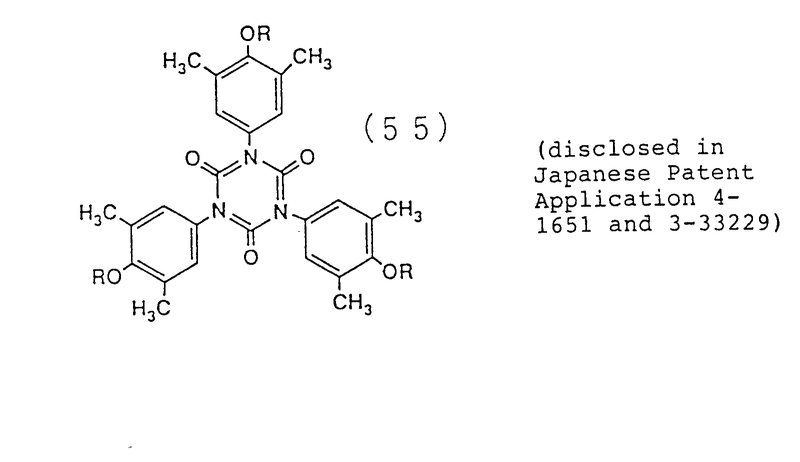 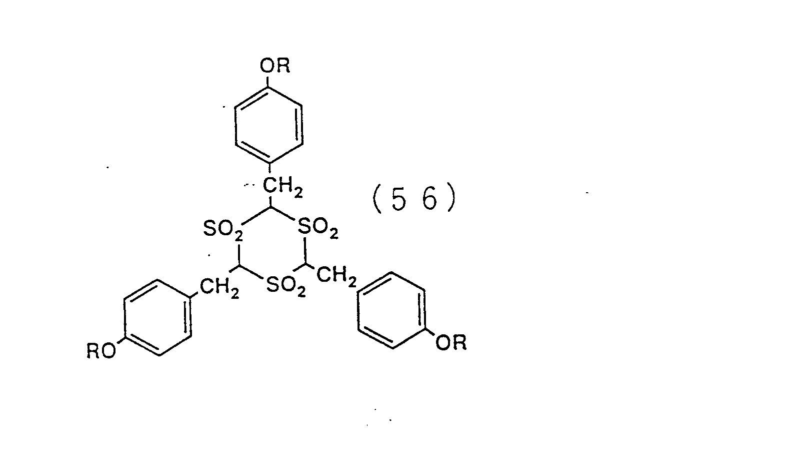 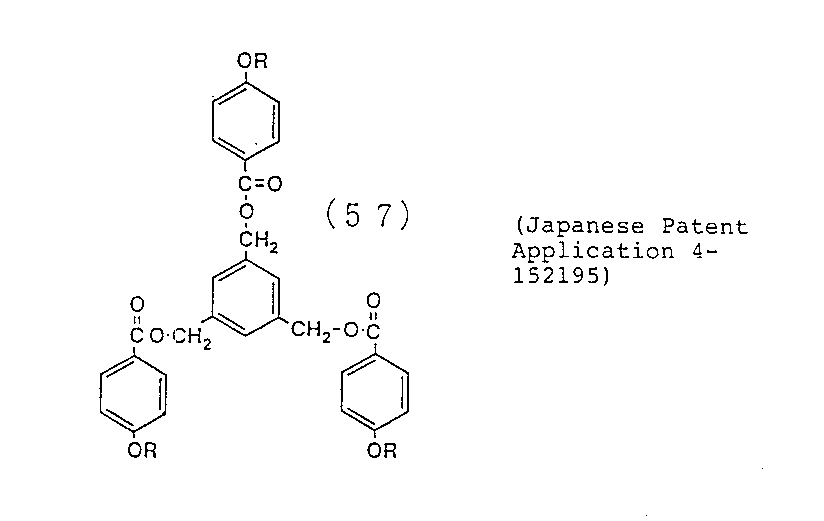 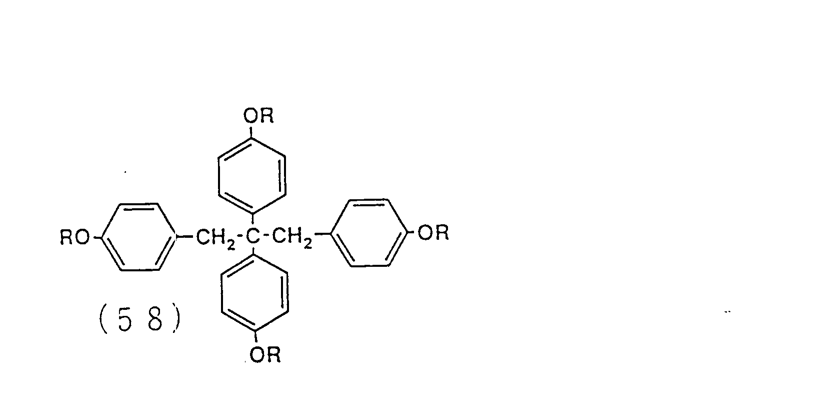 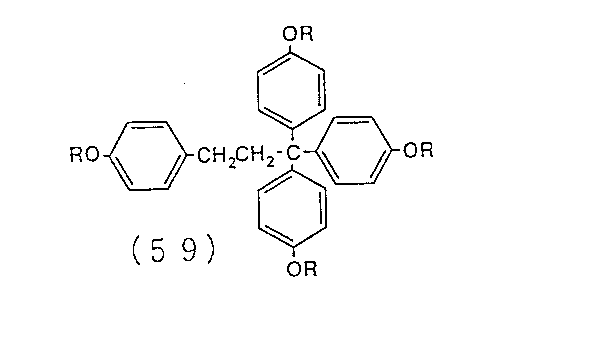 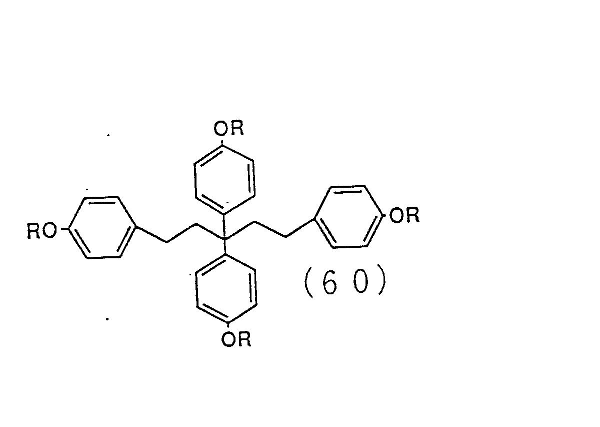 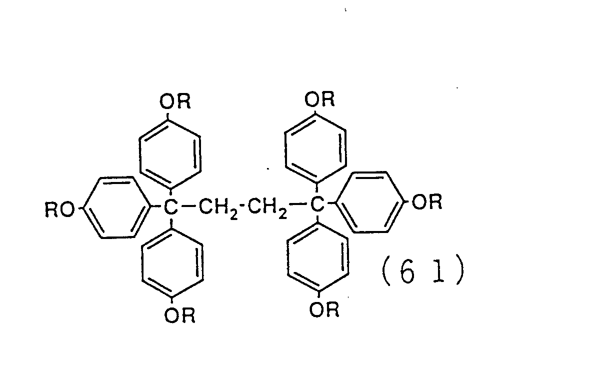 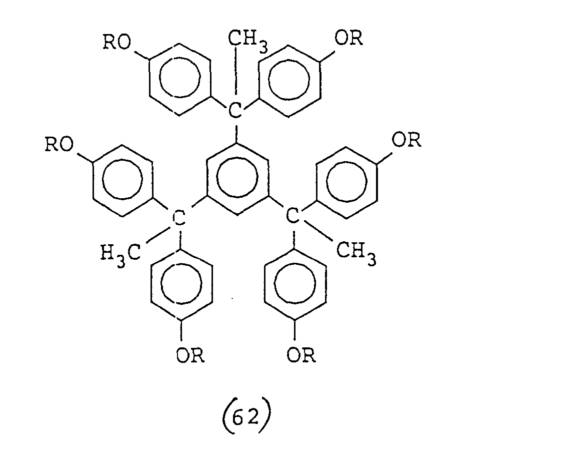 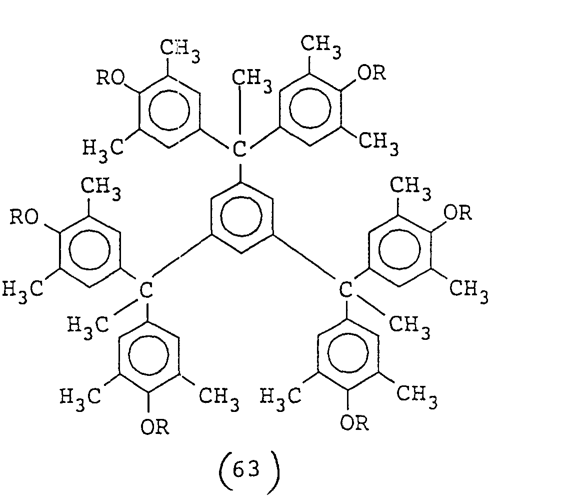 R in the above compounds (1) to (63) represents a hydrogen atom or a group containing -COOA⁰ or -OB⁰ such as -CH₂COO-C(CH₃)₂C₆H₅, -COOC₄H₉(t), 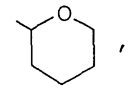 -CH₂-COOC₄H₉ provided that at least two or at least three (depending on the number of bonded atoms therebetween) of the R groups are groups other than a hydrogen atom and they are positioned so that the definition for the number of the bonded atoms between the acid decomposable groups is satisfied. The groups represented by R may be the same or different.

Method for producing compound (c) by substituting a hydrogen atom in the polyhydroxy compound with an acid decomposable group are well known. Typical examples for the methods are shown below.
i) Introducing of-COOC(CH₂)₃ can be conducted by the method disclosed in J. Frechet et. al., Polymer, Vol. 24, August, 995 (1983), i.e., by reacting a polyhydrodroxy compound with di-t-butylcarbonate in the presence of a basic catalyst.
ii) Introducing of a tetrahydropyranyl group can be conducted by the method disclosed in H.N. Grant et. at., Helv. Chem. Acta. 46, 415 (1963), i.e., by reacting a polyhydroxy compound with 3,4-dihydro-2H-pyran in the presence of an acidic catalyst.

The proportion of the compounds (c) used in the present invention is from 3 to 50% by weight, preferably 5 to 35% by weight based on the entire weight of the light-sensitive composition (excluding a solvent).

### Alkali soluble resin [the component (a) of the composition of the present invention

Any alkali soluble resin conventionally used in this field can be used in the present invention as long as the resin is substantially water insoluble and soluble in an alkaline aqueous solution. Examples of the resin used in the present invention include a novolak resin, a hydrogenated novolak resin, an acetone-pyrogallol resin, polyhydroxystyrene, a halogen- or alkyl-substituted polyhydroxystyrene, a hydroxystyrene-N-substituted maleimide copolymer, a partially O-alkylated or O-acylated polyhydroxystyrene, a styrenemaleic acid anhydride copolymer, and a carboxyl group-containing methacrylate type resin, a derivative thereof, and the mixture thereof, but the present invention is not limited to these resins.

The particularly preferred alkali soluble resins are a novolak resin and polyhydroxystyrene. The novolak resin can be prepared by subjecting a prescribed monomer as a main component to addition condensation with aldehydes in the presence of an acid catalyst.

The following monomers can be used singly or in combination of two or more as the prescribed monomer: cresols such as phenol, m-cresol, p-cresol, and o-cresol; xylenols such as 2,5-xylenol, 3,5-xylenol, 3,4-xylenol, and 2,3-xylenol, alkylphenols such as methylphenol, p-ethylphenol, o-ethylphenol, p-t-butylphenol, p-octylphenol, and 2,3,5-trimethylphenol; alkoxyphenols such as p-methoxyphenol, m-methoxyphenol, 3,5-dimethoxyphenol, 2-methoxy-4-methylphenol, methoxyphenol, p-ethoxyphenol, m-propoxyphenol, p-propoxyphenol, m-butoxyphenol, and p-butoxyphenol; bisalkylphenols such as 2-methyl-4-isopropylphenol; and hydroxy aromatic compounds such as m-chlorophenol, p-chlorophenol, o-chlorophenol, dihydroxybiphenyl, bisphenol A, phenylphenol, resorcinol, and naphthol. The present invention, however,is not limited to the above monomers.

Examples of aldehydes, useful in the present invention include formaldehyde, paraformaldehyde, acetaldehyde, propionaldehyde, benzaldehyde, phenyl-acetaldehyde, α-phenylpropionaldehyde, β-phenylpropionaldehyde, o-hydroxybenzaldehyde, m-hydroxybenzaldehyde, p-hydroxybenzaldehyde, o-chlorobenzaldehyde, m-chlorobenzaldehyde, p-chlorobenzaldehyde, o-nitrobenzaldehyde, m-nitrobenzaldehyde, p-nitrobenzaldehyde, o-methylbenzaldehyde, m-methylbenzaldehyde, p-methylbenzaldehyde, p-ethylbenzaldehyde, p-n-butylbenzaldehyde, furfural, and chloracetaldehyde and an acetal compound thereof, for example, chloroacetaldehyde diethylacetal. Of those, formaldehyde is preferably used.

These aldehydes are used singly or in combination of two or more. Examples of the acid catalyst include hydrochloric acid, sulfuric acid, formic acid, acetic acid, and oxalic acid.

The weight-average molecular weight of the novolak resin thus obtained is preferably in the range of 1,000 to 30,000. A molecular weight less than 1,000 increases layer shrinkage in the unexposed portion after developing, and a molecular weight exceeding 30,000 decreases developing speed. A particularly preferred molecular weight is 2,000 to 20,000. The weight-average molecular weight is defined by the polystyrene-converted value of gel permeation chromatography.

These alkali soluble resins may be used as a mixture of two or more. The proportion of the alkali soluble resin used in the present invention is preferably 50 to 97% by weight, more preferably 60 to 90% by weight based on t:he entire weight of the light-sensitive composition (excluding solvent).

### The compound generating acid by active rays or radial rays [the component (b) of the composition of the present invention]

The component (b) is decomposed by active rays or radial rays such as UV, deep UV, X ray and electron rays to generate an acid. Specifically, component (b) of the compositions of the present invention is a sulfonium salt represented by Formula (PAG4): 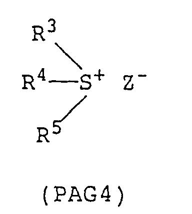 wherein
R³, R⁴ and R⁵ each represents a substituted or unsubstituted alkyl group or an aryl group. Preferred groups include an aryl group having 6 to 14 carbon atoms, an alkyl group having 1 to 8 carbon atoms, and a substituted derivative thereof. Preferred substituents include an alkoxy group having 1 to 8 carbon atoms, an alkyl group having 1 to 8 carbon atoms, a nitro group, a carboxyl group, a hydroxy group, and a halogen atom for the aryl group, and an alkoxy group having 1 to 8 carbon atoms, a carboxyl group, and an alkoxycarbonyl group having 1 to 8 carbon atoms group for the alkyl group.
Z⁻ represents a paired anion, for example, BF₄⁻, AsF₆⁻, PF₆⁻, SbF₆⁻, SiF₆⁻², and ClO₄⁻, a perfluoroalkanesulfonic acid anion such as CF₃SO₃⁻, and a pentafluorobenzenesulfonic acid anion, a condensed polynuclear aromatic sulfonic acid anion such as a naphthalene-l-sulfonic acid anion, an anthraquinonesulfonic acid anion, and a dye containing a sulfonic acid group, but the present invention is not limited thereto.

At least two of R³, R⁴ and R⁵ may be combined via a single bond or substituent thereof.

The following compounds are illustrate examples thereof,

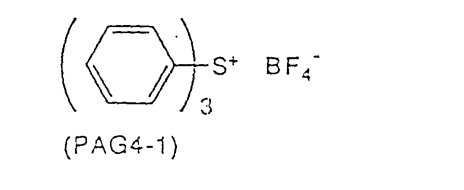

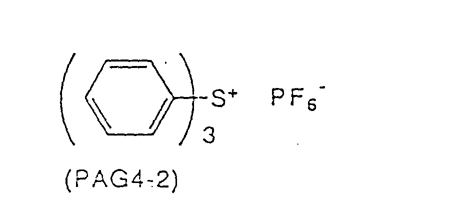

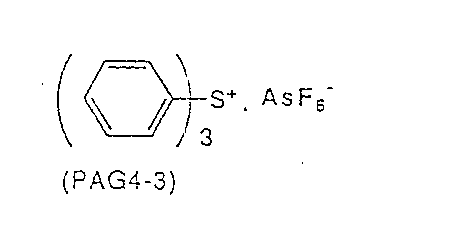

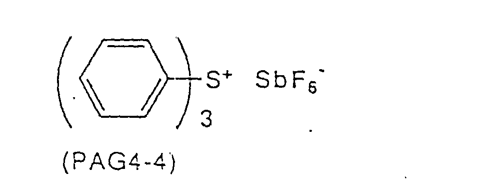

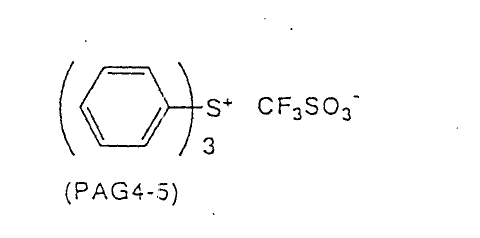

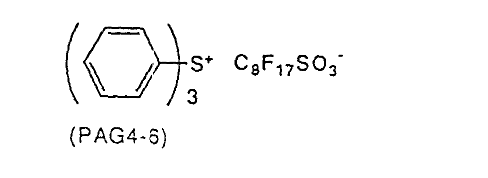

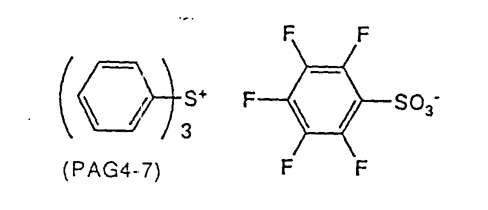

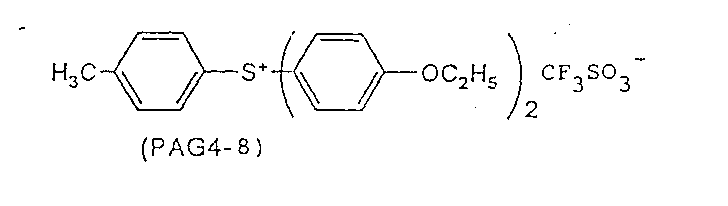

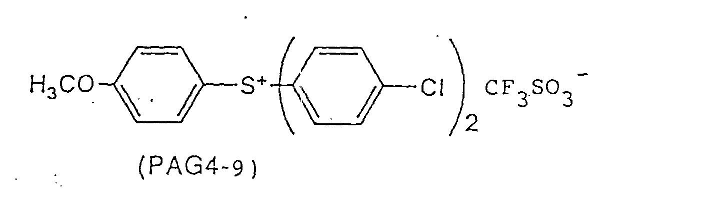

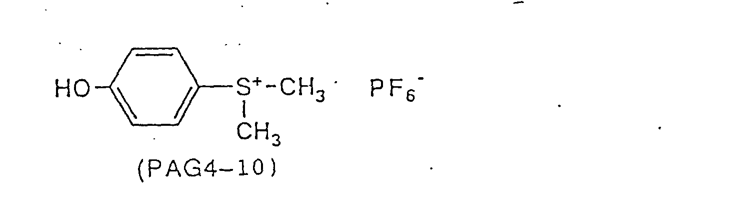

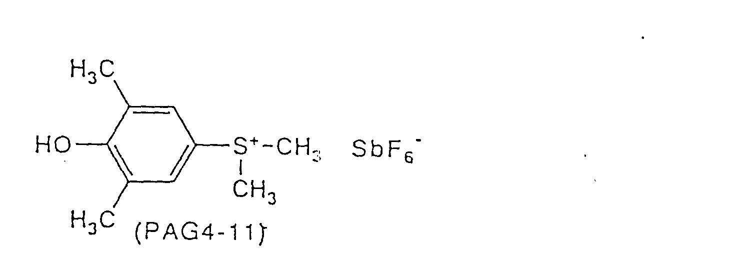

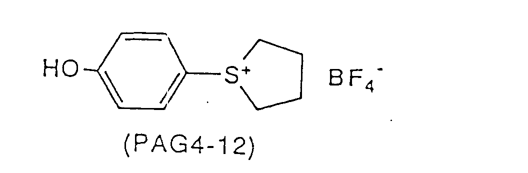

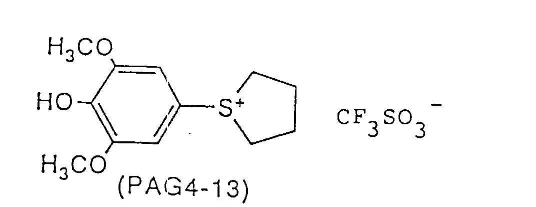

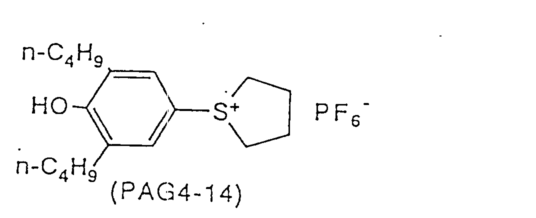

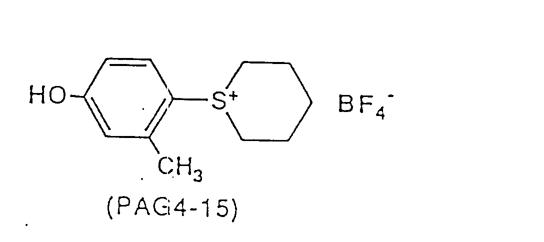

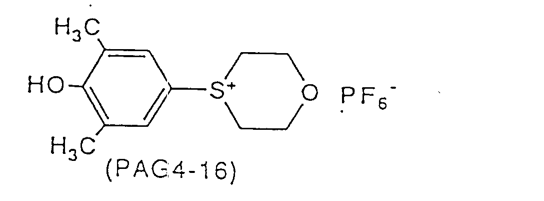

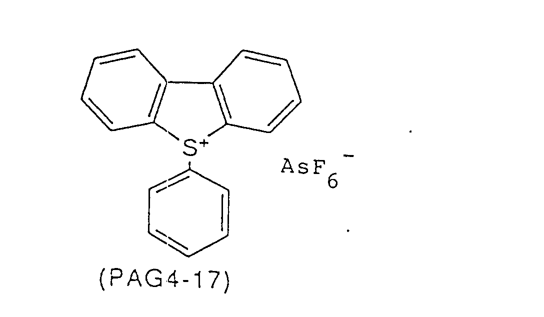

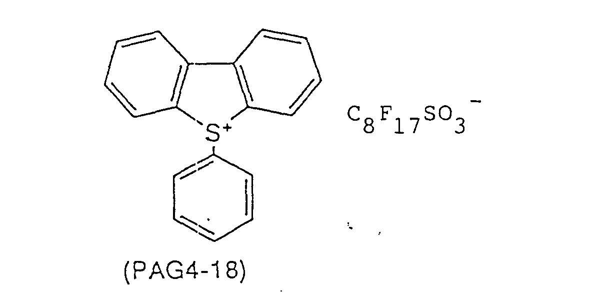

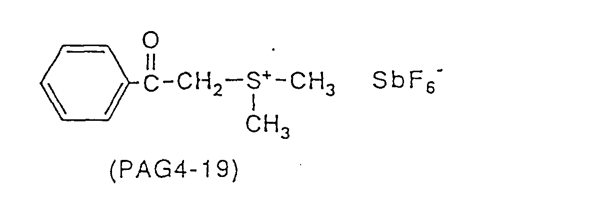

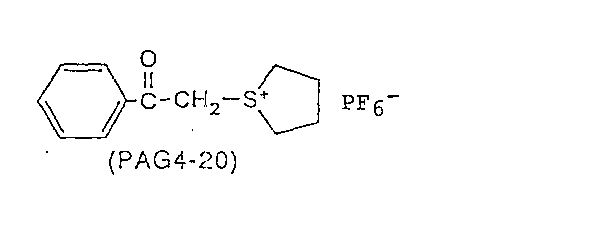

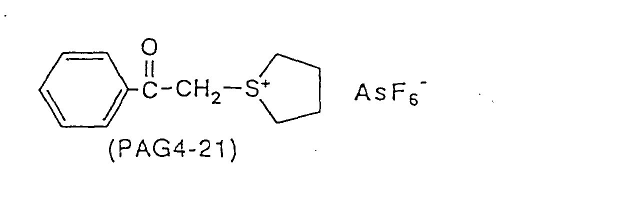

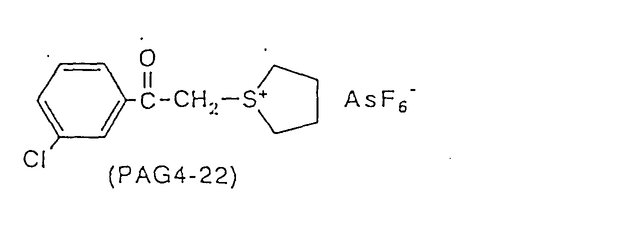

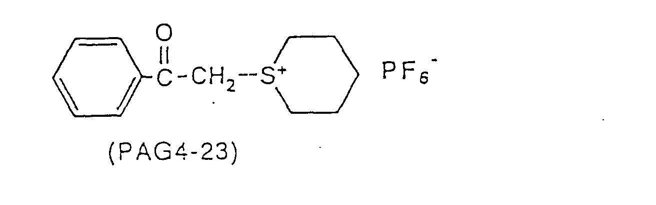

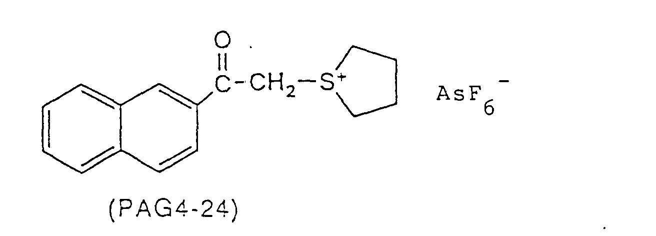

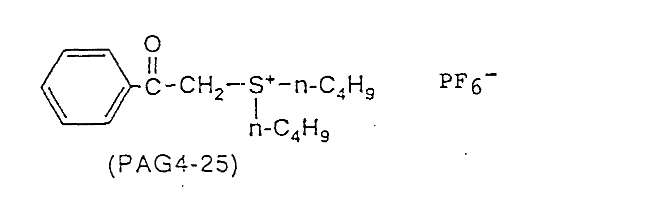

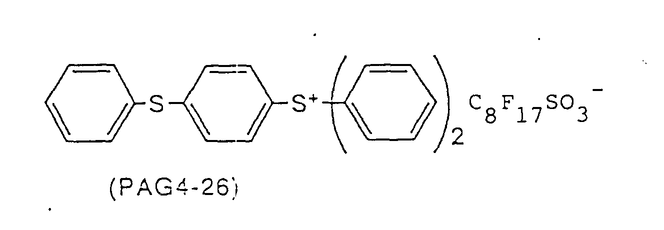

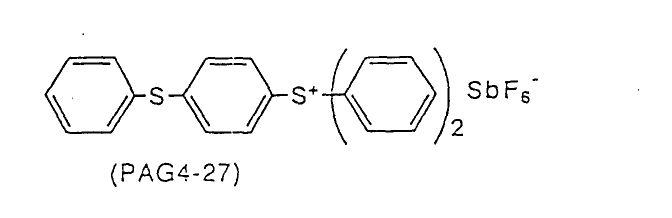

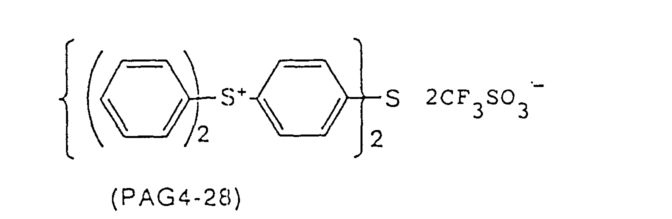

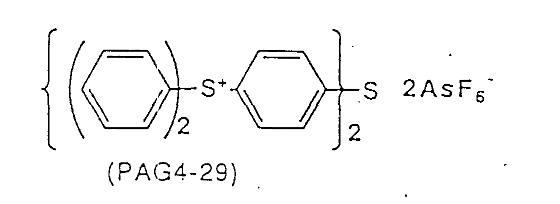

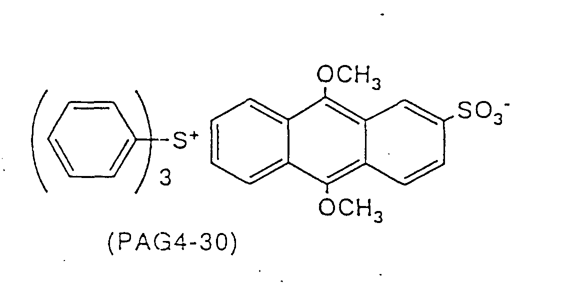

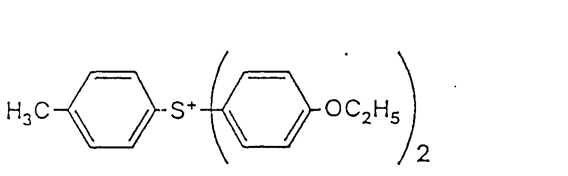

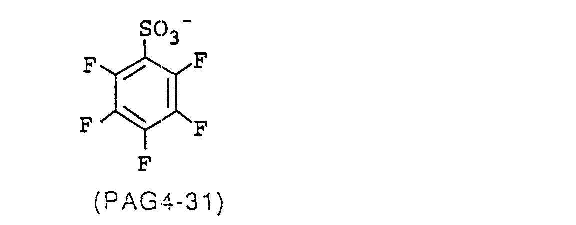

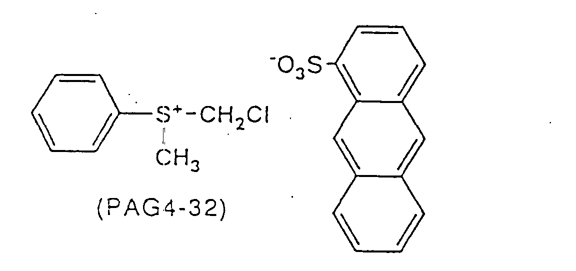

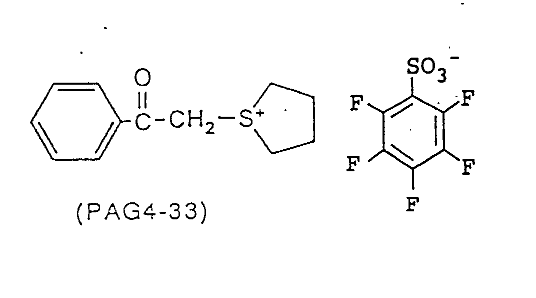

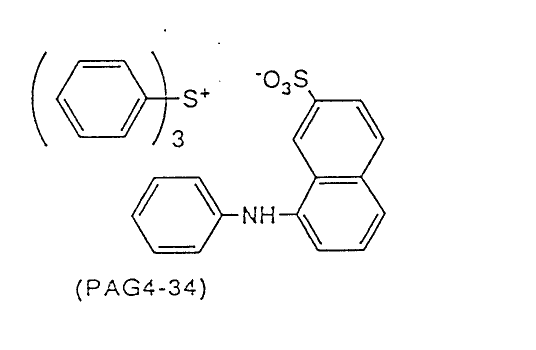

The above onium salts represented by Formula (PAG4) are publicly known and can be synthesized by the methods described in, for example, J. Am. Chem. Soc., by J.W. Knapczyk et al, 91, 145 (1969), J. Org. Chem., by A.L. Maycok et al, 35, 2532 (1970), Bull. Soc. Chem. Belg., by E. Goethas et al, 73, 546 (1964), J. Am. Chem. Soc., by H.M. Leicester, 51, 3587 (1929), J. Polym. Chem. Ed., by J.V. Ceivello et al, 18, 2677 (1980), US-A-2,807,648 and 4,247,473, and JP-A-53-101331 (US-A-4,151,175).

The amount of these compounds which are decomposed by active rays and radial rays to generate acids is usually in the range of 0.001 to 40% by weight, preferably 0.01 to 20% by weight, and more preferably 0.1 to 5% by weight based on the entire weight of the light-sensitive composition (excluding solvent).

The light-sensitive composition of the present invention can further contain a dye, a pigment, a plasticizer, a surface active agent, a photosensitizer, and a compound having two or more phenolic OH groups which accelerate solubility in a developing solution, if desired. The amount of these compounds is preferably not more than 30% by weight based on the entire weight of the light sensitive composition (excluding solvent).

An oily dye and a base dye are available as a preferred dye. Specific examples include Oil Yellow #101, Oil Yellow #103, Oil Pink #312, Oil Green BG, Oil Blue BOS, Oil Blue #603, Oil Black BY, Oil Black BS, Oil Black T-505 (the above are manufactured by Orient Chemical Ind. Co., Ltd.), Crystal Violet (CI42555), Methyl Violet (CI42535), Rhodamine B (CI45170B), Malachite Green (CI42000), and Methylene Blue (CI52015).

Further, the following spectral sensitizers can be added, and the light-sensitive composition of the present invention can be sensitized to a wavelength region longer than far ultraviolet in which a photo acid generating agent used has no absorption to provide the light-sensitive composition of the present invention with a sensitivity to i line (365 nm) or g line (436 nm).

Preferred spectral sensitizers include benzophenone, p,p'-tetraethylmethyldiaminobenzophenone, p,p'-tetraethylethylaminobenzophenone, 2-chlorothio-xanthone, anthrone, 9-ethoxyanthracene, anthracene, pyrene, perylene, phenothiazine, benzil, acridine orange, benzoflavin, Setoflavin-T, 9,10-diphenylanthracene, 9-fluorenone, acetophenone, phenathrene, 2-nitrofluorene, 5-nitroacenaphthene, benzoquinone, 2-chloro-4-nitro-aniline, N-acetyl-p-nitroaniline, p-nitroaniline, N-acetyl-4-nitro-1-naphthylamine, picramide, anthraquinone, 2-ethylanthraquinone, 2-tert-butylanthraquinone, 1,2-benzanthraquinone, 3-methyl-1,3-diaza-1,9-benzanthrone, dibenzalacetone, 1,2-naphthoquinone, 3,3'-carbonyl-bis-(5,7-dimethoxycarbonylcoumarin), and coronene, but the present invention is not limited thereto.

The light-sensitive composition of the present invention, which is dissolved in a solvent dissolving the above respective components, is coated on a support. Preferred as the solvent used herewith are ethylene dichloride, cyclohexanone, cyclopentanone, 2-heptanone, γ-butyrolactone, methyl ethyl ketone, ethylene glycol monomethyl ether, ethylene glycol monoethyl ether, 2-methoxyethyl acetate, ethylene glycol monoethyl ether acetate, propylene glycol monomethyl ether, propylene glycol monomethyl ether acetate, toluene, ethyl acetate, methyl lactate, ethyl lactate, methyl methoxypropionate, ethyl ethoxypropionate, methyl pyruvate, ethyl pyruvate, propyl pyruvate, N,N-dimethylformamide, dimethylsulfoxide, N-methylpyrrolidone, and tetrahydrofuran. These solvents are used singly or in combination.

A surface active agent can be added as well to the above solvents. Examples include nonionic type surface active agents including polyoxyethylene alkyl ethers such as polyoxyethylene lauryl ether, polyoxyethylene stearyl ether, polyoxyethylene cetyl ether, and polyoxyethylene oleyl ether, polyoxyethylene alkyl aryl ethers such as polyoxyethylene octylphenol ether and polyoxyethylene nonylphenol ether, polyoxyethylene/polyoxypropylene block copolymers, sorbitan fatty acid esters such as sorbitan monolaurate, sorbitan monopalmitate, sorbitan monostearate, sorbitan monooleate, sobitan trioleate, and sorbitan tristearate, and polyoxyethylene sorbitan fatty acid esters such as polyoxyethylene sorbitan monolaurate, polyoxyethylene sorbitan monopalmitate, polyoxyethylene sorbitan monostearate, polyoxyethylene sorbitan trioleate, and polyoxyethylene sorbitan tristearate; fluorine containing surface active agents such as F Top EF 301, EF 303 and EF 352 (manufactured by Shin Akita Kasei Co., Ltd.), Megafac® F 171 and F 173 (manufactured by Dainippon Ink Co., Ltd.), Florade® FC 430 and FC 431 (manufactured by Sumitomo Three M Co., Ltd.), Asahi Guard® AG 710, and Surfron S-382, SC-101, SC-102, SC-103, SC-104, SC-105, and SC-106 (manufactured by Asahi Glass Co., Ltd.); an organosiloxane polymer KP 341 (Shin-etsu Chemical Ind. Co., Ltd.); and an acrylic acid type or methacrylic acid type (co)polymer Polyflow® No. 75 and No. 95 (Kyoeisha Oil & Fat Chemical Co., Ltd.).

The amount of these surface active agents added is usually two parts by weight or less, preferably 1 part by weight or less per 100 parts by weight of the solid matters contained in the composition of the present invention.

These surface active agents may be added singly or in combination.

The above light--sensitive composition is coated on a substrate (for example, silicon coated with silicon dioxide) used for manufacturing a precision integrated circuit element by a suitable coating method such as a spinner and a coater and then is exposed through a mask, baked (usually, at 35 to 180°C, for about 5 minutes or less) and developed, whereby a superior resist pattern is obtained.

The developing solution used for the light-sensitive composition of the present invention, may be aqueous alkaline solutions of alkalis including inorganic alkalis such as sodium hydroxide, potassium hydroxide, sodium carbonate, sodium silicate, sodium metasilicate, and aqueous ammonia; primary amines such as ethylamine and n-propylamine; secondary amines such as diethylamine and di-n-butylamine; tertiary amines such as triethylamine and methyl diethylamine; alkanolamines such as dimethylethanolamine and triethanolamine; quaternary ammonium salts such as tetramethylammonium hydroxide and tetraethylammonium hydroxide; and cyclic amines such as pyrrole and piperidine. Usually, the concentration of these compounds is 10⁻⁵ N or higher, preferably 0.001 to 1 N and the developing temperature is 0 to 100°C, preferably 5 to 60°C.

Further, alcohols and surface active agents can also be added to the aqueous alkaline solutions in a suitable amount.

The present invention will be explained below in further detail by reference to examples, but the invention is not limited thereto.

### EXAMPLES

### Synthesis Example-1 of a dissolution inhibitor

α,α',α"-Tris(4-hydroxyphenyl)-1,3,5-triisopropylbenzene (commercially available; 20 g) was dissolved in tetrahydofuran (400 ml). Potassium tert-butoxide (14 g) was added to this solution under a nitrogen atmosphere, and the solution was stirred at room temperature for 10 minutes, followed by adding di-tert-butyldicarbonate (29.2 g). The reaction was carried out at room temperature for 3 hours, and the reaction liquid was poured into ice water to extract the product with ethyl acetate. The ethyl acetate phase was further washed with water and dried, followed by distilling off the solvent. After the crystalline solid material obtained was recrystalized (diethyl ether), it was dried, whereby the exemplified compound 31 (all of the Rs were -COOC(CH)₃ groups) (25.6 g) was obtained.

### Synthesis Example-2 of a dissolution inhibitor

α,α',α"-Tris(4-hydroxyphenyl)-1,3,5-triisopropylbenzene (20 g) was dissolved in diethyl ether (400 ml). Added were 3,4-dihydro-2H-pyran (31.6 g) and a catalytic amount of hydrochloric acid to this solution under a nitrogen atmosphere and the reaction was carried out for 24 hours under refluxing. After finishing the reaction, a small amount of sodium hydroxide was added, followed by filtering. The solvent was distilled off from the filtrate, and the product obtained was refined by column chromatography and dried, whereby the exemplified compound 31 all of the Rs were tetrahydropyranyl groups) (22.4 g) was obtained.

### Synthesis Example-3 of a dissolution inhibitor

There were added to an N,N-dimethylacetamide solution (120 ml) of α,α',α"-tris(4-hydroxyphenyl)-1,3,5-triisopropylbenzene (19.2 g) (0.040 mole), potassium carbonate (21.2 g) (0.15 mole) and further t-butyl bromoacetate (27.1 g) (0.14 mole), and the solution was stirred at 120°C for 7 hours. Thereafter, the reaction mixture was poured into water (1.5 ℓ) and extracted with ethyl acetate. After drying over magnesium sulfate, the extract was concentrated and refined by column chromatography (carrier: silica gel, developing solvent: ethyl acetate/n-hexane = 3/7 by volume ratio), whereby a pale yellow viscous solid material (30 g) was obtained. It was confirmed with NMR that this was the exemplified compound 31 (all of the Rs were -CH₂COOC₄H₉(t)groups).

### Synthesis Example-4 of a dissolution inhibitor

1-[α-Methyl-α-(4'-hydroxyphenyl)ethyl]-4-[α',α'-bis(4"-hydroxyphenyl)ethyl]benzene (commercially available; 42.4 g) (0.10 mole) was dissolved in N,N-dimethylacetamide (300 ml), and potassium carbonate (49.5 g) (0.35 mole) and cumyl bromoacetate (84.8 g) (0.33 mole) were added thereto. Thereafter, the solution was stirred at 120°C for 7 hours. The reaction mixture was poured into ion exchanged water (2 ℓ). After being neutralized with acetic acid, the solution was extracted with ethyl acetate. The ethyl acetate extract was concentrated and refined in the same manner as in Synthesis Example-3, whereby the exemplified compound 18 (all of the Rs were -CH₂COOC(CH₃)₂C₆H₅ groups) (70 g) was obtained.

### Synthesis Example-5 of an dissolution inhibitor

There were added to an N,N-dimethylacetamide solution (120 ml) of α,α',α',α",α"-hexakis(4-hydroxyphenyl)-1,3,5-triethylbenzene (can be prepared according on the similar method disclosed in J-A-55-162728; 14.3 g) (0.020 mole), potassium carbonate (21.2 g) (0.15 mole) and further t-butyl bromoacetate (27.1 g) (0.14 mole), and the solution was stirred at 120°C for 7 hours. Thereafter, the reaction mixture was poured into water (1.5 ℓ) and extracted with ethyl acetate. After drying over magnesium sulfate, the extract was concentrated and refined by column chromatography ( carrier: silica gel, developing solvent: ethyl acetate/n-hexane = 2/8 by volume ratio), whereby a pale yellow powder (24 g) was obtained. It was confirmed with NMR that this was the exemplified compound 62 (all of the Rs were -CH₂COO-C₄H₉(t) groups).

### Synthesis Example-6 of a dissolution inhibitor

α,α',α"-Tris(4-hydroxyphenyl)-1,3,5-triisopropylbenzene (20 g) (0.042 mole) was dissolved in tetrahydofuran (THF) (400 ml). Potassium tert-butoxide (9.3 g) (0.083 mole) was added to this solution under a nitrogen atmosphere and the solution was stirred at room temperature for 10 minutes, followed by adding di-tert-butyldicarbonate (19.5 g) (0.087 mole). The reaction was carried out at room temperature for 3 hours and the reaction solution was poured into ice water to extract the product with ethyl acetate.

The ethyl acetate extract was concentrated and refined by column chromatography (carrier: silica gel, developing solvent: ethyl acetate/n-hexane = 1/5 by volume ratio), whereby the exemplified compound 31 (two R's were -COOC(CH₃)₃ groups and one R was a hydrogen atom) (7 g) was obtained.

### Synthesis Example-7 of a dissolution inhibitor

α,α',α"-Tris(4-hydroxyphenyl)-1,3,5-triisopropylbenzene (48.1 g) (0.10 mole) was dissolved in dimethylacetamide (300 ml) and potassium carbonate (22.1 g) (0.16 mole) and t-butyl bromoacetate (42.9 g) (0.22 mole) were added thereto. Thereafter, the solution was stirred at 120°C for 5 hours. Then, the reaction mixture was poured into ion exchanged water (2 ℓ) and extracted with ethyl acetate after neutralizing with acetic acid.

The ethyl acetate extract was concentrated and refined with a column chromatography (carrier: silica gel, developing solvent: ethyl acetate/hexane = 1/5 by volume ratio), whereby the exemplified compound 31 (two R's were -CH₂COOC₄H₉(t) groups and one R was a hydrogen atom) (10 g) was obtained.

### Synthesis example of a novolak resin

m-Cresol (40 g), p-cresol (60 g), a 37% formalin aqueous solution (49 g) and oxalic acid (0.13 g) were introduced into a three neck flask, and the temperature was raised up to 100°C to carry out the reaction for 15 hours.

Thereafter, the temperature was raised to 200°C, and the pressure was reduced gradually to 6.7 mbar (5 mm Hg) to remove water, unreacted monomer, formaldehyde and oxalic acid. Subsequently, the resulting melted alkali soluble novolak resin (NOV. 3) was cooled down to room temperature for recovering. The novolak resin (NOV. 3) thus obtained had a weight-average molecular weight of 7100 (converted to polystyrene).

The following novolak resins in which the compositions were changed were synthesized in the same manner:
- NOV. 1:: m-cresol/p-cresol = 60/40 (weight ratio of reactants),
Mw = 12,000
- NOV. 2:: m-cresol/p-cresol = 50/50 ( " ),
Mw = 8,700
- NOV. 4:: m-cresol/p-cresol/3,5-xylenol
= 25/50/28 ( " ),
Mw = 5,200
- NOV. 5:: m-cresol/2,3,5-trimethylphenol = 55/57, ( " ),
Mw =5,800

The novolak resin (NOV. 3) obtained above (20g) was completely dissolved in methanol (60 g) and then water (30 g) was gradually added thereto while stirring to precipitate a resin.

An upper phase was removed by decantation to recover the precipitated resin, which was heated at 40°C to dry under a reduced pressure for 24 hours, whereby the alkali soluble resin (NOV. 6) was obtained. The weight-average molecular weight thereof was 8000 (converted to polystyrene).

m-Cresol (85 g), p-cresol (15 g) and a 37% formalin aqueous solution (53 g) were introduced into a three neck flask and the mixture was stirred well while heating on an oil bath at 110°C. Zinc acetate dihydrate (2.4 g) was added thereto to continue heating while stirring for 5 hours. Then, the same cresol mixture (100 g) and the formalin aqueous solution (47 g) were continuously introduced into the same flask. Further, after heating and stirring were continued for 1 hour, the temperature was lowered to 80°C to add oxalic acid (0.2 g). The reaction was continued once again for 15 hours in a refluxing condition while keeping the temperature of the oil bath at 110°C. Thereafter, the content was poured into water containing 1% hydrochloric acid, and the reaction product was extracted with ethylcellosolve acetate. Then, this was moved to a vacuum distiller, and t:he temperature was raised to 200°C to remove water. Further, distillation was continued for two hours under a reduced pressure of 2.7 to 4.0 mbar (2 to 3 mm Hg) to remove the residual monomer. The resulting melted polymer was recovered from the flask, whereby the desired novolak resin (NOV. 7, Mw = 7,500) was obtained.

### EXAMPLES 1 TO 14

The compounds shown in the above synthetic examples were used to prepare the resists. The prescriptions therefor are shown in Table 1.

### COMPARATIVE EXAMPLES 1 AND 2

A t-butoxycarbonyloxystyrene polymer and a t-butoxycarbonyloxy-α-methylstyrene polymer were synthesized according to the method described in US-A-4,491,628 to prepare the two component series positive type resists. The prescriptions therefor are shown in Table 1.

### COMPARATIVE EXAMPLES 3, 4 AND 5

The compounds described in EP-A-249,139, di-t-butyl terephthalate, 4-t-butoxy-p-biphenyl and t-butyl-2-naphthylcarbonate, were used as the dissolution inhibitor agent to prepare the three components series positive type resists. The prescriptions therefor are shown in Table 1.

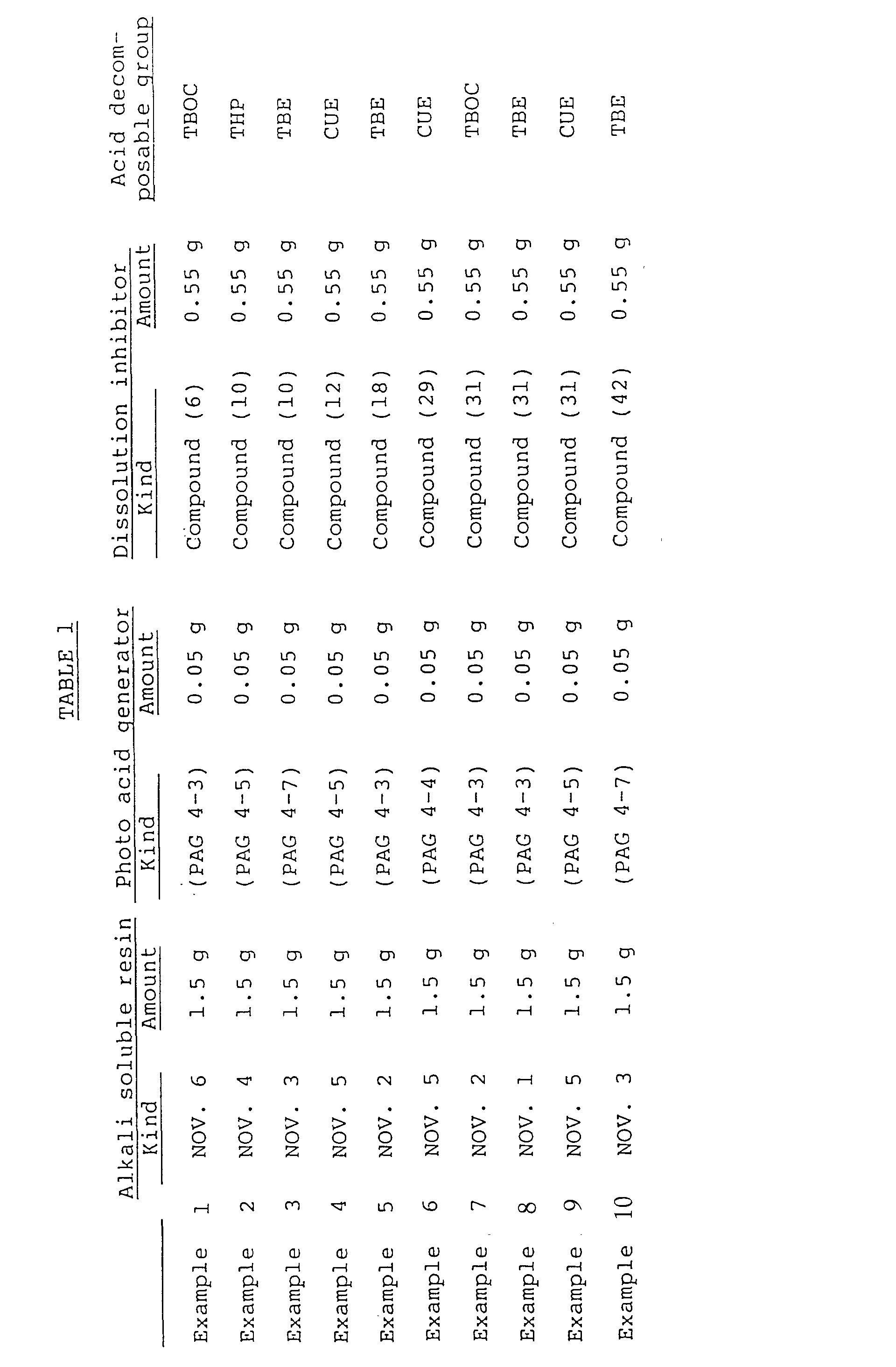

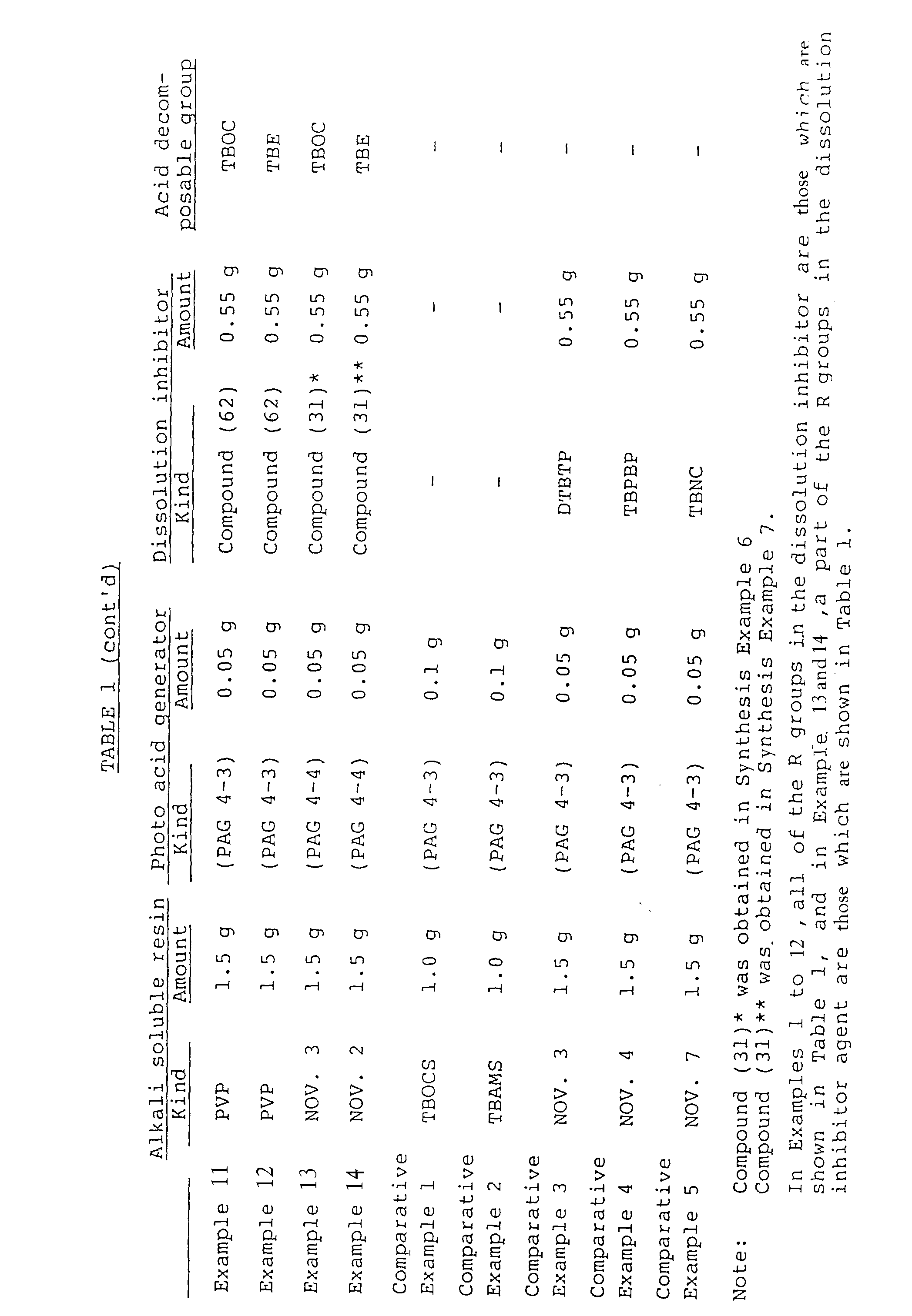

The codes used in Table 1 have the following definitions:

### Polymers

- NOV. 1 to 7:: novolak resins
- PVP:: p-hydroxystyrene polymer (number-average molecular weight: 9,600)
- TBOCS:: t-butoxycarbonyloxystyrene polymer (number-average molecular weight: 21,600)
- TBAMS:: t-butoxycarbonyloxy-α-methylstyrene polymer ( number-average molecular weight: 46,900)

### Dissolution inhibitor

- DTBTP:: di-t-butyl terephthalate
- TBPBP:: 4-t-butoxy-p-biphenyl
- TBNC:: t-butyl-2-naphthylcarbonate

### Acid Decomposable group

- TBOC:: -OCOOC₄H₉(t)
- TBE:: -OCH₂COOC₄H₉₍ₜ₎
- CUE:: -OCH₂COOC(CH₃)₂C₆H₅
- THP::

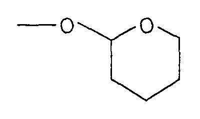

### Preparation and evaluation of the light-sensitive compositions

The respective materials shown in Table 1 were dissolved in diglyme (diethylene glycol dimethyl ether; 6 g), and the solutions were filtered with a filter of 0.2 µm to prepare the resist solutions. These resist solutions were coated on a silicon wafer with a spin coater at a revolution speed of 3000 rpm, followed by drying on a vacuum adsorption type hot plate at 110°C for 60 seconds, to thereby obtain a resist layer with a layer thickness of 1.0 µm.

This resist layer was subjected to an exposure with an eximer laser stepper of 248 nm KrF (NA = 0.42). After exposing, the resist layer was heated on the vacuum adsorption type hot plate at 90°C for 60 seconds and was immediately dipped in a 2.38% tetramethylammonium hydroxide (TMAH) aqueous solution at 23°C for 60 seconds, followed by rinsing with water for 30 seconds and drying. The patterns thus obtained on the silicon wafer were observed with a scanning type electron microscope to evaluate the profile of the resist. The results thereof are shown in Table 2.

Sensitivity was defined by the reciprocal of the exposure necessary for reproducing a mask pattern of 0.70 µm and expressed by a value relative to that of Comparative Example 1, which was set at 1.0.

Layer shrinkage was expressed in terms of the ratio of the layer thicknesses before and after exposing and baking.

Resolution represents a critical resolution in the exposure necessary for reproducing a mask pattern of 0.70 µm.

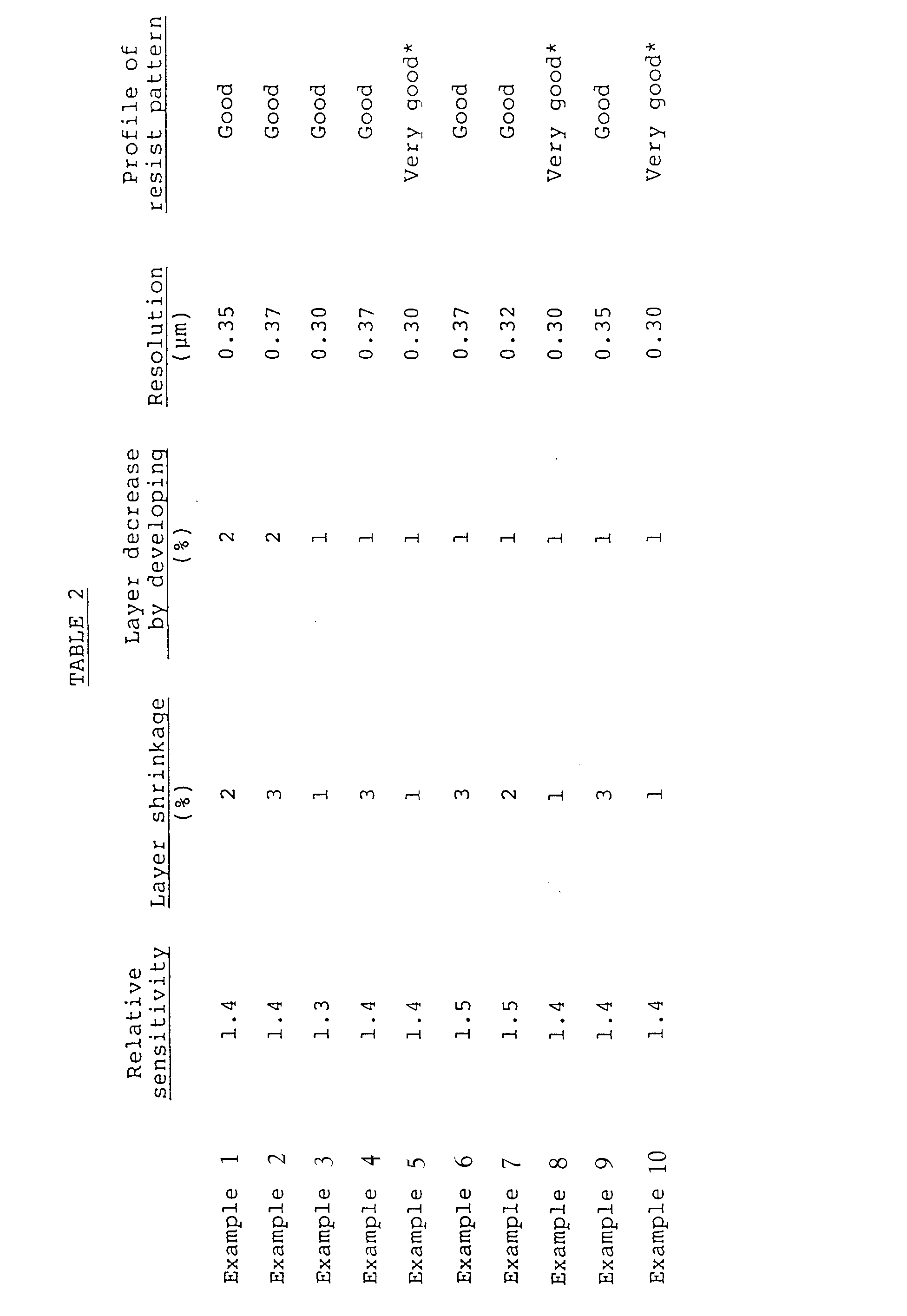

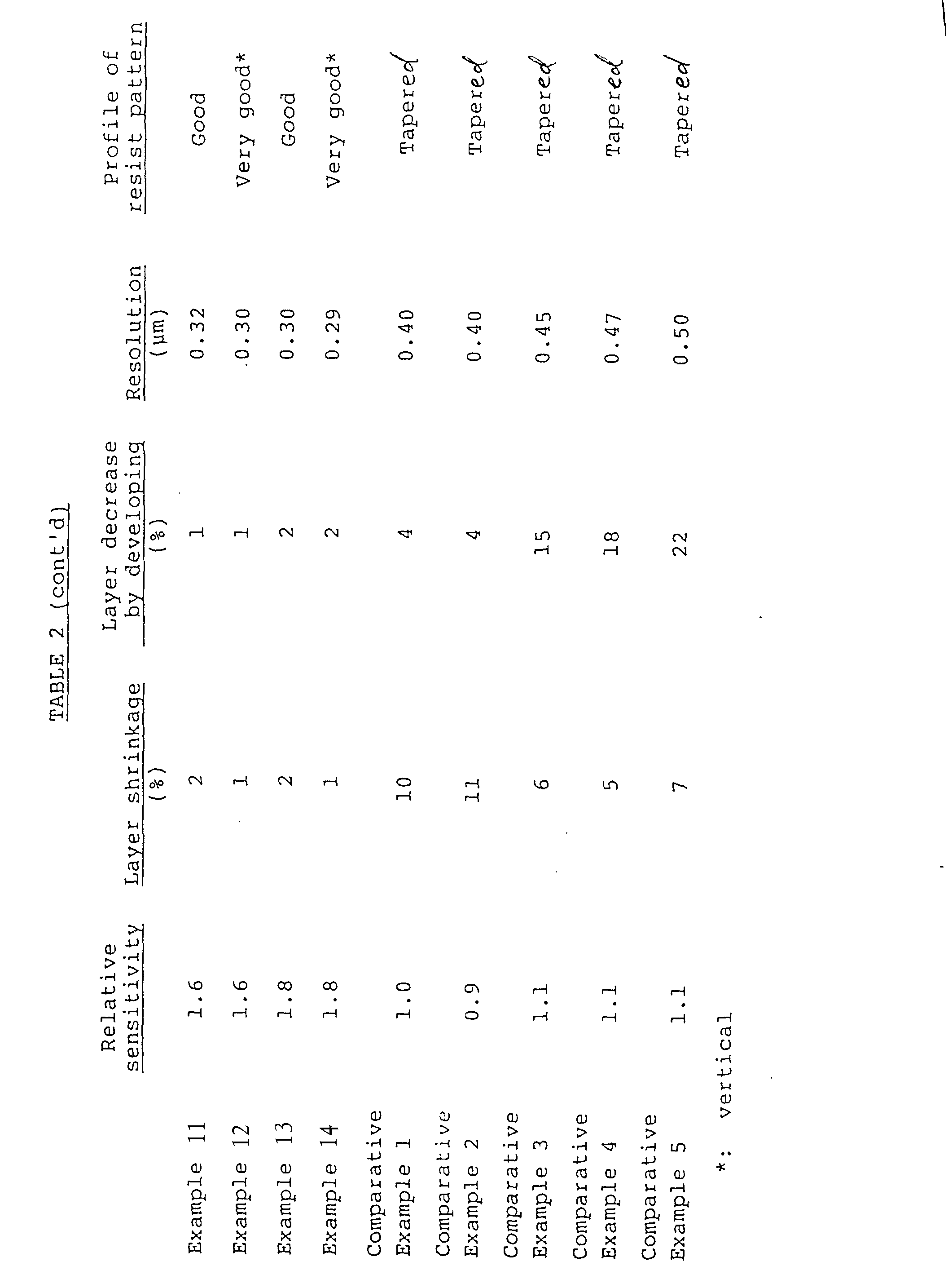

It can be seen from the results shown in Table 2 that the resists of the present invention have less layer shrinkage by baking after exposing and provide an excellent profile and high resolution.

## Claims

1. A positive type light-sensitive composition comprising:
(a) a resin which is insoluble in water and soluble in an alkaline aqueous solution,
(b) a compound which generates acid by irradiation with active rays or radial rays and is of general formula 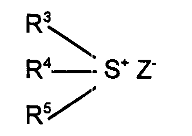 wherein R³, R⁴ and R⁵ each represents a substituted or unsubstituted alkyl group or an aryl group;
Z⁻ represents a paired anion; and
two of R³, R⁴ and R⁵ may be combined via a single bond or substituent thereof;
(c) an acid decomposable dissolution inhibitor, having a molecular weight of not more than 3000 and having groups decomposable by the action of the generated acid to increase the solubility of said compound in an alkaline developing solution, wherein said dissolution inhibitor (c) is at least one compound selected from
(i) compounds having two of said acid decomposable groups which are separated by 10 or more bonded atoms excluding the atoms constituting the acid decomposable groups, or
(ii) compounds having at least three of said acid decomposable groups, and two of said groups which are at the farthest positions are separated by 9 or more bonded atoms excluding the atoms constituting the acid decomposable groups,
wherein said acid decomposable group contains -COOA⁰ or -OB⁰, wherein A⁰ represents a -C(R⁰¹) (R⁰²) (R⁰³) or -C(R⁰⁴) (R⁰⁵)-OR⁰⁶ group; B° represents a A⁰ or -COO-A⁰ group; R⁰¹, R⁰², R⁰³, R⁰⁴ and R⁰⁵ each may be the same or different and each represents a hydrogen atom, an alkyl group, a cycfoalkyl group, an alkenyl group, or an aryl group, or substituted groups thereof and R⁰⁶ represents an alkyl group, an aryl group, or substituted groups thereof, provided that at least two of R⁰¹ to R⁰³ each are groups other than a hydrogen atom and provided that two of R⁰¹ to R⁰³ and R⁰⁴ to R⁰⁶ may be combined with each other to form a ring.

2. The positive type light-sensitive composition as in claim 1, wherein said acid decomposable group is -R°(̵COOA⁰)_{n'}(n'≥1) or -Ar-OB⁰, wherein R⁰ represents a di- or more valent aliphatic or aromatic hydrocarbon group which may have a substituent; and Ar represents a monocyclic or polycyclic, di- or more valent aromatic group which may have a substituent.

3. The positive type light-sensitive composition as in claim 2, wherein the substituent in the substituted group represented by R⁰, R⁰¹ to R⁰⁶ and Ar is at least one group selected from
a hydroxy group, a halogen atom, a nitro group, a cyano group, an alkyl group, an alkoxy group, an alkoxycarbonyl group, and aralkyl group, an aralkyloxy group; an acyl group, an acyloxy group, an alkenyl group, an alkenyloxy group, aryl group, an aryloxy group, and an arylcarbonyloxy group.

4. The positive type light-sensitive composition as in any of claims 1-3, wherein said acid decomposable dissolution inhibitor is at least one compound selected from the compounds represented by Formulas (I) to (XVI), wherein groups containing -COOA⁰ or -OB⁰ are positioned so that the number of the bonded atoms satisfies the definition (i) or (ii); 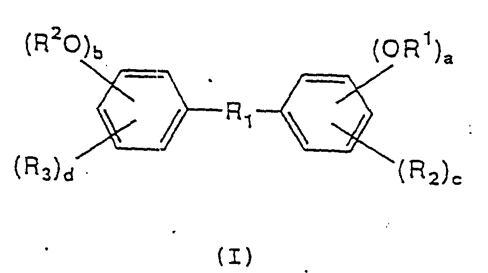 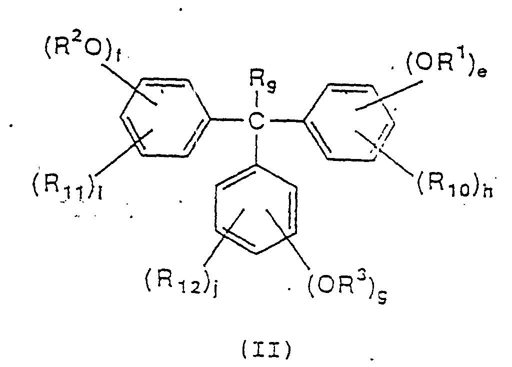 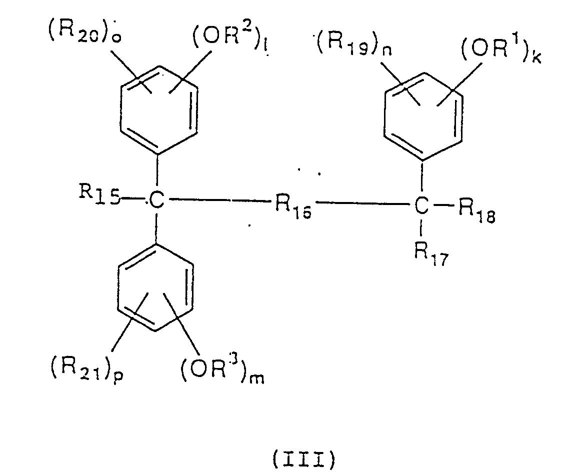 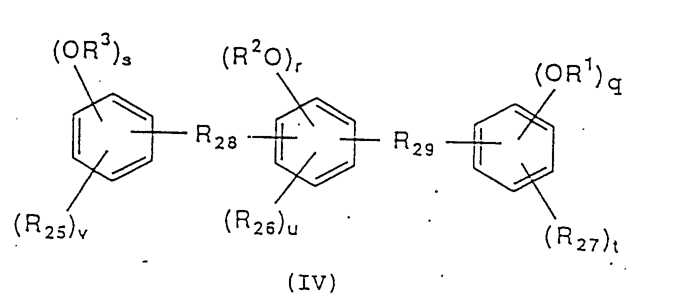 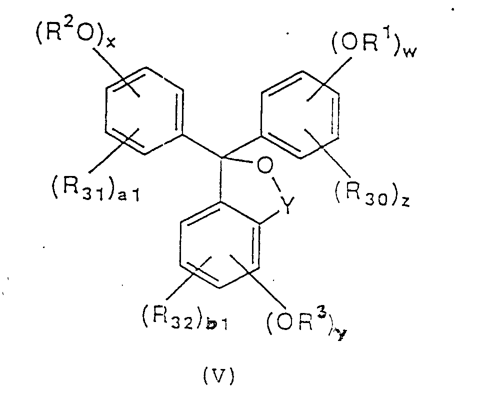 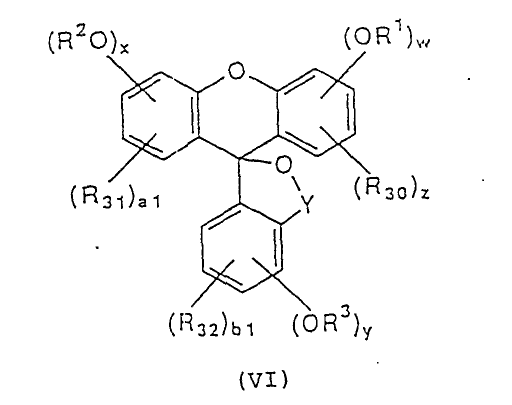 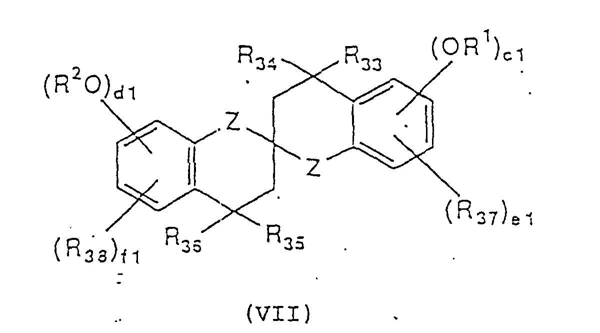 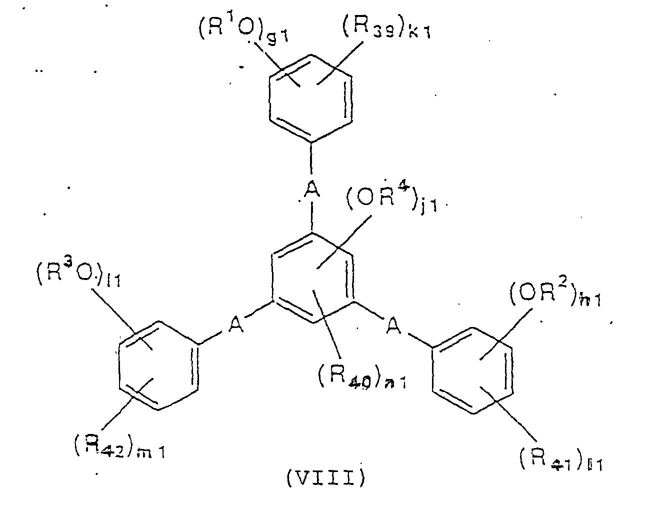 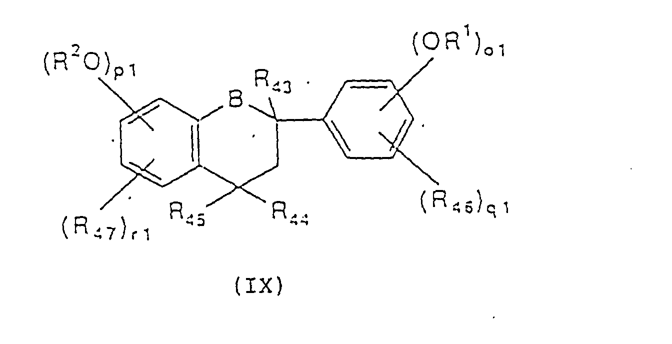 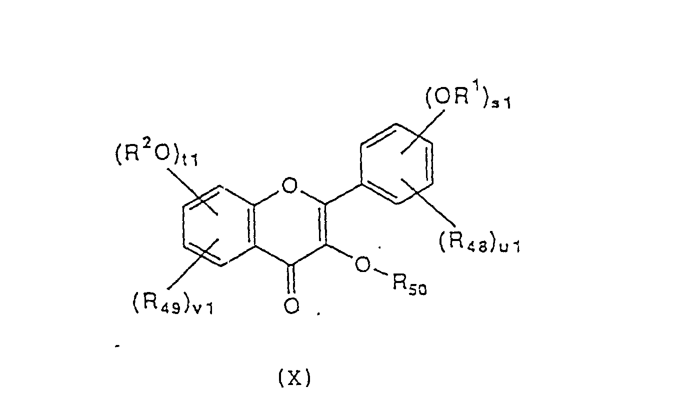 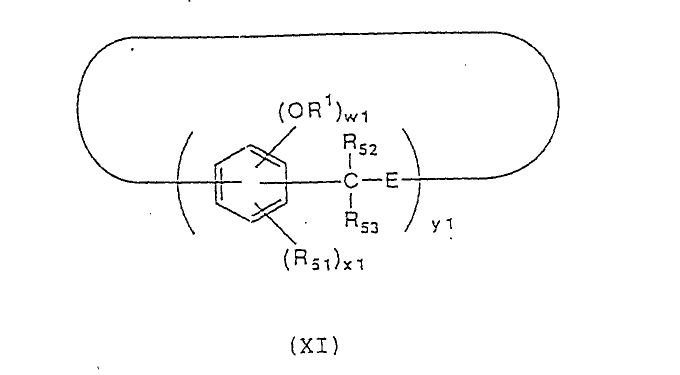 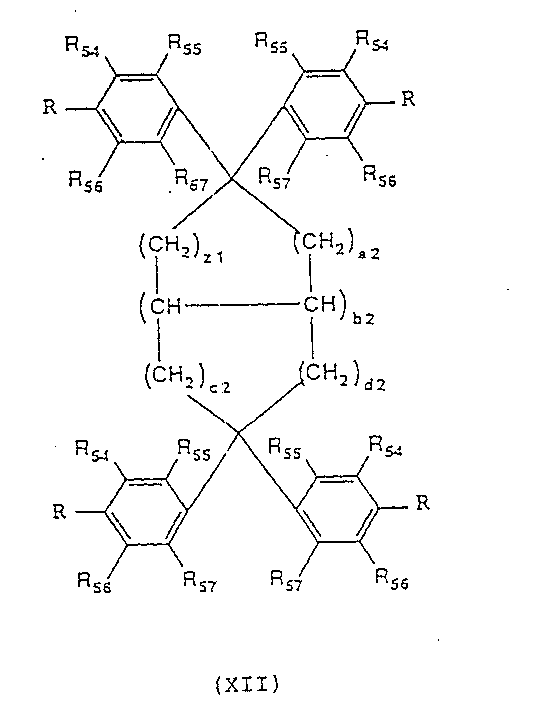 wherein R¹, R², R³, R⁴ are the same or different, and each represents a hydrogen atom, a -R⁰(COO-A⁰)_{n'} group or a B⁰ group, provided that at least two of the groups represented by R¹, R², R³ or R⁴ each represents -R⁰-COOA⁰ or -B⁰;
R₁ represents -CO-, -COO-, -NHCONH-, -NHCOO-,
-O-, -S-, -SO- , -SO₂-, -SO₃-, or 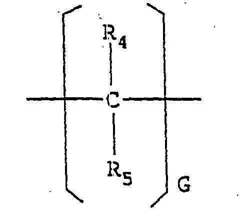 wherein G is 2 to 6, provided that when G is 2, at least one of R₄ and R₅ is an alkyl group;
R₄ and R₅ are the same or different, and each represents a hydrogen atom, an alkyl group, an alkoxy group, -OH, -COOH, -CN, a halogen atom, -R₆-COOR₇, or -R₈-OH;
R₆ and R₈ each represents an alkylene group;
R₇ represents a hydrogen atom, an alkyl group, an aryl group, or an aralkyl group;
R₂, R₃, R₉ to R₁₂, R₁₅, R₁₇ to R₂₁, R₂₅ to R₂₇, R₃₀ to R₃₂, R₃₇ to R₄₂, R₄₆ to R₄₉, and R₅₁ are the same or different, and each represents a hydrogen atom, a hydroxy group, an alkyl group, an alkoxy group, an acyl group, an acyloxy group, an aryl group, an aryloxy group, an aralkyl group, an aralkyloxy group, a halogen atom, a nitro group, a carboxyl group, a cyano group, or -N(R₁₃)(R₁₄) where R₁₃ and R₁₄ each represents an alkyl group and an aryl group;
R₁₆ represents a single bond, an alkylene group or 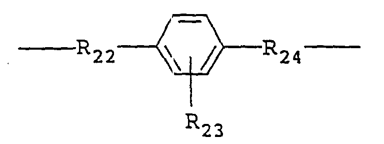
wherein R₂₂ and R₂₄ are the same or different, and each represents a single bond, an alkylene group, -O-, -S-, -CO-, or a carboxyl group; and
R₂₃ represents a hydrogen atom, an alkyl group, an alkoxy group, an acyl group, an acyloxy group, an aryl group, a nitro group, a hydroxy group, a cyano group, a carboxyl group, -OR⁰(̵COOA⁰)_{n'}, or -OB⁰;
R₂₈ and R₂₉ are the same or different, and each represents a methylene group, a lower alkyl-substituted methylene group, a halomethylene group, or a an alkoxymethylene group;
R₃₃ to R₃₆ are the same or different, and each represents a hydrogen atom or an alkyl group;
R₄₃ to R₄₅ are the same or different, and each represents a hydrogen atom, an alkyl group, an alkoxy group, an acyl group, or an acyloxy group;
R₅₀ represents a hydrogen atom, -R⁰(̵COOA⁰)_{n'}- or -B⁰, or 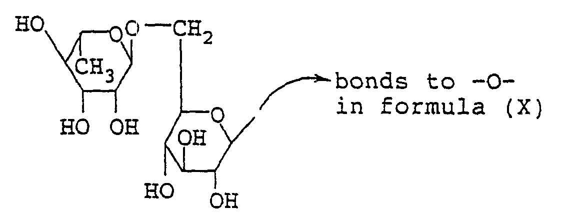
R₅₂ to R₅₃ are the same or different, and each represents a hydrogen atom, a lower alkyl group, a lower haloalkyl group, or an aryl group;
R₅₄ to R₅₇ are the same or different, and each represents a hydrogen atom, a hydroxy group, a halogen atom, a nitro group, a cyano group, a carbonyl group, an alkyl group, an alkoxy group, an alkoxycarbonyl group, an aralkyl group, an aralkyloxy group, an acyl group, an acyloxy group, an alkenyl group, an alkenyloxy group, an aryl group, an aryloxy group, or an aryloxycarbonyl group;
R represents -O-R⁰(̵COOA⁰)_{n'}, -O-B⁰ or a hydroxy group provided that at least two of the R groups each represents -O-R⁰(̵COOA⁰)_{n'} or -O-B⁰ and that groups represented by the same symbol may be not the same group;
Y represents -CO- or -SO₂-;
Z and B each represents a single bond or -O-;
A represents a methylene group, a lower alkyl-substituted methylene group, a halomethylene group, or an alkoxymethylene group;
E represents a single bond or an oxymethylene group;
when subscripts a to z and a1 to y1 are plural, the groups in parenthesis may be the same or different;
a to q, s, t, v, gl to il, kl to ml, ol, ql, sl, and ul each represents 0 or an integer of 1 to 5;
r, u, w, x, y, z, al to fl, pl, rl, tl, and vl to xl each represents 0 or an integer of 1 to 4;
jl, nl, zl, a2, b2, c2, and d2 each represents 0 or an integer of 1 to 3, provided that at least one of zl, a2, b2, c2, and d2 is 1 or more;
yl represents an integer of 3 to 8;
wherein (a+b), (e+f+g), (k+ℓ+m), (q+r+s), (w+x+y), (cl+dl), (gl+hl+il+jl), (ol+pl), and (sl+tl)≧2;
(jl+nl)≦3;
(r+u), (w+z), (x+al), (y+bl), (cl+el), (dl+fl), (pl+rl), (tl+vl), (xl+wl)≦4, but in formula (V), (w+z) and(x+al)≦5; and
(a+c), (b+d), (e+h), (f+i), (g+j), (k+n), (l+o), (m+p), (q+t), (s+v), (gl+kl), (hl+ll), (il+ml), (ol+ql), and (sl+ul)≦5; 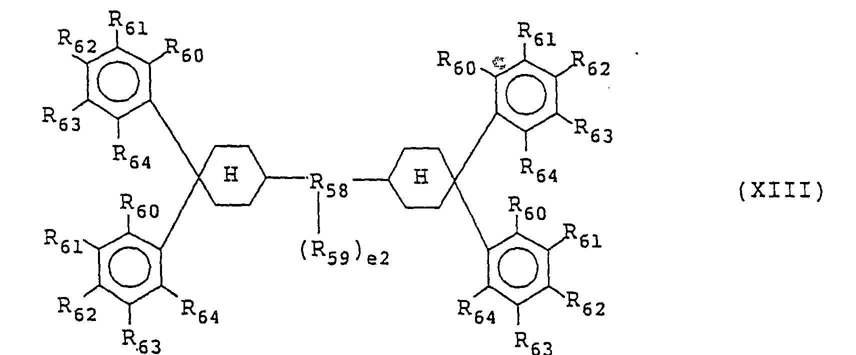
wherein R₅₈ represents an alkylene group, an alkenylene group, an arylene group, a single bond, -S-, -SO-, or -(O=)S(=O)-;
R₅₉ represents a hydrogen atom, a hydroxy group, a halogen atom, a nitro group, a cyano group, an alkyl group, an alkoxy group, an alkoxycarbonyl groups, an aralkyl group, an aralkyloxy group, an acyl group, an acyloxy group, an alkenyl group, an alkenyloxy group, an aryl group, an aryloxy group, an aryloxycarbonyl group, or 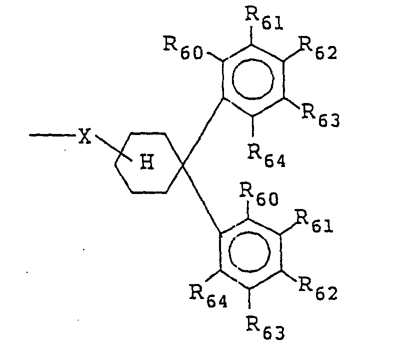
wherein R₆₀ to R₆₄ are the same or different and each represents a hydrogen atom, a hydroxy group, a halogen atom, an alkyl group, an alkoxy group, an alkenyl group, -O-R⁰(̵COO-A⁰)_{n'} or -O-B⁰, provided that at least two of R₆₀ to R₆₄ (each of said at least two groups may be positioned at any of the benzene rings in formula (XIII)) each represents -O-R⁰(̵COO-A⁰)_{n'} or -O-B⁰; groups represented by the same symbols may be the same or different;
X represents a substituted or unsubstituted alkylene or arylene group; and
e2 represents 0 or 1; 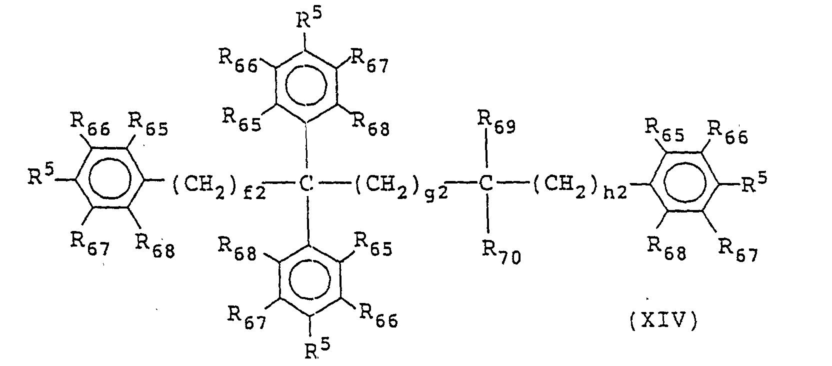
wherein R₆₅ to R₆₈ are the same or different, and each represents a hydrogen atom, a hydroxy group, a halogen atom, an alkyl group, an alkoxy group, or an alkenyl group;
R₆₉ to R₇₀ represents a hydrogen atom, an alkyl group, or 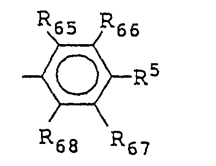
R⁵ represents a hydroxy group, a -O-R⁰(̵COO-A⁰)_{n'} group or a -O-B⁰ group; and at least two of the R⁵ groups each represents -O-R⁰(̵COO-A⁰)_{n'} or -O-B⁰;
f2 and h2 each represents 0 or 1;
g2 represents 0 or an integer of l to 4; and
the groups having the same symbols may be the same or different; 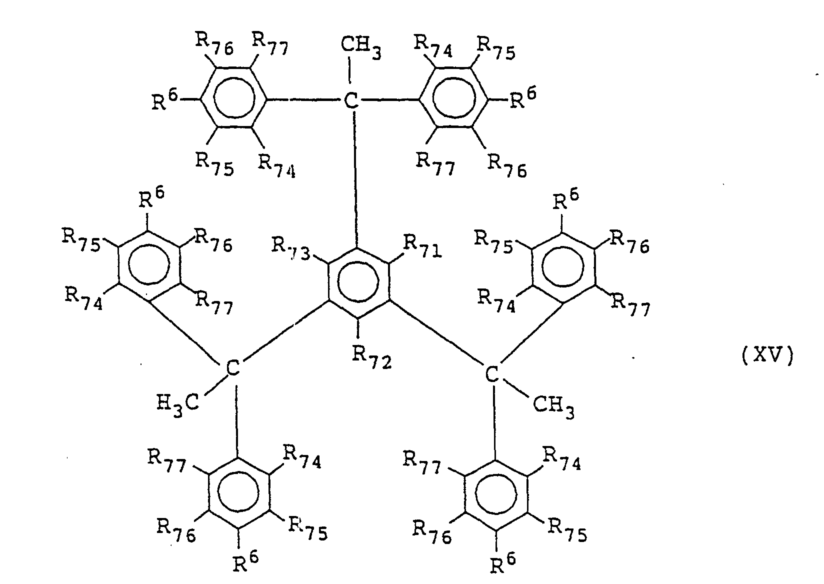
wherein R₇₁ to R₇₇ are the same or different, and each represents a hydrogen atom, a hydroxy group, a halogen atom, an alkyl group, an alkoxy group, a nitro group, an alkenyl group, an aryl group, an aralkyl group, an alkoxycarbonyl group, an aryloxycarbonyl group, an acyloxy group, an acyl group, an aralkyloxy group, or an aryloxy group; and
R⁶ represents a hydroxyl group, a -O-R⁰(̵COO-A⁰)_{n'} group or a -O-B⁰ group, and at least two of R⁶ groups each represents a -O-R⁰(̵COO-A⁰)_{n,} group or -O-B⁰ group; 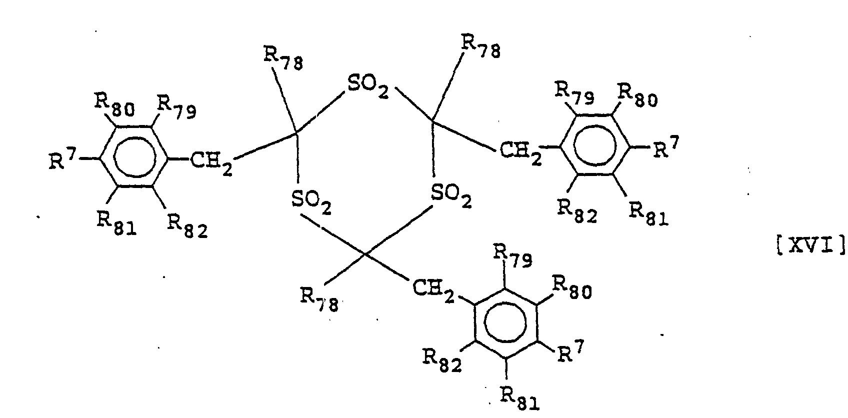
wherein R₇₈ represents a hydrogen atom or an alkyl group;
R₇₉ to R₈₂ represents a hydroxy group, a hydrogen atom, a halogen atom, an alkyl group, or an alkoxy group;
R⁷ represents a hydroxyl group, a -O-R⁰(̵COO-A⁰)ₙ' group or a -O-B⁰ group, at least two of the R⁷ groups each represents a -O-R⁰(̵COO-A⁰)ₙ' group or a -O-B⁰ group; and
the groups having the same symbols may be the same or different.

5. The positive type light-sensitive composition as in any of claims 1-3, wherein said acid decomposable dissolution inhitibor is at least one compound selected from the compounds represented by Formulas (53) to (55) and (57): 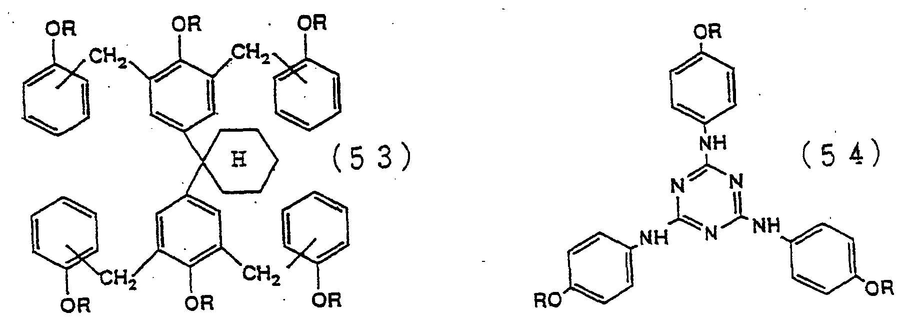 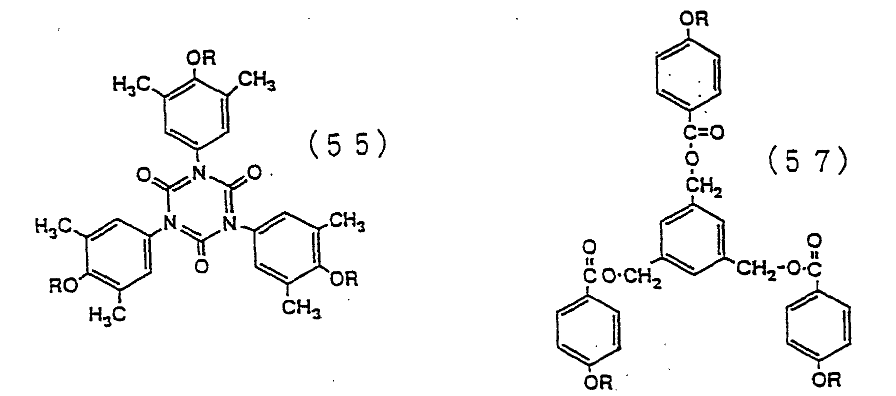 wherein R, which may be the same or different, represents a hydrogen atom or a group containing -COOA⁰ or -OB⁰ as defined in claim 1, provided that at least two or at least three (depending on the number of bonded atoms therebetween) of the R groups are groups other than a hydrogen atom, and that they are positioned so that the definition (i) or (ii) for the number of the bonded atoms between the acid decomposable groups as defined in claim 1 is satisfied.

6. The positive type light-sensitive composition as in claim 5, wherein radical R in the compounds represented by Formulas (53) to (55) and (57) is the same or different and represents

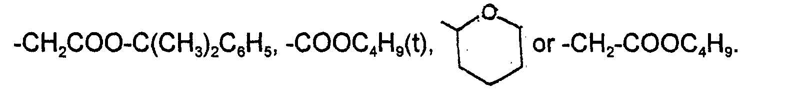

7. The positive type light-sensitive composition as in any of claims 1-6, wherein the proportion of the acid decomposable dissolution inhibitor is from 3 to 50% by weight based on the entire weight of the light-sensitive composition (excluding a solvent).

8. The positive type light-sensitive type composition as in any of claims 1-7, wherein said resin is at least one resin selected from a novolak resin, a hydrogenated novolak resin, an acetone-pyrogallol resin, polyhydroxystyrene, a halogen- or alkyl-substituted polyhydroxystyrene, a hydroxystyrene-N-substituted maleimide copolymer, a partially o-alkylated or o-acylated polyhydroxystyrene, a styrenemaleic acid anhydride copolymer, and a carboxyl group-containing methacrylate type resin, and a derivative thereof.

9. The positive type light-sensitive composition as in any of claims 1-8, wherein the proportion of the resin is 50 to 97% by weight based on the entire weight of the light-sensitive composition (excluding a solvent).

10. The positive type light-sensitive composition as in any of claims 1-9, wherein the amount of said acid generating compound is 0.001 to 40% by weight based on the entire weight of the light-sensitive composition (excluding solvent).

## Patentansprüche

1. Positive lichtempfindliche Zusammensetzung, umfassend:
(a) ein Harz, das in Wasser unlöslich und in einer alkalischen wäßrigen Lösung löslich ist,
(b) eine Verbindung, die bei Bestrahlung mit wirksamen Strahlen oder wirksamer Strahlung Säure erzeugt und die allgemeine Formel 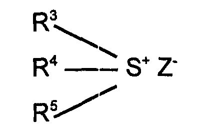 aufweist, worin R³, R⁴ und R⁵ jeweils eine substituierte oder unsubstituierte Alkylgruppe oder eine Arylgruppe darstellen,
Z⁻ ein gepaartes Anion darstellt, und
zwei von R³, R⁴ und R⁵ über eine Einfachbindung oder einen Substituenten davon verbunden sein können,
(c) einen Säure-zersetzbaren Auflösungsinhibitor mit einem Molekulargewicht von nicht mehr als 3.000, der Gruppen aufweist, die durch Einwirkung der erzeugten Säure zersetzbar sind, um die Löslichkeit der Verbindung in einer alkalischen Entwicklungslösung zu erhöhen, wobei der Auflösungsinhibitor (c) mindestens eine Verbindung ist, die ausgewählt ist aus
(i) Verbindungen mit zwei der genannten Säure-zersetzbaren Gruppen, die durch 10 oder mehr verbundene Atome, ausgenommen die die Säure-zersetzbaren Gruppen bildenden Atome, getrennt sind, oder
(ii) Verbindungen mit mindestens drei der genannten Säure-zersetzbaren Gruppen, wobei zwei der Gruppen, die am weitesten entfernt sind, durch 9 oder mehr verbundene Atome, ausgenommen die die Säure-zersetzbaren Gruppen bildenden Atome, getrennt sind,
wobei die Säure-zersetzbare Gruppe -COOA⁰ oder -OB⁰ enthält, worin A⁰ eine Gruppe -C(R⁰¹)(R⁰²)(R⁰³) oder -C(R⁰⁴)(R⁰⁵)-OR⁰⁶ ist, B⁰ eine Gruppe A⁰ oder -COO-A⁰ ist, R⁰¹, R⁰², R⁰³, R⁰⁴ und R⁰⁵ jeweils gleich oder verschieden sein können und jeweils ein Wasserstoffatom, eine Alkylgruppe, eine Cycloalkylgruppe, eine Alkenylgruppe oder eine Arylgruppe oder substituierte Gruppen davon sind und R⁰⁶ eine Alkylgruppe, eine Arylgruppe oder substituierte Gruppen davon ist, mit der Maßgabe, daß mindestens zwei von R⁰¹ bis R⁰³ jeweils von einem Wasserstoffatom verschiedene Gruppen sind, und mit der Maßgabe, daß zwei von R⁰¹ bis R⁰³ und R⁰⁴ bis R⁰⁶ miteinander unter Bildung eines Rings verbunden sein können.

2. Positive lichtempfindliche Zusammensetzung wie in Anspruch 1, worin die Säure-zersetzbare Gruppe -R⁰-(-COOA⁰)ₙ, (n' ≥ 1) oder -Ar-OB⁰ ist, worin R⁰ eine zwei- oder mehrwertige aliphatische oder aromatische Kohlenwasserstoffgruppe ist, die einen Substituenten aufweisen kann, und Ar eine monocyclische oder polycyclische zwei- oder mehrwertige aromatische Gruppe ist, die einen Substituenten aufweisen kann.

3. Positive lichtempfindliche Zusammensetzung wie in Anspruch 2, worin der Substituent in der durch R⁰, R⁰¹ bis R⁰⁶ und Ar dargestellten substituierten Gruppe mindestens eine Gruppe ist, die ausgewählt ist aus
einer Hydroxygruppe, einem Halogenatom, einer Nitrogruppe, einer Cyanogruppe, einer Alkylgruppe, einer Alkoxygruppe, einer Alkoxycarbonylgruppe und einer Aralkylgruppe, einer Aralkyloxygruppe, einer Acylgruppe, einer Acyloxygruppe, einer Alkenylgruppe, einer Alkenyloxygruppe, einer Arylgruppe, einer Aryloxygruppe und einer Arylcarbonyloxygruppe.

4. Positive lichtempfindliche Zusammensetzung wie in irgendeinem der Ansprüche 1 bis 3, worin der Säure-zersetzbare Auflösungsinhibitor mindestens eine Verbindung ist, die aus den durch die Formeln (I) bis (XVI) dargestellten Verbindungen ausgewählt ist, worin Gruppen, die -COOA⁰ oder -OB⁰ enthalten, derart angeordnet sind, daß die Anzahl der verbundenen Atome die Definition (i) oder (ii) erfüllt: 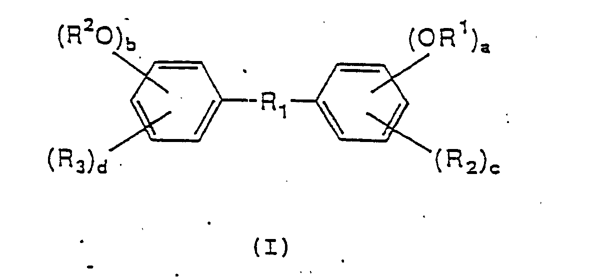 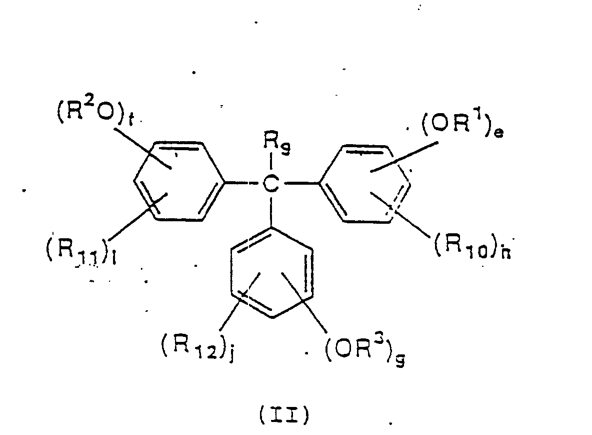 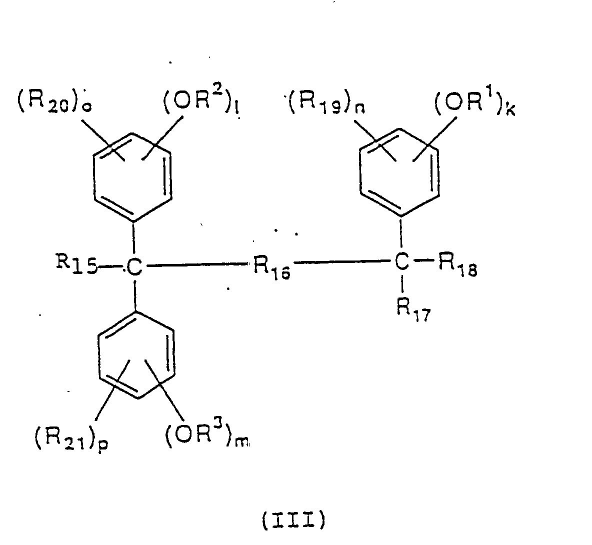 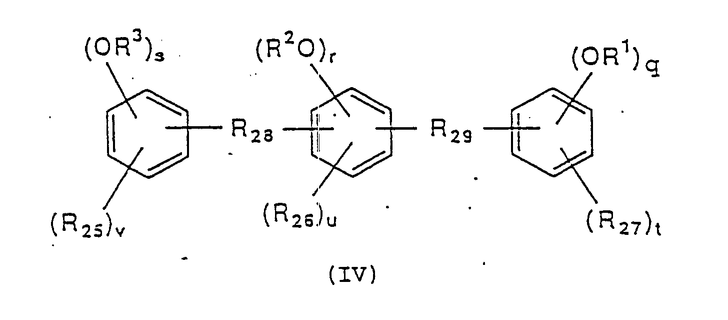 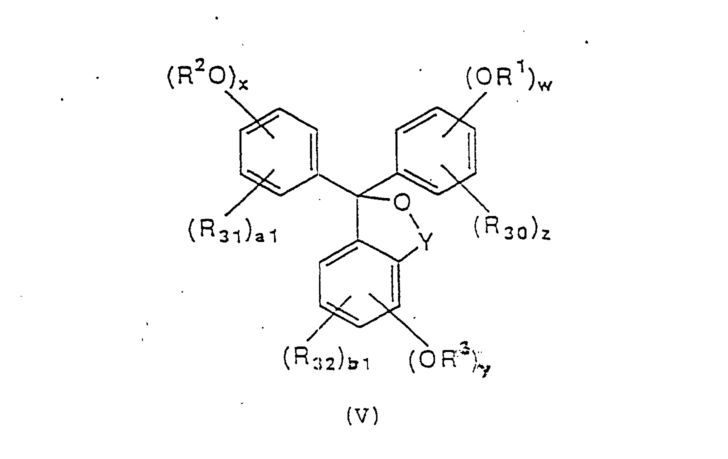 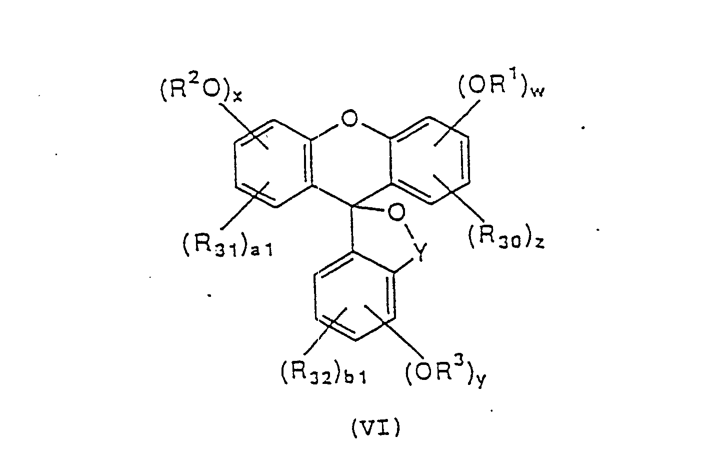 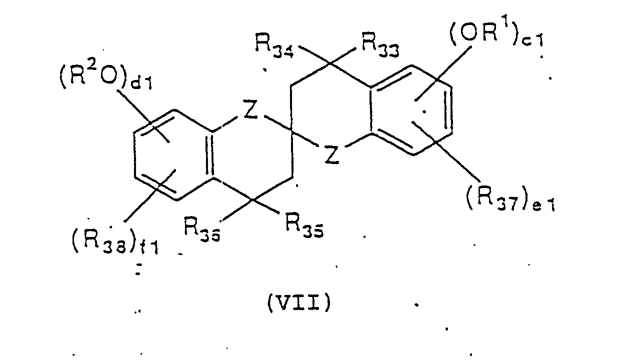 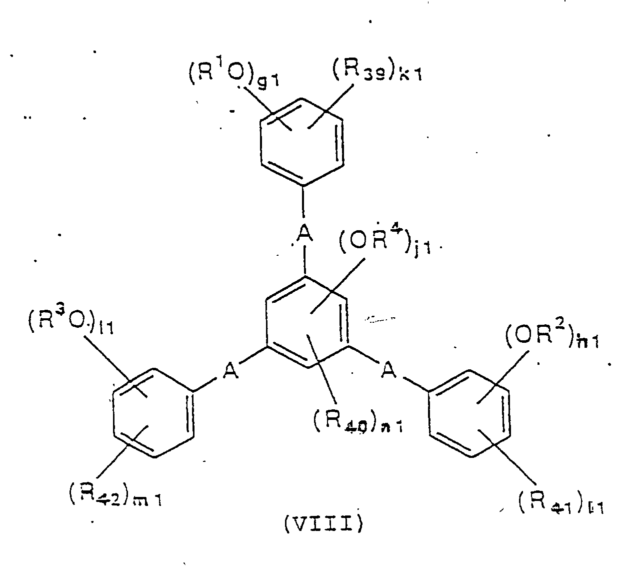 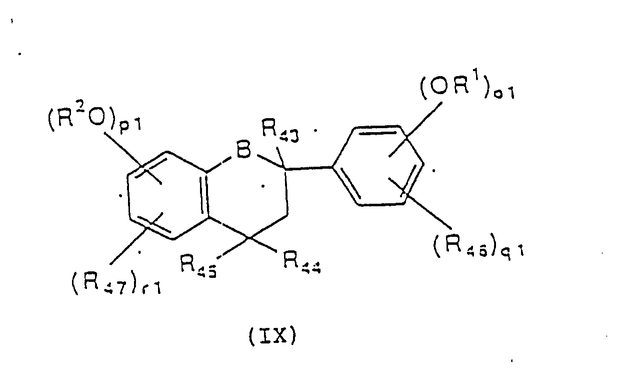 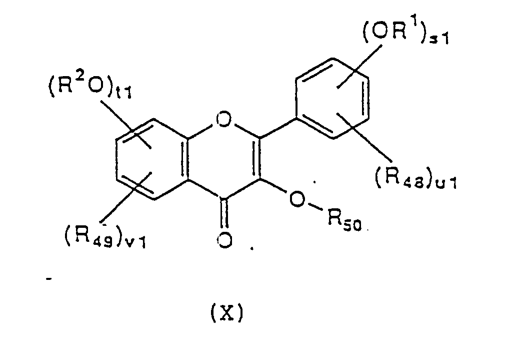 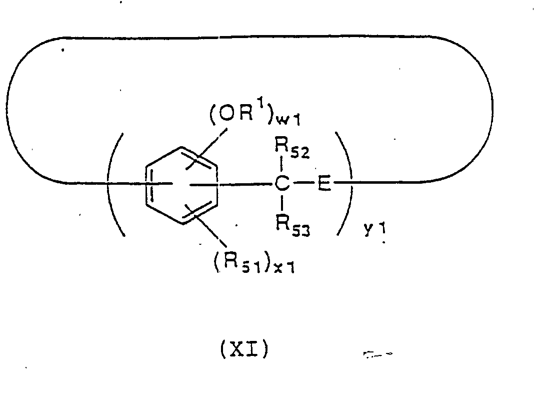 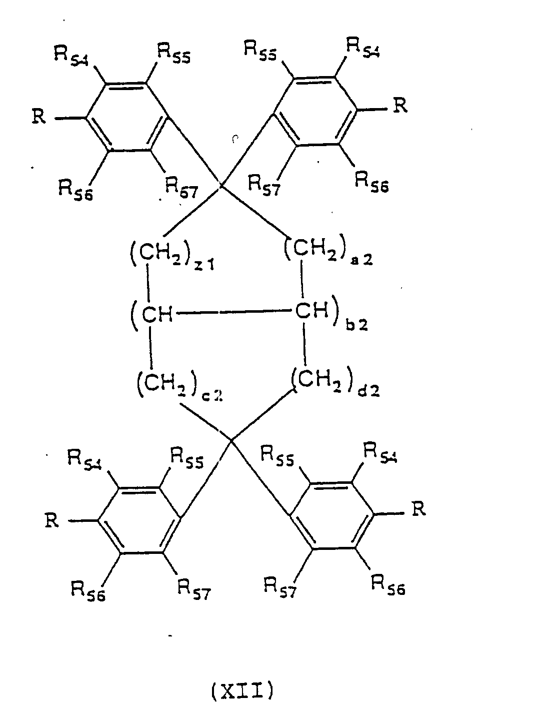 worin R¹, R², R³, R⁴ gleich oder verschieden sind und jeweils ein Wasserstoffatom, eine -R⁰(COO-A⁰)ₙ,-Gruppe oder eine B⁰-Gruppe sind, mit der Maßgabe, daß mindestens zwei der durch R¹, R², R³ oder R⁴ dargestellten Gruppen jeweils -R⁰-COOA⁰ oder -B⁰ sind,
R₁ -CO-, -COO-, -NHCONH-, -NHCOO-, -O-, -S-, -SO-, -SO₂-, -SO₃- oder 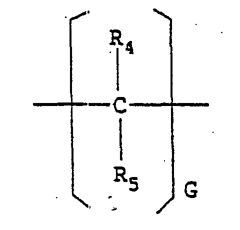 ist, worin G 2 bis 6 ist, mit der Maßgabe, daß, wenn G 2 ist, mindestens einer von R₄ und R₅ eine Alkylgruppe ist,
R₄ und R₅ gleich oder verschieden sind und jeweils ein Wasserstoffatom, eine Alkylgruppe, eine Alkoxygruppe, -OH, -COOH, -CN, ein Halogenatom, -R₆-COOR₇ oder -R₈-OH sind,
R₆ und R₈ jeweils eine Alkylengruppe sind,
R₇ ein Wasserstoffatom, eine Alkylgruppe, eine Arylgruppe oder eine Aralkylgruppe ist,
R₂, R₃, R₉ bis R₁₂, R_{15'} R₁₇ bis R₂₁, R₂₅ bis R₂₇, R₃₀ bis R₃₂, R₃₇ bis R₄₂, R₄₆ bis R₄₉ und R₅₁ gleich oder verschieden sind und jeweils ein Wasserstoffatom, eine Hydroxygruppe, eine Alkylgruppe, Alkoxygruppe, Acylgruppe, Acyloxygruppe, Arylgruppe, Aryloxygruppe, Aralkylgruppe, Aralkyloxygruppe, ein Halogenatom, eine Nitrogruppe, eine Carboxylgruppe, eine Cyanogruppe oder -N(R₁₃)(R₁₄) darstellen, worin R₁₃ und R₁₄ jeweils eine Alkylgruppe und eine Arylgruppe darstellen,
R₁₆ eine Einfachbindung, eine Alkylengruppe oder 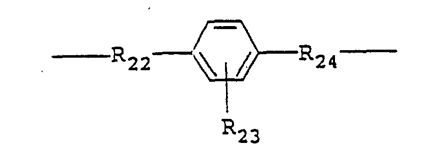 ist, worin R₂₂ und R₂₄ gleich oder verschieden sind und jeweils eine Einfachbindung, eine Alkylengruppe, -O-, -S-, -CO- oder eine Carboxylgruppe sind, und
R₂₃ ein Wasserstoffatom, eine Alkylgruppe, Alkoxygruppe, Acylgruppe, Acyloxygruppe, Arylgruppe, Nitrogruppe, Hydroxygruppe, Cyanogruppe, Carboxylgruppe, -OR⁰-(-COOA⁰)_{n'} oder -OB⁰ ist,
R₂₈ und R₂₉ gleich oder verschieden sind und jeweils eine Methylengruppe, eine Niederalkyl-substituierte Methylengruppe, eine Halogenmethylengruppe oder eine Alkoxymethylengruppe sind,
R₃₃ bis R₃₆ gleich oder verschieden sind und jeweils ein Wasserstoffatom oder eine Alkylgruppe darstellen,
R₄₃ bis R₄₅ gleich oder verschieden sind und jeweils ein Wasserstoffatom, eine Alkylgruppe, eine Alkoxygruppe, eine Acylgruppe oder eine Acyloxygruppe darstellen,
R₅₀ ein Wasserstoffatom, -R⁰-(-COOA⁰)_{n'} oder -B⁰ oder 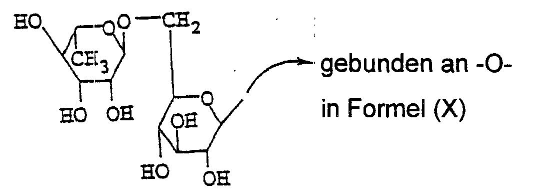 ist,
R₅₂ bis R₅₃ gleich oder verschieden sind und jeweils ein Wasserstoffatom, eine Niederalkylgruppe, eine niedere Halogenalkylgruppe oder eine Arylgruppe sind,
R₅₄ bis R₅₇ gleich oder verschieden sind und jeweils ein Wasserstoffatom, eine Hydroxygruppe, ein Halogenatom, eine Nitrogruppe, Cyanogruppe, Carbonylgruppe, Alkylgruppe, Alkoxygruppe, Alkoxycarbonylgruppe, Aralkylgruppe, Aralkyloxygruppe, Acylgruppe, Acyloxygruppe, Alkenylgruppe, Alkenyloxygruppe, Arylgruppe, Aryloxygruppe oder eine Aryloxycarbonylgruppe sind,
R -O-R⁰-(-COOA⁰)_{n'}, -O-B⁰ oder eine Hydroxygruppe ist, mit der Maßgabe, daß mindestens zwei der R-Gruppen jeweils -O-R⁰-(-COOA⁰)ₙ, oder -O-B⁰ sind, und durch das gleiche Symbol dargestellte Gruppen nicht die gleiche Gruppe zu sein brauchen,
Y -CO- oder -SO₂- ist,
Z und B jeweils eine Einfachbindung oder -O- sind,
A eine Methylengruppe, eine Niederalkyl-substituierte Methylengruppe, eine Halogenmethylengruppe oder eine Alkoxymethylengruppe ist,
E eine Einfachbindung oder eine Oxymethylengruppe ist,
wenn die tiefgestellten Indices a bis z und a1 bis y1 eine Mehrzahl sind, die Gruppen in Klammern gleich oder verschieden sein können,
a bis q, s, t, v, g1 bis i1, k1 bis m1, o1, q1, s1 und u1 jeweils 0 oder eine ganze Zahl von 1 bis 5 sind,
r, u, w, x, y, z, a1 bis f1, p1, r1, t1 und v1 bis x1 jeweils 0 oder eine ganze Zahl von 1 bis 4 sind,
j1, n1, z1, a2, b2, c2 und d2 jeweils 0 oder eine ganze Zahl von 1 bis 3 sind, mit der Maßgabe, daß mindestens eine von z1, a2, b2, c2 und d2 1 oder mehr ist,
y1 eine ganze Zahl von 3 bis 8 ist,
worin (a+b), (e+f+9), (k+ℓ+m), (q+r+s), (w+x+y), (c1+d1), (g1+h1+i1+j1), (o1+p1) und (s1+t1) ≥ 2 sind,
(j1+n1) ≤ 3 ist,
(r+u), (w+z), (x+a1), (y+b1), (c1+e1), (d1+f1), (P1+r1), (t1+v1), (x1+w1) ≤ 4, aber in Formel (V) (w+z) und (x+a1) ≤ 5 sind, und
(a+c), (b+d), (e+h), (f+i), (g+j), (k+n), (l+o), (m+p), (q+t), (s+v), (g1+k1), (h1+l1), (i1+m1), (o1+q1) und (s1+u1) ≤ 5 sind, 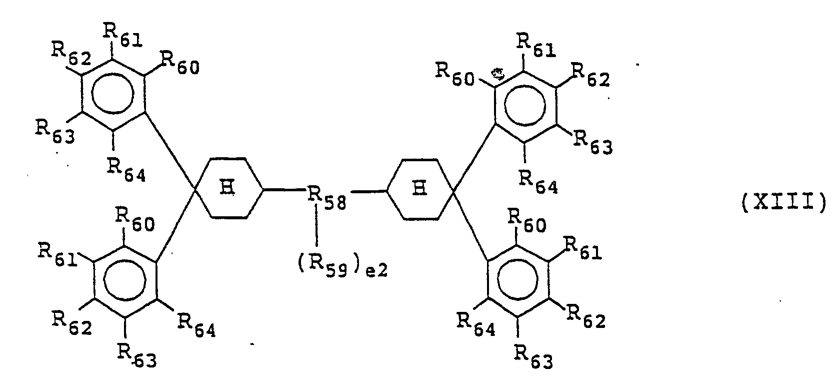
worin R₅₈ eine Alkylengruppe, eine Alkenylengruppe, eine Arylengruppe, eine Einfachbindung, -S-, -SO- oder -(O=)S(=O)- ist,
R₅₉ ein Wasserstoffatom, eine Hydroxygruppe, ein Halogenatom, eine Nitrogruppe, eine Cyanogruppe, eine Alkylgruppe, eine Alkoxygruppe, eine Alkoxycarbonylgruppe, eine Aralkylgruppe, eine Aralkyloxygruppe, eine Acylgruppe, eine Acyloxygruppe, eine Alkenylgruppe, eine Alkenyloxygruppe, eine Arylgruppe, eine Aryloxygruppe, eine Aryloxycarbonylgruppe, oder 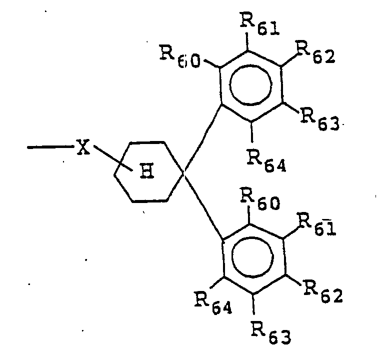
ist, worin R₆₀ bis R₆₄ gleich oder verschieden sind und jeweils ein Wasserstoffatom, eine Hydroxygruppe, ein Halogenatom, eine Alkylgruppe, eine Alkoxygruppe, eine Alkenylgruppe, -O-R⁰-(-COO-A⁰)_{n'} oder -O-B⁰ sind, mit der Maßgabe, daß mindestens zwei von R₆₀ bis R₆₄ (jede der genannten mindestens zwei Gruppen kann an jedem der Benzolringe in Formel (XIII) angeordnet sein) jeweils -O-R⁰-(-COO-A⁰)_{n'} oder -O-B⁰ sind, wobei durch die gleichen Symbole dargestellte Gruppen gleich oder verschieden sein können,
X eine substituierte oder unsubstituierte Alkylen- oder Arylengruppe ist, und e2 0 oder 1 ist, 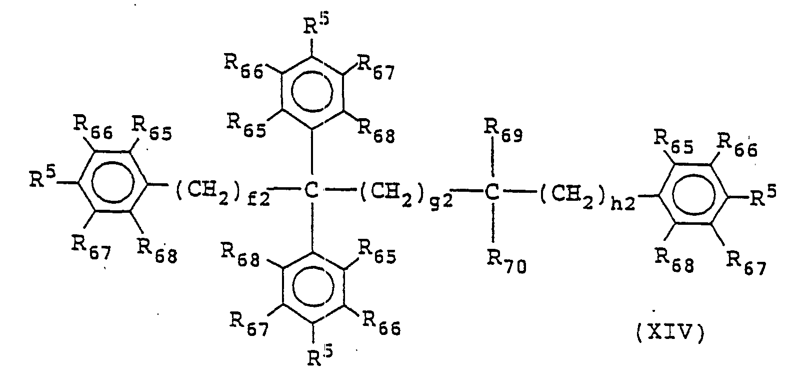
worin R₆₅ bis R₆₈ gleich oder verschieden sind und jeweils ein Wasserstoffatom, eine Hydroxygruppe, ein Halogenatom, eine Alkylgruppe, eine Alkoxygruppe oder eine Alkenylgruppe sind,
R₆₉ bis R₇₀ ein Wasserstoffatom, eine Alkylgruppe oder 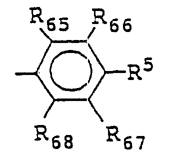 sind,
R⁵ eine Hydroxygruppe, eine Gruppe -O-R⁰-(-COO-A⁰)_{n'} oder eine Gruppe -O-B⁰ ist, und mindestens zwei der R⁵-Gruppen jeweils -O-R⁰-(-COO-A⁰)_{n'} oder -O-B⁰ sind,
f2 und h2 jeweils 0 oder 1 sind,
g2 0 oder eine ganze Zahl von 1 bis 4 ist, und
die Gruppen mit den gleichen Symbolen gleich oder verschieden sein können, 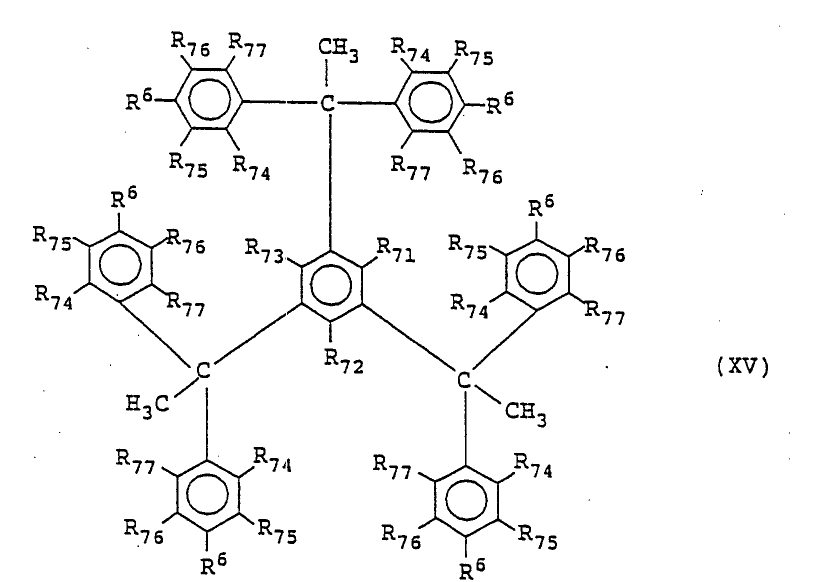
worin R₇₁ bis R₇₇ gleich oder verschieden sind und jeweils ein Wasserstoffatom, eine Hydroxygruppe, ein Halogenatom, eine Alkylgruppe, eine Alkoxygruppe, eine Nitrogruppe, eine Alkenylgruppe, eine Arylgruppe, eine Aralkylgruppe, eine Alkoxycarbonylgruppe, eine Aryloxycarbonylgruppe, eine Acyloxygruppe, eine Acylgruppe, eine Aralkyloxygruppe oder eine Aryloxygruppe sind, und
R⁶ eine Hydroxylgruppe, eine Gruppe -O-R⁰-(-COO-A⁰)_{n'} oder eine Gruppe -O-B⁰ ist und mindestens zwei der R⁶-Gruppen jeweils eine Gruppe -O-R⁰-(-COO-A⁰)_{n'} oder eine Gruppe -O-B⁰ sind, 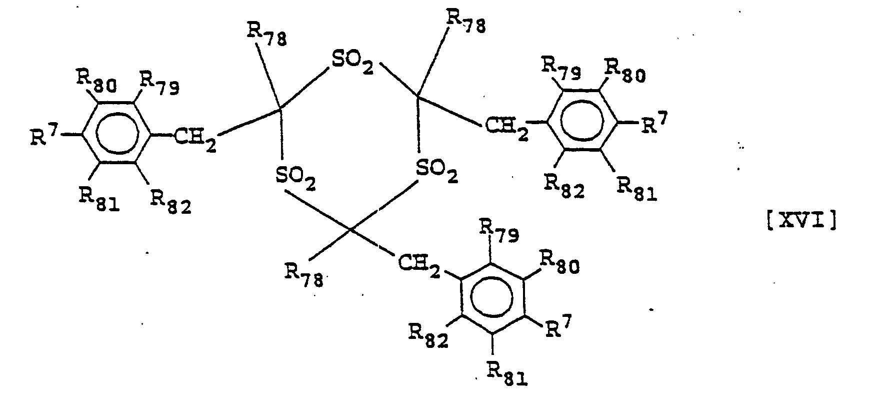
worin R₇₈ ein Wasserstoffatom oder eine Alkylgruppe ist,
R₇₉ bis R₈₂ eine Hydroxygruppe, ein Wasserstoffatom, ein Halogenatom, eine Alkylgruppe oder eine Alkoxygruppe sind,
R⁷ eine Hydroxylgruppe, eine -O-R⁰-(-COO-A⁰)_{n'}-Gruppe oder eine -O-B⁰-Gruppe ist und mindestens zwei der R⁷-Gruppen jeweils eine -O-R⁰-(-COO-A⁰)_{n'}-Gruppe oder eine -O-B⁰-Gruppe sind, und
die Gruppen mit den gleichen Symbolen gleich oder verschieden sein können.

5. Positive lichtempfindliche Zusammensetzung wie in irgendeinem der Ansprüche 1 bis 3, worin der Säure-zersetzbare Auflösungsinhibitor mindestens eine Verbindung ausgewählt aus den durch die Formeln (53) bis (55) und (57) dargestellten Verbindungen ist: 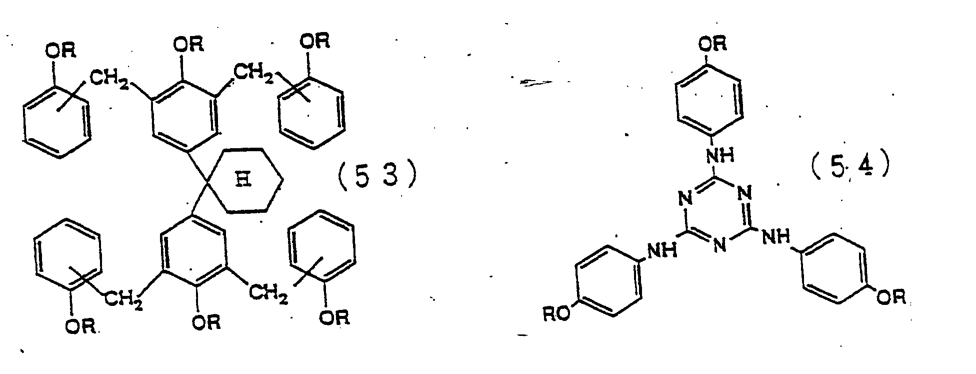 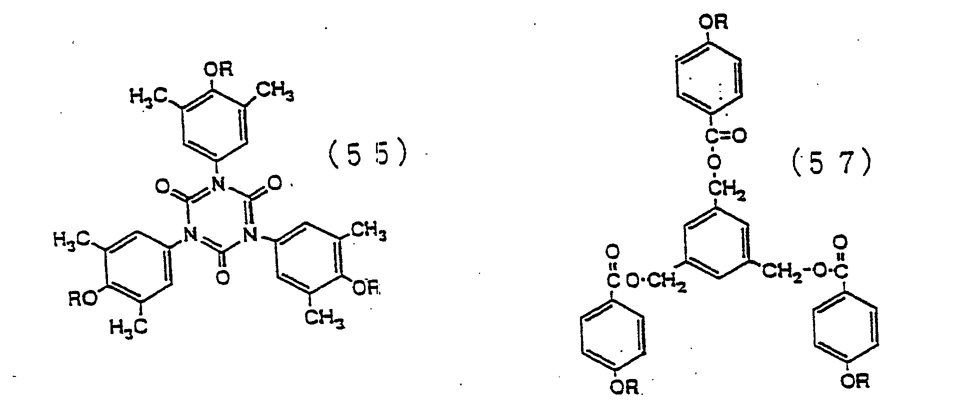 worin R, das gleich oder verschieden sein kann, ein Wasserstoffatom oder eine Gruppe mit -COOA⁰ oder -OB⁰ wie in Anspruch 1 definiert ist, mit der Maßgabe, daß mindestens 2 oder mindestens 3 (in Abhängigkeit von der Anzahl der dazwischenliegenden verbundenen Atome) der R-Gruppen von einem Wasserstoffatom verschiedene Gruppen sind und daß sie so angeordnet sind, daß die Definition (i) oder (ii) für die Anzahl der verbundenen Atome zwischen den Säure-zersetzbaren Gruppen wie in Anspruch 1 definiert erfüllt ist.

6. Positive lichtempfindliche Zusammensetzung wie in Anspruch 5, worin Rest R in den durch die Formeln (53) bis (55) und (57) dargestellten Verbindungen gleich oder verschieden ist und

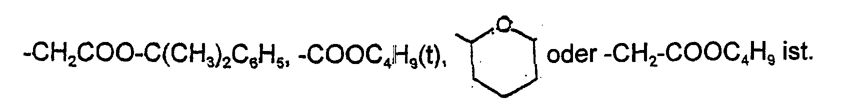

7. Positive lichtempfindliche Zusammensetzung wie in irgendeinem der Ansprüche 1 bis 6, worin der Anteil des Säure-zersetzbaren Auflösungsinhibitors auf Basis des Gesamtgewichts der lichtempfindlichen Zusammensetzung (Lösungsmittel ausgenommen) 3 bis 50 Gew.-% beträgt.

8. Positive lichtempfindliche Zusammensetzung wie in irgendeinem der Ansprüche 1 bis 7, worin das Harz mindestens ein Harz ist, das aus einem Novolak-Harz, einem hydrierten Novolak-Harz, einem Aceton-Pyrogallol-Harz, Polyhydroxystyrol, einem Halogen- oder Alkyl-substituierten Polyhydroxystyrol, einem mit Hydroxystyrol N-substituierten Maleinimid-Copolymer, einem teilweise o-alkylierten oder o-acylierten Polyhydroxystyrol, einem Styrol-Maleinsäureanhydrid-Copolymer und einem Carboxylgruppen enthaltenden Methacrylatharz und einem Derivat davon ausgewählt ist.

9. Positive lichtempfindliche Zusarnmensetzung wie in irgendeinem der Ansprüche 1 bis 8, worin der Anteil des Harzes auf Basis des Gesamtgewichts der lichtempfindlichen Zusammensetzung (Lösungsmittel ausgenommen) 50 bis 97 Gew.-% beträgt.

10. Positive lichtempfindliche Zusammensetzung wie in irgendeinem der Ansprüche 1 bis 9, worin die Menge der Säure erzeugenden Verbindung auf Basis des Gesamtgewichts der lichtempfindlichen Zusammensetzung (Lösungsmittel ausgenommen) 0,001 bis 40 Gew.-% beträgt.

## Revendications

1. Composition photosensible de type positif, qui comprend :
(a) une résine insoluble dans l'eau et soluble dans une solution aqueuse alcaline,
(b) un composé qui produit un acide lorsqu'il est irradié par des rayons actifs ou des rayons radiaux et qui a pour formule générale : 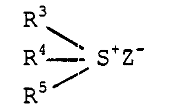 formule dans laquelle R³, R⁴ et R⁵ représentent chacun un groupe alkyle ou aryle, substitué ou non substitué, Z⁻ représente un anion associé, et deux de R³, R⁴ et R⁵ peuvent être combinés par l'intermédiaire d'une liaison simple ou d'un substituant,
(c) un inhibiteur de dissolution, décomposable par les acides, ayant une masse moléculaire ne dépassant pas 3000 et possédant des groupes décomposables sous l'action de l'acide produit de manière à ce que la solubilité dudit composé dans une solution de développement alcaline soit augmentée, ledit inhibiteur de dissolution (c) étant au moins un composé choisi parmi :
(i) les composés ayant deux desdits groupes décomposables par les acides, qui sont séparés par 10 atomes liés ou plus, à l'exclusion des atomes constituant les groupes décomposables par les acides, et
(ii) les composés ayant au moins trois desdits groupes décomposables par les acides, deux desdits groupes, qui sont aux positions les plus éloignées, étant séparés par 9 atomes liés ou plus, à l'exclusion des atomes constituant les groupes décomposables par les acides, ledit groupe décomposable par les acides contenant -COOA⁰ ou -OB⁰, où A° représente un groupe -C(R⁰¹)(R⁰²)(R⁰³) ou -C(R⁰⁴)(R⁰⁵)-OR⁰⁶, B⁰ représente un groupe A° ou -COO-A⁰, R⁰¹, R⁰², R⁰³, R⁰⁴ et R⁰⁵ peuvent être identiques ou différents et représentent chacun un atome d'hydrogène, un groupe alkyle, un groupe cycloalkyle, un groupe alcényle ou un groupe aryle, ou un groupe substitué dérivé des précédents, et R⁰⁶ représente un groupe alkyle ou aryle ou un groupe substitué qui en dérive, étant entendu qu'au moins deux de R⁰¹ à R⁰³ sont des groupes autres qu'un atome d'hydrogène et que deux de R⁰¹ à R⁰³ ou de R⁰⁴ à R⁰⁶ peuvent se combiner pour former un cycle.

2. Composition photosensible de type positif selon la revendication 1, dans laquelle ledit groupe décomposable par les acides est un groupe -R⁰-(COOA⁰)ₙ,(n' ≥ 1) ou -Ar-OB⁰, dans lequel R⁰ représente un groupe hydrocarboné, aliphatique ou aromatique, divalent ou plurivalent, qui peut porter un substituant, et Ar représente un groupe aromatique, monocyclique ou polycyclique, divalent ou plurivalent, qui peut porter un substituant.

3. Composition photosensible de type positif selon la revendication 2, dans laquelle le substituant du groupe substitué représenté par R⁰, R⁰¹ à R⁰⁶ et Ar est au moins un groupe choisi parmi le groupe hydroxyle, les atomes d'halogène, le groupe nitro, le groupe cyano, les groupes alkyle, les groupes alcoxy, les groupes alcoxycarbonyle, les groupes aralkyle, les groupes aralkyloxy, les groupes acyle, les groupe acyloxy, les groupes alcényle, les groupes alcényloxy, les groupes aryle, les groupes aryloxy et les groupes arylcarbonyloxy.

4. Composition photosensible de type positif selon l'une quelconque des revendications 1 à 3, dans laquelle ledit inhibiteur de dissolution décomposable par les acides est au moins un composé choisi parmi les composés représentés par les formules (I) à (XVI) suivantes, où les groupes contenant -COOA⁰ ou -OB⁰ sont placés de telle manière que le nombre d'atomes liés satisfait à la définition (i) ou (ii), 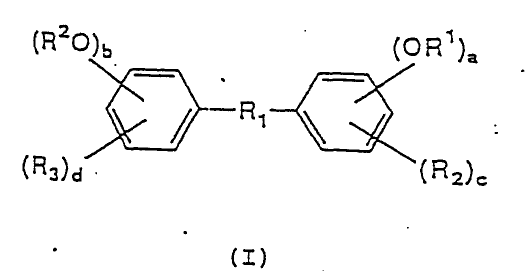 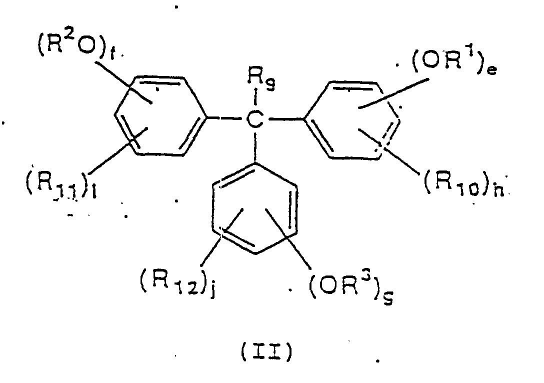 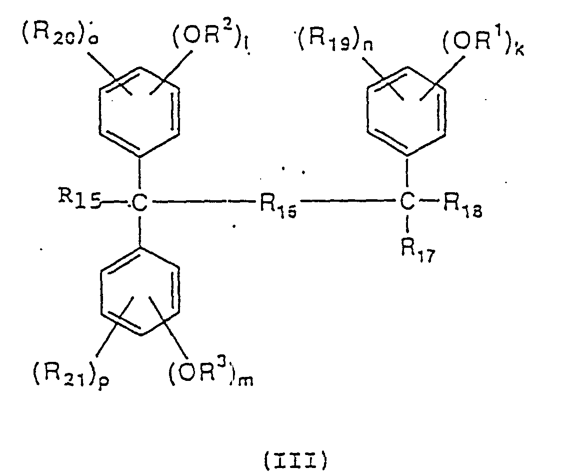 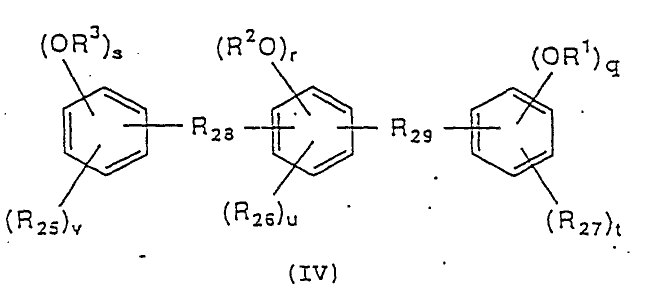 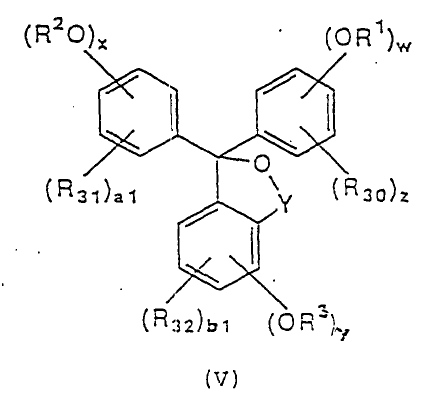 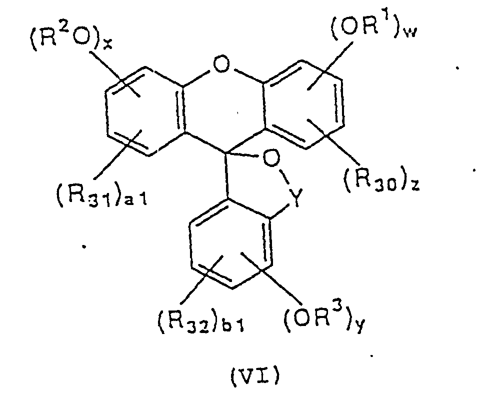 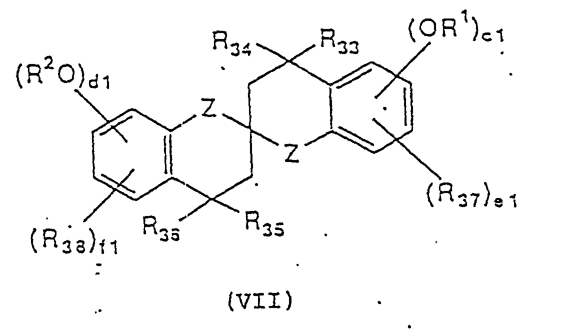 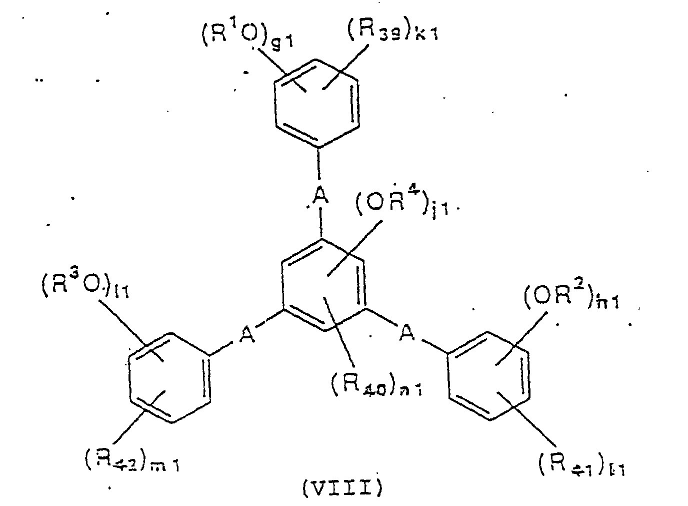 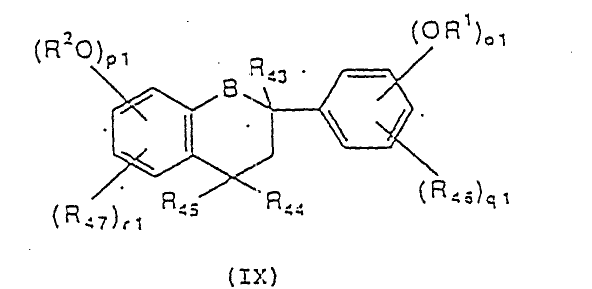 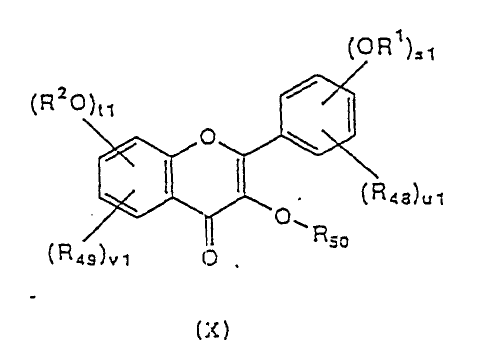 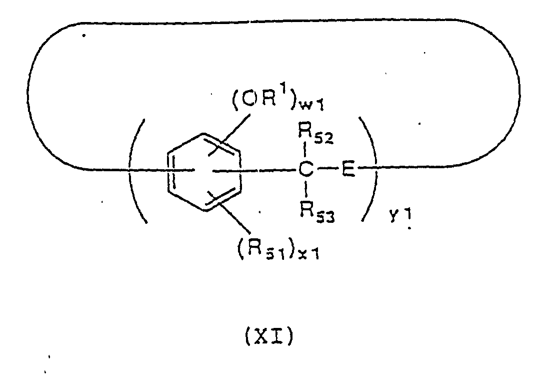 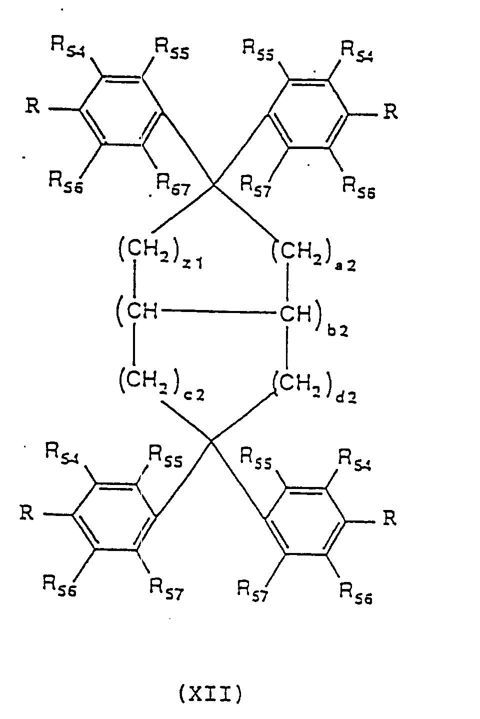 formules dans lesquelles R¹, R², R³ et R⁴ sont identiques ou différents et représentent chacun un atome d'hydrogène, un groupe -R⁰(COO-A⁰)ₙ, ou un groupe B°, étant entendu qu'au moins deux des groupes représentés par R¹, R², R³ et R⁴ sont
-R⁰-COOA⁰ ou -B⁰,
R₁ représente -CO-, -COO-, -NHCONH-, -NHCOO-, -O-, -S-, -SO-, -SO₂-, -SO₃- ou 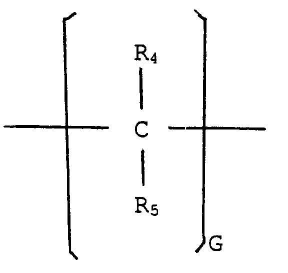
où G est égal à 2 à 6, étant entendu que lorsque G est égal à 2, au moins l'un de R₄ et R₅ est un groupe alkyle,
R₄ et R₅ sont identiques ou différents et représentent chacun un atome d'hydrogène, un groupe alkyle, un groupe alcoxy, -OH, -COOH, -CN, un atome d'halogène, -R₆-COOR₇ ou-R₈-OH,
R₆ et R₈ représentent chacun un groupe alkylène,
R₇ représente un atome d'hydrogène, un groupe alkyle, un groupe aryle ou un groupe aralkyle,
R₂, R₃, R₉ à R₁₂, R₁₅, R₁₇ à R₂₁, R₂₅ à R₂₇, R₃₀ à R₃₂, R₃₇ à R₄₂, R₄₆ à R₄₉ et R₅₁ sont identiques ou différents et représentent chacun un atome d'hydrogène, un groupe hydroxyle, un groupe alkyle, un groupe alcoxy, un groupe acyle, un groupe acyloxy, un groupe aryle, un groupe aryloxy, un groupe aralkyle, un groupe aralkyloxy, un atome d'halogène, un groupe nitro, un groupe carboxyle, un groupe cyano ou un groupe -N(R₁₃) (R₁₄) où R₁₃ et R₁₄ représentent chacun un groupe alkyle ou un groupe aryle,
R₁₆ représente une liaison simple, un groupe alkylène ou un groupe 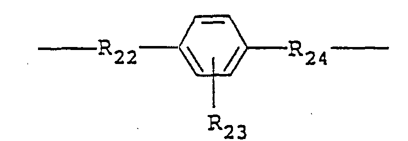
où R₂₂ et R₂₄ sont identiques ou différents et représentent chacun une liaison simple, un groupe alkylène, -O-, -S-, -CO- ou un groupe carbonyloxy, et
R₂₃ représente un atome d'hydrogène, un groupe alkyle, un groupe alcoxy, un groupe acyle, un groupe acyloxy, un groupe aryle, un groupe nitro, un groupe hydroxyle, un groupe cyano, un groupe carboxyle, -OR⁰-(COOA⁰)_{n'} ou -OB⁰,
R₂₈ et R₂₉ sont identiques ou différents et représentent chacun un groupe méthylène, un groupe méthylène substitué par un groupe alkyle inférieur, un groupe halogénométhylène ou un groupe alcoxyméthylène,
R₃₃ à R₃₆ sont identiques ou différents et représentent chacun un atome d'hydrogène ou un groupe alkyle,
R₄₃ à R₄₅ sont identiques ou différents et représentent chacun un atome d'hydrogène, un groupe alkyle, un groupe alcoxy, un groupe acyle ou un groupe acyloxy,
R₅₀ représente un atome d'hydrogène, -R⁰-(COOA⁰)_{n'} ou -B⁰, ou bien un groupe 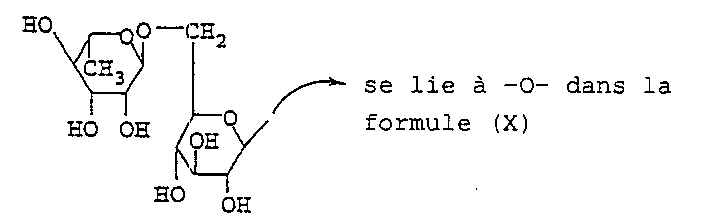
R₅₂ et R₅₃ sont identiques ou différents et représentent chacun un atome d'hydrogène, un groupe alkyle inférieur, un groupe halogénoalkyle inférieur ou un groupe aryle,
R₅₄ à R₅₇ sont identiques ou différents et représentent chacun un atome d'hydrogène, un groupe hydroxyle, un atome d'halogène, un groupe nitro, un groupe cyano, un groupe carboxyle, un groupe alkyle, un groupe alcoxy, un groupe alcoxycarbonyle, un groupe aralkyle, un groupe aralkyloxy, un groupe acyle, un groupe acyloxy, un groupe alcényle, un groupe alcényloxy, un groupe aryle, un groupe aryloxy ou un groupe aryloxycarbonyle,
R représente -O-R⁰-(COCA⁰)_{n'}, -O-B⁰ ou un groupe hydroxyle, étant entendu qu'au moins deux des groupes R représentent -O-R⁰-(COOA⁰)_{n'} ou -O-B⁰ et que les groupes représentés par le même symbole peuvent être différents,
Y représente -CO- ou -SO₂-,
Z et B représentent chacun une liaison simple ou -O-,
A représente un groupe méthylène, un groupe méthylène substitué par un groupe alkyle inférieur, un groupe halogénométhylène ou un groupe alcoxyméthylène,
E représente une liaison simple ou un groupe oxyméthylène, les groupes entre parenthèses pouvant être identiques ou différents lorsque les indices a à z et a1 à y1 sont supérieurs à 1,
a à q, s, t, v, g1 à i1, k1 à m1, o1, q1, s1, et u1 représentent chacun 0 ou un nombre entier de 1 à 5,
r, u, w, x, y, z, a1 à f1, p1, r1, t1 et v1 à x1 représentent chacun 0 ou un nombre entier de 1 à 4,
j1, n1, z1, a2, b2, c2 et d2 représentent chacun 0 ou un nombre entier de 1 à 3, étant entendu qu'au moins l'un de z1, a2, b2, c2 et d2 est supérieur ou égal à 1,
y1 représente un nombre entier de 3 à 8,
les sommes (a+b), (e+f+g), (k+l+m), (q+r+s), (w+x+y), (c1+d1), (g1+h1+i1+j1), (o1+p1) et (s1+t1) sont supérieures ou égales à 2,
la somme (j1+n1) est inférieure ou égale à 3,
les sommes (r+u), (w+z), (x+a1), (y+b1), (c1+e1), (d1+f1), (p1+r1), (t1+v1) et (x1+w1) sont inférieures ou égales à 4, mais dans la formule (V) les sommes (w+z) et (x+a1) sont inférieures ou égales à 5,
et les sommes (a+c), (b+d), (e+h), (f+i), (g+j), (k+n), (l+o), (m+p), (q+t), (s+v), (g1+k1), (h1+11), (i1+m1), (o1+q1) et (s1+u1) sont inférieures ou égales à 5, 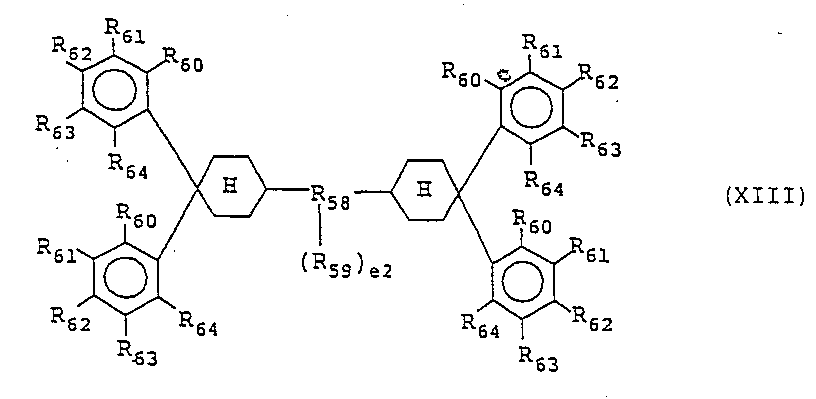 formule dans laquelle R₅₈ représente un groupe alkylène, un groupe alcénylène, un groupe arylène, une liaison simple, -S-, -SO- ou -(O=)S(=O)-,
R₅₉ représente un atome d'hydrogène, un groupe hydroxyle, un atome d'halogène, un groupe nitro, un groupe cyano, un groupe alkyle, un groupe alcoxy, un groupe alcoxycarbonyle, un groupe aralkyle, un groupe aralkyloxy, un groupe acyle, un groupe acyloxy, un groupe alcényle, un groupe alcényloxy, un groupe aryle, un groupe aryloxy, un groupe aryloxycarbonyle ou un groupe de formule 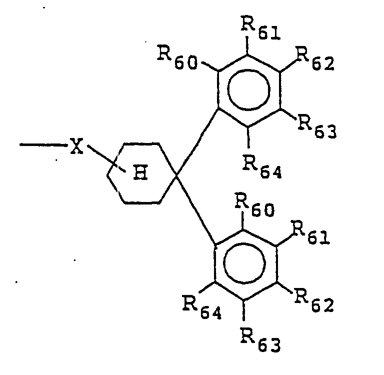
dans laquelle R₆₀ à R₆₄ sont identiques ou différents et représentent chacun un atome d'hydrogène, un groupe hydroxyle, un atome d'halogène, un groupe alkyle, un groupe alcoxy, un groupe alcényle, -O-R⁰-(COO-A⁰)_{n'} ou -O-B⁰, étant entendu qu'au moins deux de R₆₀ à R₆₄ représentent -O-R⁰-(COO-A⁰)_{n'} ou -O-B⁰ (chacun desdits au moins deux groupes peut être fixé sur l'un quelconque des noyaux benzéniques de la formule (XIII)), les groupes représentés par le même symbole pouvant être identiques ou différents,
X représente un groupe alkylène ou arylène, non substitué ou substitué, et
e2 représente 0 ou 1, 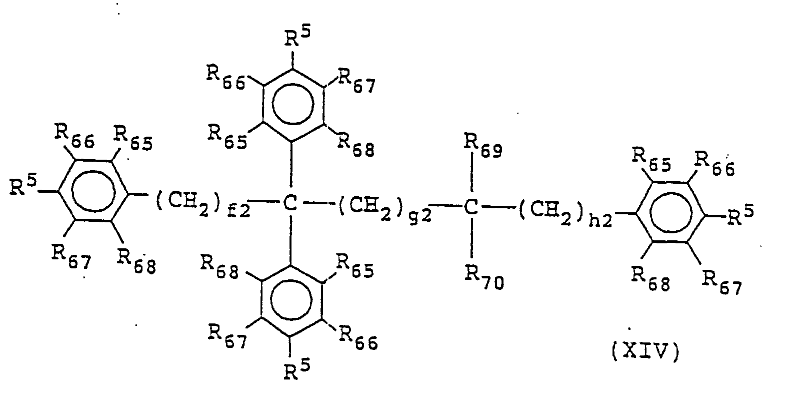
formule dans laquelle R₆₅ à R₆₈ sont identiques ou différents et représentent chacun un atome d'hydrogène, un groupe hydroxyle, un atome d'halogène, un groupe alkyle, un groupe alcoxy ou un groupe alcényle,
R₆₉ et R₇₀ représentent un atome d'hydrogène, un groupe alkyle ou un groupe 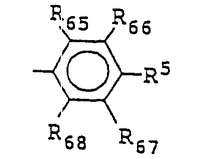
R⁵ représente un groupe hydroxyle, un groupe -O-R⁰-(COO-A⁰)ₙ, ou un groupe -O-B⁰, au moins deux des groupes R⁵ représentant -O-R⁰-(COO-A⁰)ₙ, ou -O-B⁰,
f2 et h2 représentent chacun 0 ou 1,
g2 représente 0 ou un nombre entier de 1 à 4,
et les groupes ayant le même symbole peuvent être identiques ou différents, 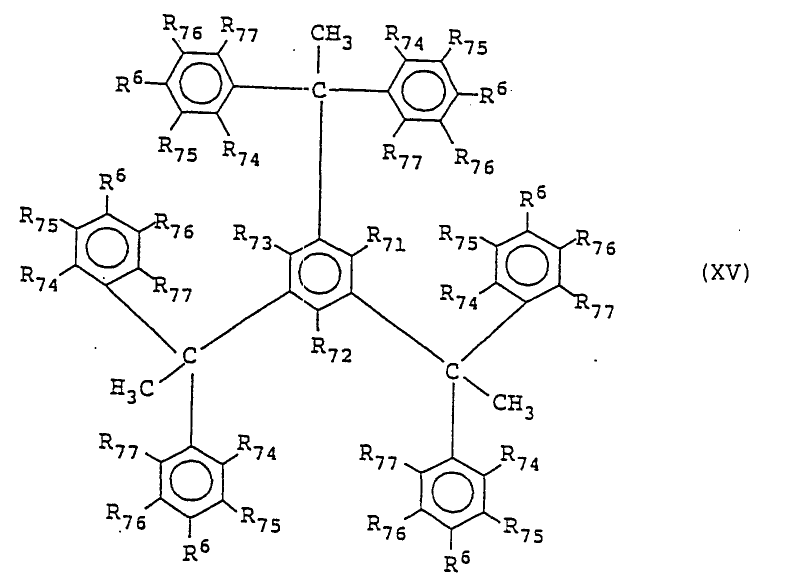
formule dans laquelle R₇₁ à R₇₇ sont identiques ou différents et représentent chacun un atome d'hydrogène, un groupe hydroxyle, un atome d'halogène, un groupe alkyle, un groupe alcoxy, un groupe nitro, un groupe alcényle, un groupe aryle, un groupe aralkyle, un groupe alcoxycarbonyle, un groupe aryloxycarbonyle, un groupe acyloxy, un groupe acyle, un groupe aralkyloxy ou un groupe aryloxy, et
R⁶ représente un groupe hydroxyle, un groupe -O-R⁰-(COO-A⁰)_{n'} ou un groupe -O-B⁰, au moins deux des groupes R⁶ représentant un groupe -O-R⁰-(COO-A⁰)_{n'} ou un groupe -O-B⁰, 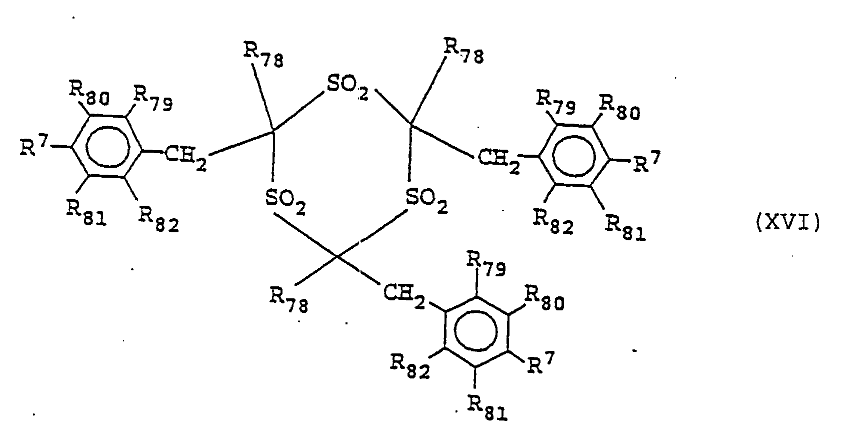
formule dans laquelle R₇₈ représente un atome d'hydrogène ou un groupe alkyle,
R₇₉ à R₈₂ représentent un groupe hydroxyle, un atome d'hydrogène, un atome d'halogène, un groupe alkyle ou un groupe alcoxy,
R⁷ représente un groupe hydroxyle, un groupe -O-R⁰-(COO-A⁰)_{n'} ou un groupe -O-B⁰, au moins deux des groupes R⁷ représentant un groupe -O-R⁰-(COO-A⁰)_{n'} ou un groupe -O-B⁰,
les groupes ayant le même symbole pouvant être identiques ou différents.

5. Composition photosensible de type positif selon l'une quelconque des revendications 1 à 3, dans laquelle ledit inhibiteur de dissolution décomposable par les acides est au moins un composé choisi parmi les composés représentés par les formules (53) à (55) et (57) suivantes : 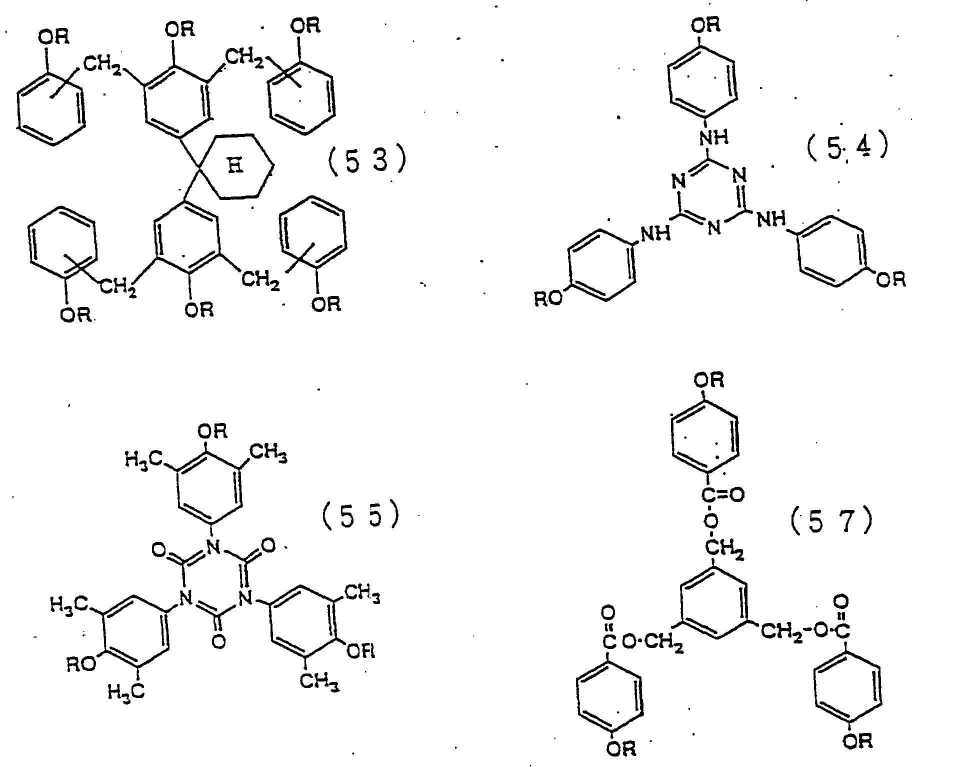 dans lesquelles les groupes R, qui peuvent être identiques ou différents, représentent un atome d'hydrogène ou un groupe contenant -COO-A⁰ ou -OB⁰ tel que défini dans la revendication 1, étant entendu qu'au moins deux ou au moins trois (suivant le nombre d'atomes liés entre eux) des groupes R sont des groupes autres qu'un atome d'hydrogène, et qu'ils sont placés de telle manière que la définition (i) ou (ii) pour le nombre d'atomes liés entre les groupes décomposables par un acide, tel que défini dans la revendication 1, soit satisfaite.

6. Composition photosensible de type positif selon la revendication 5, dans laquelle les radicaux R des composés représentés par les formules (53) à (55) et (57) sont identiques ou différents et représentent

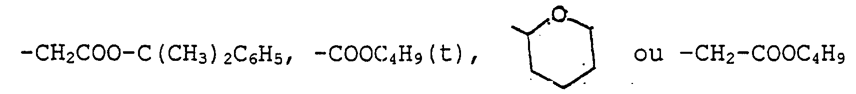

7. Composition photosensible de type positif selon l'une quelconque des revendications 1 à 6, dans laquelle la proportion de l'inhibiteur de dissolution décomposable par les acides représente 3 à 50 % en poids du poids total de la composition photosensible (solvant exclu)

8. Composition photosensible de type positif selon l'une quelconque des revendications 1 à 7, dont ladite résine est au moins une résine choisie parmi les résines novolaques, les résines novolaques hydrogénées, les résines acétone-pyrogallol, les polyhydroxystyrènes, les polyhydroxystyrènes à substituant halogène ou alkyle, les copolymères d'hydroxystyrène et de maléimide substitué sur l'azote, les polyhydroxystyrènes partiellement O-alkylés ou O-acylés, les copolymères de styrène et d'anhydride maléique, les résines de type méthacrylate contenant des groupes carboxyle, et leurs dérivés.

9. Composition photosensible de type positif selon l'une quelconque des revendications 1 à 8, dans laquelle la proportion de la résine représente 50 à 97 % en poids du poids total de la composition photosensible (solvant exclu).

10. Composition photosensible de type positif selon l'une quelconque des revendications 1 à 9, dans laquelle la quantité dudit composé générateur d'acide représente 0,001 à 40 % en poids du poids total de la composition photosensible (solvant exclu).
